(19) **Europäisches Patentamt European Patent Office Office européen des brevets**

(11) **EP 4 651 689 A1**

(12) **EUROPEAN PATENT APPLICATION**
published in accordance with Art. 153(4) EPC

(43) Date of publication:
**19.11.2025 Bulletin 2025/47**

(21) Application number: **24822508.8**

(22) Date of filing: **23.05.2024**

(51) International Patent Classification (IPC):
*H10K 59/12* (2023.01)    *H10K 59/121* (2023.01)
*H10K 59/131* (2023.01)    *H10K 59/65* (2023.01)
*H01L 27/12* (2006.01)

(86) International application number:
**PCT/CN2024/094855**

(87) International publication number:
**WO 2024/255556 (19.12.2024 Gazette 2024/51)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH MA MD TN**

(30) Priority: **16.06.2023   CN 202310722592**

(71) Applicants:
• Boe Technology Group Co., Ltd.
  **Beijing 100015 (CN)**
• Chengdu BOE Optoelectronics Technology Co., Ltd.
  **Chengdu, Sichuan 611731 (CN)**

(72) Inventors:
• **FANG, Fei**
  **Beijing 100176 (CN)**

• **LI, Qian**
  **Beijing 100176 (CN)**
• **WANG, Zhu**
  **Beijing 100176 (CN)**
• **YAN, Zhenglong**
  **Beijing 100176 (CN)**
• **SHI, Ling**
  **Beijing 100176 (CN)**
• **SHANG, Yanyang**
  **Beijing 100176 (CN)**
• **ZHANG, Yuxin**
  **Beijing 100176 (CN)**

(74) Representative: **CMS Cameron McKenna Nabarro Olswang LLP**
  **Cannon Place**
  **78 Cannon Street**
  **London EC4N 6AF (GB)**

(54) **DISPLAY SUBSTRATE AND DISPLAY DEVICE**

(57)    A display substrate, comprising: a base, a plurality of first light-emitting units and a plurality of second light-emitting units which are located in a first display region, a plurality of first pixel circuits located in the first display region, and a plurality of second pixel circuits located in a second display region. Each first light-emitting unit comprises at least one first light-emitting element. Each second light-emitting unit comprises at least one second light-emitting element. The at least one first light-emitting unit is adjacent to the at least one second light-emitting unit. At least one first pixel circuit is electrically connected to the at least one first light-emitting element and is configured to drive the at least one first light-emitting element to emit light. At least one second pixel circuit is electrically connected to the at least one second light-emitting element and is configured to drive the at least one second light-emitting element to emit light.

FIG. 4A

## Description

The present application claims the priority to Chinese Patent Application No. 202310722592.7, entitled "DISPLAY SUBSTRATE AND DISPLAY DEVICE", filed on June 16, 2023, to the China National Intellectual Property Administration, the contents of which should be regarded as being incorporated herein by reference.

Technical Field

The present disclosure relates to, but is not limited to, the field of display technologies, in particular to a display substrate and a display apparatus.

Background

Organic Light Emitting Diodes (OLED) and Quantum-dot Light Emitting Diodes (QLED) are active light emitting display devices, and have advantages of self-illumination, a wide viewing angle, a high contrast ratio, low power consumption, an extremely high reaction speed, lightness and thinness, flexibility, and low cost, etc.

Summary

The following is a summary of subject matters described herein in detail. This summary is not intended to limit the protection scope of claims.

Embodiments of the present disclosure provide a display substrate and a display apparatus.

In one aspect, the present embodiment provides a display substrate including a base substrate, a plurality of first light emitting units, a plurality of second light emitting units, a plurality of first pixel circuits, and a plurality of second pixel circuits. The base substrate includes a first display region and a second display region located on at least one side of the first display region. The plurality of first light emitting units and the plurality of second light emitting units are located in the first display region; a first light emitting unit includes at least one first light emitting element and a second light emitting unit includes at least one second light emitting element; the first light emitting unit is adjacent to at least one second light emitting unit. The plurality of first pixel circuits are located in the first display region; at least one first pixel circuit of the plurality of first pixel circuits is electrically connected to the at least one first light emitting element and configured to drive the at least one first light emitting element to emit light. The plurality of second pixel circuits are located in the second display region; at least one second pixel circuit of the plurality of second pixel circuits is electrically connected to the at least one second light emitting element and configured to drive the at least one second light emitting element to emit light.

In some exemplary implementation modes, the plurality of first light emitting units and the plurality of second light emitting units are arranged at intervals along at least one of a first direction and a second direction; the first direction intersects the second direction.

In some exemplary implementation modes, in the first direction, one first light emitting unit and one second light emitting unit are arranged at intervals; in the second direction, one first light emitting unit and one second light emitting unit are arranged at intervals.

In some exemplary implementation modes, the plurality of first light emitting units include: a plurality of columns of first light emitting units; each column of first light emitting units include a plurality of first light emitting units arranged sequentially along the second direction. The plurality of second light emitting units includes: a plurality of columns of second light emitting units, each column of second light emitting units include a plurality of second light emitting units arranged sequentially along the second direction. In the first direction, a column of first light emitting units and a column of second light emitting units are arranged at intervals.

In some exemplary implementation modes, the plurality of first light emitting units include a plurality of rows of first light emitting units, each row of first light emitting units include a plurality of first light emitting units arranged sequentially along the first direction. The plurality of second light emitting units includes a plurality of rows of second light emitting units, each row of the second light emitting units include a plurality of second light emitting units arranged sequentially along the first direction. In the second direction, a row of first light emitting units and a row of second light emitting units are arranged at intervals.

In some exemplary implementation modes, a first light emitting unit and a second light emitting unit adjacent to each other in the first direction are arranged in alignment, and a first light emitting unit and a second light emitting unit adjacent in the second direction are arranged in alignment; alternatively, a first light emitting unit and a second light emitting unit adjacent to each other in the second direction are misaligned.

In some exemplary implementation modes, a ratio of light emitting areas of a second light emitting element and a first light emitting element emitting light of a same color is less than 1.

In some exemplary implementation modes, a quantity of first light emitting elements included in at least one first light emitting unit is the same as a quantity of second light emitting elements included in at least one second light emitting unit.

In some exemplary implementation modes, the at least one first light emitting unit includes four first light emitting elements: one first light emitting element that emits light of a first color, one first light emitting element that emits light of a second color, and two first light emitting elements that emit light of a third color. The at least one second light emitting unit includes four second light emitting elements: one second light emitting element that emits light of the first color, one second light emitting element that emits light of the second color, and two second light emitting elements that emit light of the third color.

In some exemplary implementation modes, the plurality of first light emitting elements and the plurality of second light emitting elements of the first display region are arranged in a plurality of rows and a plurality of columns. In the at least one first light emitting unit, the two first light emitting elements that emit light of the third color are arranged in a same column, the first light emitting element that emits light of the first color and the first light emitting element that emits light of the second color are arranged in a same column, and the four first light emitting elements of the first light emitting unit are arranged in different rows. In the at least one second light emitting unit, the two second light emitting elements that emit light of the third color are arranged in a same column, the second light emitting element that emits light of the first color and the second light emitting element that emits light of the second color are arranged in a same column, and the four first light emitting elements of the second light emitting unit are arranged in different rows.

In some exemplary implementation modes, the plurality of first light emitting elements and the plurality of second light emitting elements of the first display region are arranged in a plurality of rows and a plurality of columns. In the at least one first light emitting unit, the two first light emitting elements that emit light of the third color are arranged in a same row, the first light emitting element that emit light of the first color and the first light emitting element that emit light of the second color are arranged in a same row, and the four first light emitting elements of the first light emitting unit are arranged in different columns. In the at least one second light emitting unit, the two second light emitting elements that emit light of the third color are arranged in a same row, the first light emitting element that emits light of the first color and the second light emitting element that emits light of the second color are arranged in a same row, and the four second light emitting elements of the second light emitting unit are arranged in different columns.

In some exemplary implementation modes, the four first light emitting elements in the first light emitting unit are electrically connected to four first pixel circuits in a one-to-one correspondence, the four first pixel circuits are arranged sequentially in a first direction, and an orthographic projection of each first pixel circuit on the base substrate is at least partially overlapped with an orthographic projection of a first light emitting element connected to the first pixel circuit on the base substrate.

In some exemplary implementation modes, the four first pixel circuits are disposed symmetrically with respect to a first centerline of the four first pixel circuits in the first direction, a first one of the four first pixel circuits and a second one of the four first pixel circuits are disposed symmetrically with respect to a second centerline of the first one and the second one of the four first pixel circuits in the first direction, and a third one and the fourth one of the four first pixel circuits are disposed symmetrically with respect to a third centerline the third one and the fourth one of the four first pixel circuits in the first direction.

In some exemplary implementation modes, the four first pixel circuits are electrically connected to a first power supply line, and the first power supply line is in a form of a gridin the first display region.

In some exemplary implementation modes, in a direction perpendicular to the display substrate, the display substrate includes: a circuit structure layer on the base substrate; the circuit structure layer includes the plurality of first pixel circuits and the plurality of second pixel circuits; each pixel circuit of the plurality of first pixel circuits and the plurality of second pixel circuits includes: at least one first type transistor, at least one second type transistor, and a storage capacitor. The circuit structure layer includes a first semiconductor layer, a first conductive layer, a second conductive layer, a second semiconductor layer, a third conductive layer, a fourth conductive layer, a fifth conductive layer, and a sixth conductive layer disposed on the base substrate. The first semiconductor layer includes at least: an active layer of the first type transistor of the pixel circuit; the first conductive layer includes at least a gate of the first type transistor and a first electrode of the storage capacitor of the pixel circuit; the second conductive layer at least includes a second electrode of the storage capacitor of the pixel circuit; the second semiconductor layer at least includes: an active layer of the second type transistor of the pixel circuit; the third conductive layer at least includes: a gate of the second type transistor of the pixel circuit; and the fourth conductive layer at least includes: a plurality of connection electrodes; the fifth conductive layer at least includes: a plurality of data lines; and the sixth conductive layer at least includes a first power supply line.

In some exemplary implementation modes, the first display region includes: a plurality of first sub-regions and a plurality of second sub-regions; at least one first sub-region of the plurality of first sub-regions is provided with at least one first light emitting unit, and at least one second sub-region of the plurality of second sub-regions is provided with at least one second light emitting unit. The second conductive layer further includes: a first scan line, a light emitting control line, a first reset control line, and a second reset control line electrically connected to the first pixel circuit; the first scan line, the light emitting control line, the first reset control line, and the second reset control line extend in a first direction. In a second direction, the first scan line and the first reset control line bypass from one side of the second sub-region, and the light emitting control line and the second reset control line bypass from the other side of the second sub-region; the second direction intersects the first direction.

In some exemplary implementation modes, the first display region includes: a plurality of first sub-regions and a plurality of second sub-regions; at least one first sub-region of the plurality of first sub-regions is provided with at least one first light emitting unit, and at least one second sub-region of the plurality of second sub-regions is provided with at least one second light emitting unit. The third conductive layer further includes a first initial signal line, a second initial signal line, a third initial signal line, and a second scan line electrically connected to the first pixel circuit; the first initial signal line, the second initial signal line, the third initial signal line, and the second scan line extend in a first direction. In a second direction, the first initial signal line and the second scan line bypass from one side of the second sub-region, and the second initial signal line and the third initial signal line bypass from the other side of the second sub-region; the second direction intersects the first direction.

In some exemplary implementation modes, a ratio of a quantity of the first light emitting units and a quantity of the second light emitting units in the first display region is 0.8 to 1.2.

In some exemplary implementation modes, a light transmittance of the first display region is greater than a light transmittance of the second display region. The display substrate further includes a plurality of third light emitting elements and a plurality of third pixel circuits located in the second display region, wherein at least one third pixel circuit of the plurality of third pixel circuits is electrically connected to at least one third light emitting element of the plurality of third light emitting elements and is configured to drive the at least one third light emitting element to emit light. The plurality of second pixel circuits are arranged at intervals between the plurality of third pixel circuits.

In some exemplary implementation modes, an orthographic projection of the at least one first pixel circuit on the base substrate is overlapped with an orthographic projection of the at least one first light emitting element on the base substrate. The at least one second pixel circuit is electrically connected to the at least one second light emitting element via at least one conductive connection line; an orthographic projection of the at least one second pixel circuit on the base substrate is not overlapped with an orthographic projection of the at least one second light emitting element on the base substrate.

In some exemplary implementation modes, an orthographic projection of the at least one conductive connection line on the base substrate is overlapped with the orthographic projection of the at least one first pixel circuit on the base substrate.

In another aspect, an embodiment provides a display apparatus, including the display substrate described above, and a sensor located on a non-display side of the display substrate. An orthographic projection of the sensor on the display substrate is at least partially overlapped with a first display region of the display substrate.

Other aspects of the present disclosure may be comprehended after the drawings and the detailed descriptions are read and understood.

Brief Description of Drawings

Accompanying drawings are intended to provide an understanding of technical solutions of the present application and form a part of the specification, and are used to explain the technical solutions of the present application together with embodiments of the present application, and do not constitute a limitation on the technical solutions of the present application.

FIG. 1 is a schematic diagram of a display substrate according to at least one embodiment of the present disclosure.

FIG. 2 is an equivalent circuit diagram of a pixel circuit according to at least one embodiment of the present disclosure.

FIG. 3 is a working timing diagram of the pixel circuit provided in FIG. 2.

FIG. 4A and FIG. 4B are partial schematic diagrams of a first display region according to at least one embodiment of the present disclosure.

FIG. 5 is a schematic diagram of a connection relationship between a light emitting element and a pixel circuit according to at least one embodiment of the present disclosure.

FIG. 6 is a top view of a part of a first display region according to at least one embodiment of the present disclosure.

FIG. 7A is a schematic diagram of the first display region after a first semiconductor layer is formed in FIG. 6.

FIG. 7B is a schematic diagram of one first sub-region in FIG. 7A.

FIG. 8A is a schematic diagram of the first display region after a first conductive layer is formed in FIG. 6.

FIG. 8B is a schematic diagram of the first conductive layer in FIG. 8A.

FIG. 8C is a schematic diagram of one first sub-region in FIG. 8A.

FIG. 9A is a schematic diagram of the first display region after a second conductive layer is formed in FIG. 6.

FIG. 9B is a schematic diagram of the second conductive layer in FIG. 9A.

FIG. 9C is a schematic diagram of one first sub-region in FIG. 9A.

FIG. 10A is a schematic diagram of the first display region after a second semiconductor layer is formed in FIG. 6.

FIG. 10B is a schematic diagram of the second semiconductor layer in FIG. 10A.

FIG. 10C is a schematic diagram of one first sub-region in FIG. 10A.

FIG. 11A is a schematic diagram of the first display region after a third conductive layer is formed in FIG. 6.

FIG. 11B is a schematic diagram of the third conductive layer in FIG. 11A.

FIG. 11C is a schematic view of one first sub-region in FIG. 11A.

FIG. 12 is a schematic view of one first sub-region after a fifth insulating layer is formed in FIG. 6.

FIG. 13A is a schematic diagram of the first display region after a fourth conductive layer is formed in FIG. 6.

FIG. 13B is a schematic diagram of the fourth conductive layer in FIG. 13A.

FIG. 13C is a schematic diagram of one first sub-region in FIG. 13A.

FIG. 14 is a schematic view of one first sub-region after a seventh insulating layer is formed in FIG. 6.

FIG. 15A is a schematic diagram of the first display region after a fifth conductive layer is formed in FIG. 6.

FIG. 15B is a schematic diagram of the fifth conductive layer in FIG. 15A.

FIG. 15C is a schematic diagram of one first sub-region in FIG. 15A.

FIG. 16 is a schematic view of one first sub-region after an eighth insulating layer in FIG. 6 is formed.

FIG. 17A is a schematic diagram of the first display region after a sixth conductive layer is formed in FIG. 6.

FIG. 17B is a schematic diagram of the sixth conductive layer in FIG. 17A.

FIG. 17C is a schematic diagram of one first sub-region in FIG. 17A.

FIG. 18 is a schematic diagram of the first display region after a ninth insulating layer is formed in FIG. 6.

FIG. 19A is a schematic diagram of the first display region after a conductive connection layer in FIG. 6 is formed.

FIG. 19B is a schematic diagram of the conductive connection layer of FIG. 19A.

FIG. 20 is a schematic diagram of the first display region after an anode layer is formed in FIG. 6.

FIG. 21 is another example diagram of a first display region according to at least one embodiment of the present disclosure.

FIG. 22 is another example diagram of a first display region according to at least one embodiment of the present disclosure.

FIG. 23 is another example diagram of a first display region according to at least one embodiment of the present disclosure.

FIG. 24 is another example diagram of a first display region according to at least one embodiment of the present disclosure.

FIG. 25 is another example diagram of a first display region according to at least one embodiment of the present disclosure.

FIG. 26 is another example diagram of a first display region according to at least one embodiment of the present disclosure.

FIG. 27 is another example diagram of a first display region according to at least one embodiment of the present disclosure.

FIG. 28 is another example diagram of a first display region according to at least one embodiment of the present disclosure.

FIG. 29 is another example diagram of a first display region according to at least one embodiment of the present disclosure.

FIG. 30 is another example diagram of a first display region according to at least one embodiment of the present disclosure.

FIG. 31 is another example diagram of a first display region according to at least one embodiment of the present disclosure.

FIG. 32 is another example diagram of a first display region according to at least one embodiment of the present disclosure.

FIG. 33 is another example diagram of a first display region according to at least one embodiment of the present disclosure.

FIG. 34 is another example diagram of a first display region according to at least one embodiment of the present disclosure.

FIG. 35 is another example diagram of a first display region according to at least one embodiment of the present disclosure.

FIG. 36 is a schematic diagram of a display apparatus according to at least one embodiment of the present disclosure.

Detailed Description

The embodiments of the present disclosure will be described below with reference to the drawings in detail. Implementations may be implemented in multiple different forms. Those of ordinary skills in the art may easily understand such a fact that implementations and contents may be transformed into other forms without departing from the purpose and scope of the present disclosure. Therefore, the present disclosure should not be explained as being limited to the contents recorded in the following implementations only. The embodiments and features in the embodiments of the present disclosure may be randomly combined with each other if there is no conflict.

In the drawings, a size of one or more constituent elements, a thickness of a layer, or a region is sometimes exaggerated for clarity. Therefore, one implementation of the present disclosure is not necessarily limited to the size, and a shape and a size of one or more components in the drawings do not reflect an actual scale. In addition, the accompanying drawings schematically illustrate ideal examples, and an implementation of the present disclosure is not limited to shapes, numerical values, or the like shown in the drawings.

Ordinal numerals "first", "second", "third", etc., in the specification are set not to form limits in numbers but only to avoid confusion between constituent elements. In the present disclosure, "plurality" represents two or more than two.

In the specification, for convenience, expressions "central", "above", "below", "front", "back", "vertical", "horizontal", "top", "bottom", "inside", "outside", etc., for indicating directional or positional relationships are used to illustrate positional relationships between the constituent elements with reference to the accompanying drawings, not to indicate or imply that involved devices or elements are required to have specific orientations or are structured and operated in the specific orientations but only to easily describe the present specification and simplify the description, and thus should not be understood as limitations on the present disclosure. The positional relationships between the constituent elements are changed as appropriate according to directions of the constituent elements described. Therefore, appropriate replacements based on situations are allowed, which is not limited to the expressions in the specification.

In the specification, unless otherwise explicitly specified and defined, terms "mounting", "coupling", and "connection" should be understood in a broad sense. For example, it may be a fixed connection, a detachable connection, or an integral connection; it may be a mechanical connection or a connection; it may be a direct connection, an indirect connection through a middleware, or an internal communication inside two elements. Those of ordinary skills in the art may understand meanings of the aforementioned terms in the present disclosure according to situations.

In the specification, an "electrical connection" includes a case that constituent elements are connected together through an element with a certain electrical action. The "element with a certain electrical effect" is not particularly limited as long as electrical signals between the connected constituent elements may be transmitted. Examples of the "element with a certain electrical effect" not only include an electrode and a wiring, but also include a switching element such as a transistor, a resistor, an inductor, a capacitor, and other elements with a plurality of functions, etc.

In the specification, a transistor refers to an element which at least includes three terminals, i.e., a gate, a drain, and a source. The transistor has a channel region between the drain (drain electrode terminal, drain region, or drain) and the source (source electrode terminal, source region, or source electrode), and a current can flow through the drain, the channel region, and the source. In the specification, the channel region refers to a region through which a current mainly flows.

In the specification, a first electrode may be a drain and a second electrode may be a source, or, a first electrode may be a source and a second electrode may be a drain. In a case that transistors with opposite polarities are used, or in a case that a direction of a current is changed during operation of a circuit, or the like, functions of the "source" and the "drain" are sometimes interchangeable. Therefore, the "source" and the "drain" are interchangeable in the specification. In addition, the gate may also be referred to as a control electrode.

In the specification, "parallel" refers to a state in which an angle formed by two straight lines is above -10 ° and below 10 °, and thus may include a state in which the angle is above -5 ° and below 5°. In addition, "perpendicular" refers to a state in which an angle formed by two straight lines is above 80 ° and below 100 °, and thus may include a state in which the angle is above 85 ° and below 95 °.

In this specification, a circle, oval, triangle, rectangle, trapezoid, pentagon or hexagon, etc. is not strictly speaking, but may be an approximate circle, oval, triangle, rectangle, trapezoid, pentagon or hexagon, etc. Some small deformations due to tolerances may exist, for example, chamfers, curved edges and deformations thereof may exist.

A "light transmittance" in the present disclosure refers to an ability of light to pass through a medium, and is a percentage of luminous flux passing through a transparent or translucent body to its incident luminous flux.

In the present disclosure, "about" and "substantially" refer to that a boundary is not defined strictly and a case within a range of process and measurement errors is allowed. In the present disclosure, "substantially the same" refers to a case where numerical values differ by less than 10%.

In the present disclosure, "A extends along a B direction" means that A may include a main body portion and a secondary portion connected to the main body portion. The main body portion is a line, a line segment, or a strip-shaped body, the main body portion extends along the B direction, and a length of the main body portion extending along the B direction is greater than a length of the secondary portion extending along another direction. "A extends along the B direction" in the present disclosure always means "the main body portion of A extends along the B direction".

With continuous development of display technologies, a camera is usually installed on a display device to meet needs of shooting or face recognition. In order to maximize a screen-to-body ratio, technologies such as fringe screen, water drop screen and in-screen hole have successively came into being. These technologies reduce the area occupied by the camera by digging a hole locally in a display region and placing the camera under a hole-digging region, thus increasing the screen-to-body ratio. However, the above technologies need to dig out part of the display region, which will cause some regions in a display picture to be unable to be displayed, and make it impossible to further improve the screen-to-body ratio. In order to avoid punching holes in the display region and under a premise of ensuring practicability of the display substrate, a true full-screen will be achieved by adopting a pixel circuit built-out method or a pixel circuit built-in method in the full display with camera (FDC) region.

The pixel circuit built-out method means that the pixel circuits connected with the light emitting elements in the FDC region is provided in the normal display region, and the light transmittance of the FDC region is improved by arranging the light emitting elements and the pixel circuits separately. Because no pixel circuit is provided in the FDC region, there is no light-shielding layer other than the anodes of the light emitting elements in this region, and a higher light transmittance can be realized. However, in this mode, the pixel circuits and the light emitting elements need to be electrically connected through conductive connection lines, the size (e.g., aperture) of the FDC region of the display substrate using the pixel circuit built-out method is limited due to the limitation of the space for the arrangement of the conductive connection lines. Increasing the aperture of the FDC region usually requires an increased mask process of the conductive connection lines, resulting in increased cost. Moreover, the material of the conductive connection line is usually a transparent conductive material, such as indium tin oxide (ITO). Due to the large square resistance of ITO, the load of the conductive connection line is large, which easily affects the brightness of the light emitting elements in the FDC region and reduces the brightness of the FDC region, which leads to a display defect in the FDC region, such as a vertical display defect (Mura).

The pixel circuit built-in method refers to the provision of light emitting elements and the pixel circuits connected with the light emitting elements in the FDC region. Compared with the pixel circuit built-out method, the built-in method eliminates the need for long conductive connection lines for the electric connection between the pixel circuits and the light emitting elements in the FDC region, which can avoid the display defect of the FDC region caused by the conductive connection lines. Moreover, the built-in method does not limit the size of the FDC region and can support the FDC region with large aperture. However, in a display substrate adopting the pixel circuit built-in method, since the anode of the light emitting element in the FDC region cannot completely block the pixel circuit, the light transmittance of the FDC region will be affected.

The present embodiment provides a display substrate and a display apparatus, which may support increasing the size of the FDC region while ensuring the light transmittance of the FDC region.

The present embodiment provides a display substrate including a base substrate, a plurality of first light emitting units, a plurality of second light emitting units, a plurality of first pixel circuits, and a plurality of second pixel circuits. The base substrate includes a first display region and a second display region located on at least one side of the first display region. The plurality of first light emitting units and the plurality of second light emitting units are located in the first display region; a first light emitting unit includes at least one first light emitting element, and a second light emitting unit includes at least one second light emitting element. A first light emitting unit is adjacent to at least one second light emitting unit. The plurality of first pixel circuits are located in the first display region; at least one first pixel circuit of the plurality of first pixel circuits is electrically connected to at least one first light emitting element and configured to drive the at least one first light emitting element to emit light. The plurality of second pixel circuits are located in the second display region; at least one second pixel circuit of the plurality of second pixel circuits is electrically connected to at least one second light emitting element and configured to drive the at least one second light emitting element to emit light.

The display substrate provided by the present embodiment adopts a combination of the pixel circuit built-out mode and the pixel circuit built-in mode, which may ensure the light transmittance of the first display region, and supports increasing a size of the first display region.

In some exemplary implementation modes, the plurality of first light emitting units and the plurality of second light emitting units may be arranged at intervals along at least one of a first direction and a second direction. Herein, the first direction intersects with the second direction. For example, the first direction may be perpendicular to the second direction. In some examples, the plurality of first light emitting units and the plurality of second light emitting units may be arranged at intervals in both the first direction and the second direction. For example, in the first direction, one first light emitting unit and one second light emitting unit are arranged at intervals; in the second direction, one first light emitting unit and one second light emitting unit are arranged at intervals. In other examples, the plurality of first light emitting units and the plurality of second light emitting units may be arranged at intervals along only the first direction or the second direction. In this example, by arranging the first light emitting units and the second light emitting units at intervals, a light emitting element for which a pixel circuit is built out and a light emitting element for which a pixel circuit is built in can be reasonably arranged to achieve an optimal combination of light transmittance and size of the first display region, thereby improving performance of the display substrate and the user experience. Moreover, by arranging the first light emitting units and the second light emitting units at intervals, it facilitates brightness compensation between the first light emitting element and the second light emitting element, thereby improving brightness uniformity of the first display region.

In some exemplary implementation modes, a ratio of light emitting areas of a second light emitting element and a first light emitting element that emit light of a same color may be less than 1. In some examples, a ratio of light emitting areas of a second light emitting element and a first light emitting element that emit light of a same color may be 0.4 to 0.8, for example, may be about 0.5. In this example, by reducing the light emitting area of the second light emitting element, the brightness dimming caused by the pixel circuit of the second light emitting element being building out can be improved.

In some exemplary implementation modes, a quantity of first light emitting elements included in at least one first light emitting unit may be the same as a quantity of second light emitting elements included in at least one second light emitting unit. In some examples, the at least one first light emitting unit may include four first light emitting elements: one first light emitting element that emits light of a first color, one first light emitting element that emits light of a second color, and two first light emitting elements that emit light of a third color. The at least one second light emitting unit may include four second light emitting elements: one second light emitting element that emits light of the first color, one second light emitting element that emits light of the second color, and two second light emitting elements that emit light of the third color. However, the present embodiment is not limited thereto. For example, the first light emitting unit and the second light emitting unit may each include three light emitting elements. In this example, quantities of light emitting elements included in the first light emitting unit and the second light emitting unit are the same, which is beneficial for brightness compensation between adjacent light emitting elements emitting light of a same color, and contributes to the luminance uniformity of the first display region.

In some exemplary implementation modes, a ratio of a quantity of the first light emitting units and a quantity of the second light emitting units in the first display region may be 0.8 to 1.2, such as may be about 1. The ratio of the quantity of the first light emitting units and the second light emitting units in the present example can effectively alleviate a quantity of conductive connection lines connected to built-out pixel circuits and the wiring space, and can support an increase in the size of the first display region.

In some exemplary implementation modes, a light transmittance of the first display region may be greater than a light transmittance of the second display region. The display substrate may further include a plurality of third light emitting elements and a plurality of third pixel circuits located in the second display region. At least one third pixel circuit is electrically connected to at least one third light emitting element and configured to drive the at least one third light emitting element to emit light. The plurality of second pixel circuits may be disposed at intervals between the plurality of third pixel circuits. In this example, the display effect of the display substrate can be guaranteed by setting the second display region having a light transmittance smaller than that of the first display region.

In some examples, the sum of a quantity of the first light emitting elements and a quantity of the second light emitting elements per unit area may be less than or equal to a quantity of the third light emitting elements per unit area. Alternatively, the density of the first light emitting elements and the second light emitting elements in the first display region may be less than or equal to the density of the third light emitting elements in the second display region. Alternatively, the pixel density (PPI, Pixels Per Inch) of the first display region may be less than or equal to the pixel density of the second display region.

Solutions of the embodiments will be described below through some examples.

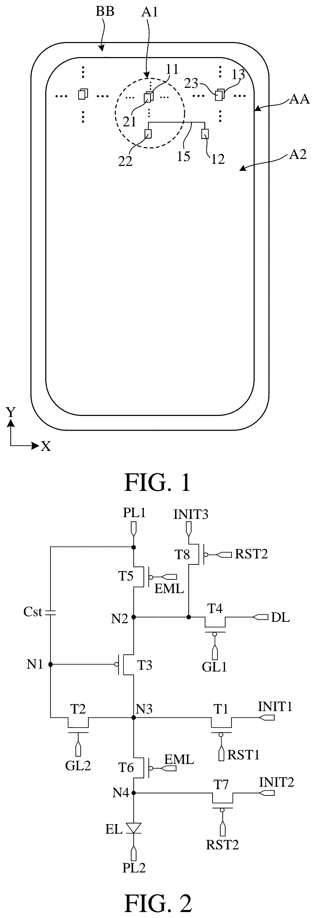

FIG. 1 is a schematic diagram of a display substrate according to at least one embodiment of the present disclosure. In some examples, as shown in FIG. 1, the display substrate may include a display region AA and a peripheral region BB located at a periphery of the display region AA. The display region AA of the display substrate may at least include a first display region A1 and a second display region A2. The second display region A2 may at least partially surround the first display region A1. For example, the second display region A2 may surround a periphery of the first display region A1. The peripheral region BB may surround a periphery of the second display region A2. However, the present embodiment is not limited thereto.

In some examples, as shown in FIG. 1, the first display region A1 may be a light transmitting display region and may also be referred to as a Full Display with Camera (FDC) region. The second display region A2 may be referred to as a normal display region. For example, an orthographic projection of a sensor (such as a camera and other hardware) on the display substrate may be located within the first display region A1 of the display substrate. In some examples, as shown in FIG. 1, the first display region A1 may be circular, and a size of an orthographic projection of the sensor on the display substrate may be less than or equal to a size of the first display region A1. However, the present embodiment is not limited thereto. In some other examples, the first display region A1 may be rectangular, and a size of the orthographic projection of the sensor on the display substrate may be less than or equal to a size of an inscribed circle of the first display region A1.

In some examples, as shown in FIG. 1, the first display region A1 may be located at a middle position of the top of the display region AA. The second display region A2 may surround a periphery of the first display region A1. However, the present embodiment is not limited thereto. For example, the first display region A1 may be located in other positions such as an upper left corner, a lower left corner, a lower right corner or an upper right corner of the display region AA. For example, the second display region A2 may surround at least one side of the first display region A1.

In some examples, as shown in FIG. 1, the display region AA may be in a shape of a rectangle, e.g., a rounded rectangle. The first display region A1 may be circular or elliptical. However, the present embodiment is not limited thereto. For example, the first display region A1 may be rectangular, semicircular, pentagonal, or another shape.

In some examples, the display region AA may be provided with a plurality of sub-pixels. At least one sub-pixel may include a pixel circuit and a light emitting element. The pixel circuit may be configured to drive a light emitting element connected thereto. For example, the pixel circuit may be configured to provide a drive current for driving the light emitting element to emit light. The pixel circuit may include multiple transistors and at least one capacitor. For example, the pixel circuit may have a 3T1C, 4T1C, 5T1C, 5T2C, 6T1C, 7T1C, or 8T1C structure. In the aforementioned circuit structures, T refers to a thin film transistor, C refers to a capacitor, a digit before T represents a quantity of thin film transistors in the circuit, and a digit before C represents a quantity of capacitors in the circuit.

In some examples, the light emitting element may be any one of a Light Emitting Diode (LED), an Organic Light Emitting Diode (OLED), a Quantum dot Light Emitting Diode (QLED), a micro LED (including: mini-LED or micro-LED), and the like. For example, the light emitting element may be an OLED, and the light emitting element may emit red light, green light, blue light, or white light, or the like under driving of a pixel circuit corresponding to the light emitting element. A color of light emitted by the light emitting element may be determined as required. In some examples, the light emitting element may include an anode, a cathode, and an organic light emitting layer located between the anode and the cathode. The anode of the light emitting element may be electrically connected to a corresponding pixel circuit. However, the present embodiment is not limited thereto.

FIG. 2 is an equivalent circuit diagram of a pixel circuit according to at least one embodiment of the present disclosure. The pixel circuit in this example is described by taking an 8T1C structure as an example. In some examples as, shown in FIG. 2, the pixel circuit of this example may include eight transistors (i.e., a first transistor T1 to an eighth transistor T8) and one storage capacitor Cst. The first transistor T1 may also be referred to as a first reset transistor, the second transistor T2 may also be referred to as a threshold compensation transistor, the third transistor T3 may also be referred to as a drive transistor, the fourth transistor T4 may also be referred to as a data writing transistor, the fifth transistor T5 may also be referred to as a first light emitting control transistor, the sixth transistor T6 may also be referred to as a second light emitting control transistor, the seventh transistor T7 may also be referred to as a second reset transistor, and the eighth transistor T8 may also be referred to as a third reset transistor. A light emitting element EL may include an anode, a cathode and an organic light emitting layer disposed between the anode and the cathode.

In some examples, the first transistor T1, the third transistor T3 to the eighth transistor T8 may be first type transistors, which may be, for example, P-type transistors, and the second transistor T2 may be a second type transistor, which may be, for example, an N-type transistor. However, the present embodiment is not limited thereto. For example, the multiple transistors of the pixel circuit may be all P-type transistors, or all N-type transistors.

In some examples, for first type transistors (e.g., including the first transistor T1 and the third transistor T3 to the eighth transistor T8) of the pixel circuit, a low temperature poly silicon thin film transistor may be adopted, and for a second type transistor (e.g., including the second transistor T2) of the pixel circuit, an oxide thin film transistor may be adopted. Low Temperature Poly Silicon (LTPS) is adopted for an active layer of a low temperature poly silicon thin film transistor and an oxide semiconductor (Oxide) is adopted for an active layer of an oxide thin film transistor. The low temperature poly silicon thin film transistor has advantages, such as a high mobility, and fast charging, etc., while the oxide thin film transistor has advantages, such as a low leakage current, etc. The low temperature poly-silicon thin film transistor and the oxide thin film transistor are integrated on one display substrate to form a low temperature poly-crystalline oxide (LTPS+ Oxide) display substrate, and advantages of both the low temperature poly silicon thin film transistor and the oxide thin film transistor can be utilized, which can achieve low frequency drive, reduce power consumption, and improve display quality.

In some examples, as shown in FIG. 2, the pixel circuit may be electrically connected with a first scan line GL1, a second scan line GL2, a data line DL, a first power supply line PL1, a second power supply line PL2, a light emitting control line EML, a first initial signal line INIT1, a second initial signal line INIT2, a third initial signal line INIT3, a first reset control line RST1, and a second reset control line RST2. The first power supply line PL1 may be configured to provide a constant first voltage signal VDD to the pixel circuit, the second power supply line PL2 may be configured to provide a constant second voltage signal VSS to the pixel circuit, and the first voltage signal VDD is greater than the second voltage signal VSS. The first scan line GL1 may be configured to provide a first scan signal SCAN1 to the pixel circuit. The second scan line GL2 may be configured to provide a second scan signal SCAN2 to the pixel circuit. The data line DL may be configured to provide a data signal to the pixel circuit. The light emitting control line EML may be configured to provide a light emitting control signal EM to the pixel circuit. The first reset control line RST1 may be configured to provide a first reset control signal RESET1 to the pixel circuit. The second reset control line may be configured to provide a second reset control signal RESET2 to the pixel circuit.

In some examples, as shown in FIG. 2, a gate of the third transistor T3 is electrically connected with a first node N1, a first electrode of the third transistor T3 is electrically connected with a second node N2, and a second electrode of the third transistor T3 is electrically connected with a third node N3. A gate of the fourth transistor T4 is electrically connected with the first scan line GL1, a first electrode of the fourth transistor T4 is electrically connected with the data line DL, and a second electrode of the fourth transistor T4 is electrically connected with the second node N2. A gate of the second transistor T2 is connected to the second scan signal line GL2, a first electrode of the second transistor T2 is electrically connected with the first node N1, and a second electrode of the second transistor T2 is electrically connected with the third node N3. A gate of the fifth transistor T5 is electrically connected with the light emitting control line EML, a first electrode of the fifth transistor T5 is electrically connected with the first power supply line PL1, and a second electrode of the fifth transistor T5 is electrically connected with the second node N2. A gate of the sixth transistor T6 is electrically connected with the light emitting control line EML, a first electrode of the sixth transistor T6 is electrically connected with the third node N3, and a second electrode of the sixth transistor T6 is electrically connected with a fourth node N4. A gate of the first transistor T1 is electrically connected with the first reset control line RST1, a first electrode of the first transistor T1 is electrically connected with the first initial signal line INIT1, and a second electrode of the first transistor T1 is electrically connected with the third node N3. A gate of the seventh transistor T7 is electrically connected with the second reset control line RST2, a first electrode of the seventh transistor T7 is electrically connected with the second initial signal line INIT2, and a second electrode of the seventh transistor T7 is electrically connected with the fourth node N4. A gate of the eighth transistor T8 is electrically connected with the second reset control line RST2, a first electrode of the eighth transistor T8 is electrically connected with the third initial signal line INIT3, and a second electrode of the eighth transistor T8 is electrically connected with the second node N2. A first electrode of the storage capacitor Cst is electrically connected with the first node N1, and a second electrode of the storage capacitor Cst is electrically connected with the first power supply line PL1.

In the example, the first node N1 is a connection point of the storage capacitor Cst, the second transistor T2, and the third transistor T3, the second node N2 is a connection point of the fifth transistor T5, the fourth transistor T4, the eighth transistor T8, and the third transistor T3, the third node N3 is a connection point of the first transistor T1, the third transistor T3, the second transistor T2, and the sixth transistor T6, and the fourth node N4 is a connection point of the sixth transistor T6, the seventh transistor T7, and the light emitting element EL.

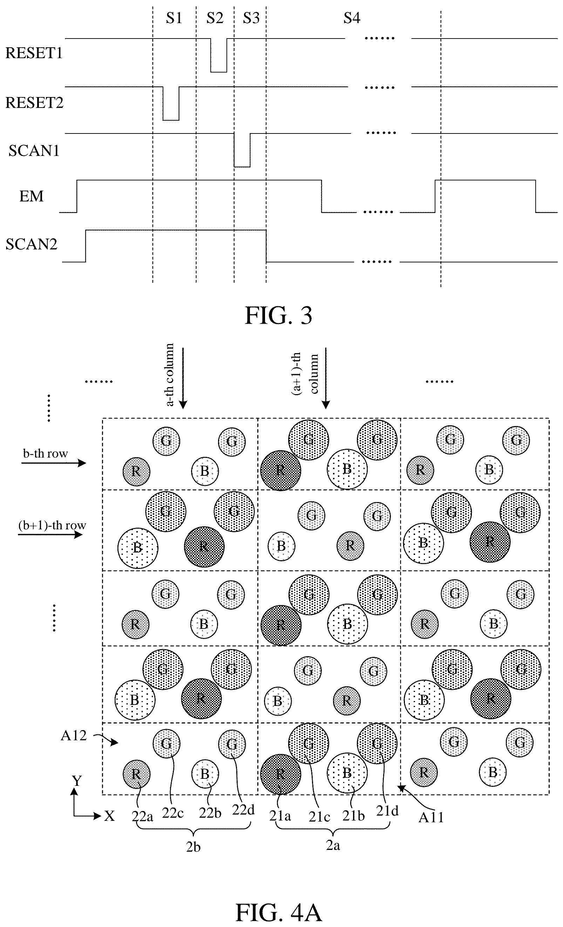

FIG. 3 is a working timing diagram of the pixel circuit provided in FIG. 2. A working process of the pixel circuit shown in FIG. 2 will be described below with reference to FIG. 3. Herein, the first transistor T1, the third transistor T3 to the eighth transistor T8 of the pixel circuit are P-type transistors, and the second transistor T2 is an N-type transistor.

In some examples, as shown in FIGS. 2 and 3, during one frame of display period, the working process of the pixel circuit may at least include a first stage S1, a second stage S2, a third stage S3, and a fourth stage S4.

The first stage S1 is referred to as a first reset stage. In the first stage S1, the second reset control signal RESET2 provided by the second reset control line RST2 is a low-level signal to turn on the seventh transistor T7 and the eighth transistor T8, and the second scan signal SCAN2 provided by the second scan line GL2 is a high-level signal to turn on the second transistor T2. The eighth transistor T8 is turned on so that the third initial signal provided by the third initial signal line INIT3 is provided to the second node N2. The seventh transistor T7 is turned on so that the second initial signal provided by the second initial signal line INIT2 is provided to the fourth node N4 to initialize the fourth node N4. The first scan signal SCAN1 provided by the first scan line GL1 is a high-level signal, the first reset control signal RESET1 provided by the first reset control line RST1 is a high-level signal, and the light emitting control signal EM provided by the light emitting control line EML is a high-level signal, so that the fourth transistor T4, the first transistor T1, the fifth transistor T5 and the sixth transistor T6 are turned off. In this stage, the light emitting element EL does not emit light.

The second stage S2 is referred to as a second reset stage. In the second stage S2, the first reset control signal RESET1 provided by the first reset control line RST1 is a low-level signal, and the first transistor T1 is turned on. The second scan signal SCAN2 provided by the second scan line GL2 is a high-level signal, and the second transistor T2 is turned on. The first transistor T1 and the second transistor T2 are turned on such that a first initial signal line provided by the first initial signal line INIT1 is provided to the first node N1 to initialize the first node N1. The second reset control signal RESET2 provided by the second reset control line RST2 is a high-level signal, the first scan signal SCAN1 provided by the first scan line GL1 is a high-level signal, and the light emitting control signal EM provided by the light emitting control line EML is a high-level signal, so that the seventh transistor T7, the eighth transistor T8, the fourth transistor T4, the fifth transistor T5 and the sixth transistor T6 are turned off. In this stage, the light emitting element EL does not emit light.

The third stage S3 is referred to as a data writing stage or a threshold compensation stage. In the third stage S3, the first scan signal SCAN1 provided by the first scan line GL1 is a low-level signal, and the fourth transistor T4 is turned on. The second scan signal SCAN2 provided by the second scan line GL2 is a high-level signal, and the second transistor T2 is turned on. At this stage, the first electrode of the storage capacitor Cst is at a low level and the third transistor T3 is turned on. The second transistor T2, the fourth transistor T4 and the fourth transistor T3 are turned on, so that a data voltage Vdata output by the data line DL is provided to the first node N1 through the second node N2, the turned-on third transistor T3, the third node N3, and the turned-on second transistor T2, and the storage capacitor Cst is charged with a difference between the data voltage Vdata output by the data line DL and a threshold voltage of the third transistor T3. A voltage of the first electrode (i.e., the first node N1) of the storage capacitor Cst is Vdata-|Vth|, wherein Vdata is the data voltage output by the data line DL, and Vth is the threshold voltage of the third transistor T3. The first reset control signal RESET1 provided by the first reset control line RST1 is a high-level signal, the second reset control signal RESET2 provided by the second reset control line RST2 is a high-level signal, and the light emitting control signal EM provided by the light emitting control line EML is a high-level signal, so that the first transistor T1, the seventh transistor T7, the eighth transistor T8, the fifth transistor T5 and the sixth transistor T6 are turned off.

In the fourth stage S4, the light emitting control signal EM provided by the light emitting control line EML can be switched from the high-level signal to a low-level signal, so that the fifth transistor T5 and the sixth transistor T6 are turned on. The second scan signal SCAN2 provided by the second scan line GL2 is a low-level signal, so that the second transistor T2 is turned off. The first scan signal SCAN1 provided by the first scan line GL1, the first reset control signal RESET1 provided by the first reset control line RST1, and the second reset control signal RESET2 provided by the second reset control line RST2 are high-level signals, so that the fourth transistor T4, the first transistor T1, the seventh transistor T7, and the eighth transistor T8 are turned off. The first voltage signal VDD outputted by the first power supply line PL1 may provide a drive voltage to the anode of the light emitting element EL through the turned-on fifth transistor T5, the third transistor T3, and the sixth transistor T6, driving the light emitting element EL to emit light.

In a driving process of the pixel circuit, a drive current flowing through the third transistor T3 is determined by a voltage difference between the gate and the first electrode of the third transistor T3. Since a voltage of the first node N1 is Vdata-|Vth|, the drive current of the third transistor T3 is as follows.

$$I=K\times(Vgs\text{-}Vth)^2=K\times[(VDD\text{-}Vdata+|Vth|)\text{-}Vth]^2=K\times[VDD\text{-}Vdata]^2.$$

Herein, I is the drive current flowing through the third transistor T3, that is, a drive current for driving the light emitting element, K is a constant, Vgs is the voltage difference between the gate and the first electrode of the third transistor T3, Vth is the threshold voltage of the third transistor T3, Vdata is the data voltage outputted by the data line DL, and VDD is the first voltage signal outputted by the first power supply line PL1.

It may be seen from the above formula that a current flowing through the light emitting element is independent of the threshold voltage of the third transistor T3. Therefore, the pixel circuit according to this embodiment may better compensate the threshold voltage of the third transistor T3. Moreover, the pixel circuit provided in the present embodiment may improve poor display caused by low frequency and improve a display effect of the light emitting element.

In some examples, as shown in FIG. 1, the first display region A1 of the display substrate may be provided with a plurality of first light emitting elements 21, a plurality of second light emitting elements 22, and a plurality of first pixel circuits 11. At least one first pixel circuit 11 is electrically connected with at least one first light emitting element 21, and is configured to drive the at least one first light emitting element 21 to emit light. The second display region A2 may be provided with a plurality of second pixel circuits 12, a plurality of third pixel circuits 13, and a plurality of third light emitting elements 23. The circuit structures of the first pixel circuit 11, the second pixel circuit 12, and the third pixel circuit 13 of the present example may be the same, for example, an 8T1C structure as described above. At least one second pixel circuit 12 may be electrically connected to at least one second light emitting element 22 through at least one conductive connection line 15, and is configured to drive the at least one second light emitting element 22 to emit light. The conductive connection line 15 may extend from the first display region A1 to the second display region A2. At least one third pixel circuit 13 is electrically connected to at least one third light emitting element 23, and is configured to drive the at least one third light emitting element 23 to emit light.

For example, the plurality of first pixel circuits 11 and the plurality of first light emitting elements 21 are electrically connected in a one-to-one correspondence, and one first pixel circuit 11 may be configured to drive one first light emitting element 21. An orthographic projection of a first light emitting element 21 on the base substrate is at least partially overlapped with an orthographic projection of a first pixel circuit 11 connected thereto on the base substrate. The plurality of second pixel circuits 12 and the plurality of second light emitting elements 22 are electrically connected in one-to-one correspondence and one second pixel circuit 12 may be configured to drive one second light emitting element 22. An orthographic projection of a second light emitting element 22 on the base substrate and an orthographic projection of a second pixel circuit 12 connected thereto on the base substrate may not overlap. The plurality of third pixel circuits 13 and the plurality of third light emitting elements 23 are electrically connected in a one-to-one correspondence, and one third pixel circuit 13 may be configured to drive one third light emitting element 23. An orthographic projection of a third light emitting element 23 on the base substrate is at least partially overlapped with an orthographic projection of a third pixel circuit 13 connected thereto on the base substrate. However, the present embodiment is not limited thereto. In other examples, a plurality of first pixel circuits may be configured to drive one first light emitting element; alternatively, one first pixel circuit may be configured to drive a plurality of first light emitting elements. As another example, a plurality of second pixel circuits may be configured to drive one second light emitting element; alternatively, one second pixel circuit may be configured to drive a plurality of second light emitting elements. As another example, a plurality of third pixel circuits may be configured to drive one third light emitting element; alternatively, one third pixel circuit may be configured to drive a plurality of third light emitting elements.

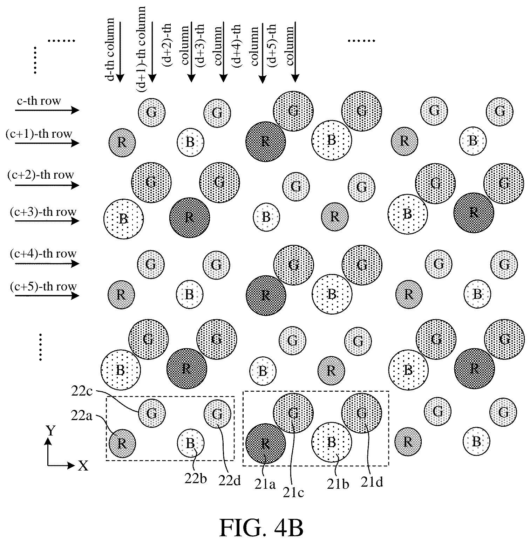

FIG. 4A and FIG. 4B are partial schematic diagrams of a first display region according to at least one embodiment of the present disclosure. In some examples, as shown in FIG. 4A, the first display region may include a plurality of first sub-regions A11 and a plurality of second sub-regions A12. At least one first sub-region A11 is adjacent to at least one second sub-region A12, for example, a first sub-region A11 is adjacent to two second sub-regions A12 in the first direction X and is located in the middle of the two second sub-regions A12; a first sub-region A11 is adjacent to two second sub-regions A12 in the second direction Y, and is located in the middle of the two second sub-regions A12. The first direction X intersects with the second direction Y. For example, the first direction X may be perpendicular to the second direction Y.

In some examples, as shown in FIG. 4A, a first sub-region A11 may be provided with one first light emitting unit 2a, and a second sub-region A12 may be provided with one second light emitting unit 2b. A plurality of first light emitting units 2a and a plurality of second light emitting units 2b of the first display region may be arrayed in a plurality of rows and a plurality of columns. A row of light emitting units may include a plurality of first light emitting units 2a and a plurality of second light emitting units 2b arranged at intervals in the first direction X, and a column of light emitting units may include a plurality of first light emitting units 2a and a plurality of second light emitting units 2b arranged at intervals in the second direction Y. In the first direction X, the first light emitting units 2a and the second light emitting units 2b are arranged at intervals one by one; in the second direction Y, the first light emitting units 2a and the second light emitting units 2b are arranged at intervals one by one. For example, one first light emitting unit 2a may be adjacent to four second light emitting units 2b. In this example, "A is adjacent to B " means that A is close to B and there are no other objects of the same type between A and B. By providing the first light emitting units and the second light emitting units to be arranged at intervals both in the first direction and the second direction, this example not only ensures the light transmittance of the first display region, but also facilitates the realization of a larger size of the first display region, and also facilitates the brightness compensation to enhance the luminance uniformity of the first display region.

In some examples, as shown in FIGS. 4A and 4B, in the first direction X, a first light emitting unit 2a and a second light emitting unit 2b which are adjacent are arranged in alignment, and in the second direction Y, a first light emitting unit 2a and a second light emitting unit 2b which are adjacent are arranged in alignment. In this example, " in the C direction, A and B are arranged in alignment " means that a line connecting the center positions of A and B in the C direction is substantially parallel to the C direction.

In some examples, as shown in FIG. 4A, a first light emitting unit 2a may include at least one first light emitting element, for example, four first light emitting elements; a second light emitting unit 2b may include at least one second light emitting element, for example four second light emitting elements. A quantity of first light emitting elements included in the first light emitting unit 2a and a quantity of second light emitting elements included in the second light emitting unit 2b may be the same. However, the present embodiment is not limited thereto. In another example, a quantity of first light emitting elements included in the first light emitting unit may be larger than a quantity of second light emitting elements included in the second light emitting unit, or a quantity of first light emitting elements included in the first light emitting unit may be smaller than a quantity of second light emitting elements included in the second light emitting unit. In this example, by setting the quantity of first light emitting elements included in the first light emitting unit and the quantity of second light emitting elements included in the second light emitting unit to be the same, it is possible to facilitate control of a ratio of the first light emitting elements and the second light emitting elements, thereby facilitating the design of brightness compensation between the first light emitting elements and the second light emitting elements.

In some examples, as shown in FIGS. 4A and 4B, a plurality of light emitting elements (including a plurality of first light emitting elements and a plurality of second light emitting elements) of the first display region may be arrayed in a plurality of rows and a plurality of columns. A row of light emitting elements may include a plurality of first light emitting elements and a plurality of second light emitting elements arranged in the first direction X, and a column of light emitting elements may include a plurality of first light emitting elements and a plurality of second light emitting elements arranged in the second direction Y. One column of light emitting units may include four columns of light emitting elements, and one row of light emitting units may include two rows of light emitting elements. For example, an a-th column of light emitting units may include a d-th column, (d+1)-th column, (d+2)-th column, and (d+3)-th column of light emitting elements, and a b-th row of light emitting units may include a c-th row and (c+1)-th row of light emitting elements, wherein a, b, c, and d are all integers greater than 0.

In some examples, as shown in FIGS. 4A and 4B, one light emitting unit 2a may include four first light emitting elements: one first light emitting element 21a that emits light of a first color, one first light emitting element 21b that emits light of a second color, and two first light emitting elements 21c and 21d that emit light of a third color. Herein, the four first light emitting elements included in the first light emitting unit 2a may be provided in two rows of light emitting elements, the first light emitting element 21a that emits light of the first color and the first light emitting element 21b that emits light of the second color may be provided in a same row of light emitting elements, the two first light emitting elements 21c and 21d that emit light of the third color may be provided in a same row of light emitting elements, and the four first light emitting elements may be provided in different columns of light emitting elements.

In some examples, as shown in FIGS. 4A and 4B, one second light emitting unit 2b may include four second light emitting elements: one second light emitting element 22a that emits light of the first color, one second light emitting element 22b that emits light of the second color, and two second light emitting elements 22c and 22d that emit light of the third color. Herein, the four second light emitting elements included in one second light emitting unit 2b may be provided in two rows of light emitting elements, the second light emitting element 22a that emits light of the first color and the second light emitting element 22b that emits light of the second color may be provided in a same row of light emitting elements, the two second light emitting elements 22c and 22d that emit light of the third color may be provided in a same row of light emitting elements, and the four second light emitting elements may be provided in different columns of light emitting elements. The arrangement of the four second light emitting elements in the second light emitting unit is substantially the same as that of the four first light emitting elements in the first light emitting unit of the present example. The arrangement of the light emitting elements of the present example may facilitate the design of brightness compensation between the first light emitting element and the second light emitting element.

In some examples, as shown in FIG. 4B, in the c-th row of light emitting elements, two second light emitting elements 22c and 22d that emit light of the third color and two first light emitting elements 21c and 21d that emit light of the third color may be periodically arranged in the first direction X; in the (c+1)-th row of light emitting elements, the second light emitting element 22a that emits light of the first color, the second light emitting element 22b that emits light of the second color, the first light emitting element 21a that emits light of the first color, and the first light emitting element 21b that emits light of the second color may be periodically arranged in the first direction X. In the d-th column of light emitting elements, the second light emitting element 22a that emit light of the first color and the first light emitting element 21b that emit light of the second color may be arranged at intervals in the second direction X; in the (d+1)-th column of light emitting elements, the second light emitting element 22c (or 22d) that emits light of the second color and the first light emitting element 21c (or 21d) that emits light of the third color may be arranged at intervals in the second direction Y; in the (d+2)-th column of light emitting elements, the second light emitting element 22b that emit light of the second color and the first light emitting element 21a that emits light of the first color may be arranged at intervals in the second direction Y; in the (d+3)-th column of light emitting elements, the second light emitting element 22d that emits light of the second color and the first light emitting element 21d that emits light of the third color may be arranged at intervals in the second direction Y.

In some examples, as shown in FIG. 4A, in different first light emitting units located in adjacent rows of light emitting units, the arrangement order of the first light emitting element 21a that emits light of the first color and the first light emitting element 21b that emits light of the second color is reversed. For example, in the first light emitting unit located in the b-th row, the first light emitting element 21a that emits light of the first color and the first light emitting element 21b that emits light of the second color may be arranged sequentially along the first direction X. In the first light emitting elements located in a (b+1)-th row, the first light emitting element 21b that emits light of the second color and the first light emitting element 21a that emits light of the first color may be arranged sequentially along the first direction X.

In some examples, as shown in FIG. 4A, in different first light emitting units located in adjacent columns of light emitting units, the arrangement order of the first light emitting element 21a that emits light of the first color and the first light emitting element 21b that emits light of the second color is reversed. For example, in the first light emitting unit located in the a-th column, the first light emitting element 21b that emits light of the second color and the first light emitting element 21a that emits light of the first color may be arranged sequentially along the first direction X. In the first light emitting unit located in an (a+1)-th column, the first light emitting element 21a that emits light of the first color and the first light emitting element 21b that emits light of the second color may be arranged sequentially along the first direction X.

In some examples, as shown in FIG. 4A, in different second light emitting units located in adjacent rows of light emitting units, the arrangement order of the second light emitting elements 22a that emit light of the first color and the second light emitting elements 22b that emit light of the second color is reversed; in different second light emitting units located in adjacent columns of light emitting units, the arrangement order of the second light emitting elements 22a emitting light of the first color and the second light emitting elements 22b emitting light of the second color is reversed. Since the arrangement of the second light emitting element in the second light emitting unit is similar to the arrangement of the first light emitting element in the first light emitting unit, the description thereof will not be repeated here.

In some examples, light of the first color may be red light (R), light of the second color may be blue light (B), and light of the third color may be green light (G). However, the present embodiment is not limited thereto.

In some examples, the first light emitting element of the first light emitting unit 2a of the first display region may be configured to perform brightness compensation for the second light emitting element emitting light of a same color in an adjacent second light emitting unit 2b. For example, the first light emitting elements 21b that emit blue light in the first light emitting units 2a in the a-th column and the (b+1)-th row and the a-th column and the (b+3)-th row may perform brightness compensation for the second light emitting element 22b that emits blue light in the second light emitting unit 2b in the a-th column and the (b+2)-th row. The first light emitting elements 21a that emit red light in the first light emitting units 2a in the a-th column and the (b+1)-th row and the a-th column and the (b+3)-th row may perform brightness compensation for the second light emitting element 22a that emits red light in the second light emitting unit 2b in the a-th column and the (b+2)-th row. The first light emitting element 21c that emits green light in the first light emitting unit 2a in the (a+1)-th column and the b-th row, the first light emitting element 21d that emits green light in the first light emitting unit 2a in the a-th column and the (b+1)-th row and the first light emitting element 21c that emits green light in the first light emitting unit 2a in the (a+1)-th column and the (b+2)-th row may perform brightness compensation for the second light emitting element 22c that emits green light in the second light emitting unit 2b in the (a+1)-th column and the (b+1)-th row. In this example, the first light emitting element in the first light emitting unit is used to perform brightness compensation for the second light emitting element that emits light of a same color in an adjacent second light emitting unit, which can effectively improve a situation in which where the brightness of the second light emitting element is dark.

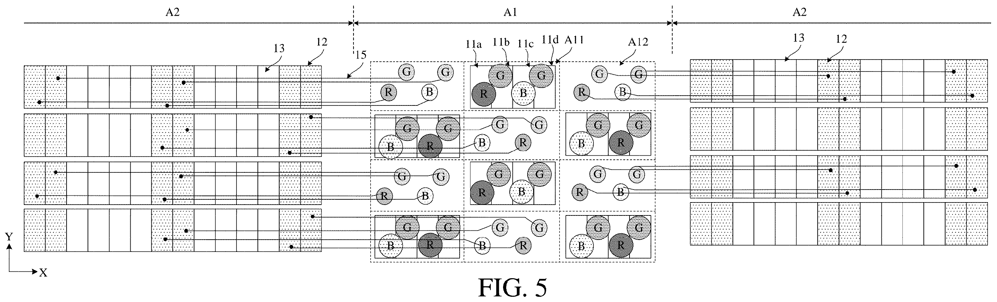

FIG. 5 is a schematic diagram of a connection relationship between a light emitting element and a pixel circuit according to at least one embodiment of the present disclosure. In some examples, as shown in FIG. 5, the first display region A1 may include a plurality of first pixel circuits (including, for example, first pixel circuits 11a, 11b, 11c, and 11d), a plurality of first light emitting elements, and a plurality of second light emitting elements, the second display region A2 may include a plurality of second pixel circuits 12, a plurality of third pixel circuits 13, and a plurality of third light emitting elements (not shown). The first pixel circuits and the first light emitting elements may be located in the first sub-region A11, and the second light emitting elements may be located in the second sub-region A12. The light transmittance of the second sub-region A12 may be greater than the light transmittance of the first sub-region A11. For example, the first sub-region A11 may be a non-light transmitting region, and the second sub-region A12 may include a non-light transmitting region and a light transmitting region. The position of the anode and the trace of a second light emitting element in the second sub-region A12 may be a non-light-transmitting region, and a region where the metal trace is not provided between the anodes of adjacent second light emitting elements may be a light-transmitting region.

In some examples, as shown in FIG. 5, four first pixel circuits of each first sub-region A11 may be sequentially arranged along the first direction X. For example, the first pixel circuits 11a, 11b, 11c, and 11d may be arranged sequentially along the first direction X. The four first light emitting elements of the first light emitting unit and the four first pixel circuits may be electrically connected in one-to-one correspondence. For example, a first light emitting element (e.g., a red first light emitting element) that emits light of a first color may be electrically connected to the first pixel circuit 11a, one first light emitting element (e.g., a green first light emitting element) that emits light of a third color may be electrically connected to the first pixel circuit 11b, a first light emitting element (for example, a blue first light emitting element) that emits light of a second color may be electrically connected to the first pixel circuit 11c, and another first light emitting element (for example, a green first light emitting element) that emits light of the third color may be electrically connected to the first pixel circuit 11d.

In some examples, as shown in FIG. 5, the second sub-region A12 is not provided with a pixel circuit, and four second light emitting elements in the second sub-region A12 may be electrically connected to the second pixel circuits 12 in the second display region A2 through conductive connection lines 15. In the second sub-region A12, light-transmitting regions between adjacent second light emitting elements may be connected to each other to form a continuous light-transmitting region, thereby improving the light transmittance of the first display region.

In some examples, as shown in FIG. 5, in the second display region A2, the plurality of second pixel circuits 12 may be distributed at intervals among the plurality of third pixel circuits 13. In the second display region A2, a region in which the second pixel circuit 12 is disposed can be obtained by reducing the size of the third pixel circuit 13 in the first direction X. For example, the size of the third pixel circuit 13 in the first direction X may be smaller than the size of the third light emitting element in the first direction X.

In some examples, original f columns of third pixel circuits may be compressed along the first direction X, so that arrangement space of one or two columns of second pixel circuits may be added, and space occupied by f columns of pixel circuits before compression and f+1 columns or f+2 columns of pixel circuits after compression may be the same. Herein, f may be an integer greater than 1. In this example, f may be 4, and arrangement space of two columns of second pixel circuits is added by compressing four columns of third pixel circuits. However, the present embodiment is not limited thereto.

In some examples, as shown in FIG. 5, the second pixel circuit 12 may be provided in the second display region A2 on two sides (e.g., left and right sides) of the first display region A1 along the first direction X, and the second pixel circuit may not be provided in the second display region on two sides (e.g., upper and lower sides) of the first display region A1 along the second direction Y, or an invalid pixel circuit may be provided therein to maintain uniformity of components of a plurality of film layers in the second display region in the etching process. The structure of the invalid pixel circuit and the structure of the second pixel circuit in the row or column where the invalid pixel circuit is located may be substantially the same, except that the invalid pixel circuit is not electrically connected to any light emitting element. The present embodiment is not limited thereto.

In some examples, as shown in FIG. 5, the second light emitting element in the first display region A1 close to the center of the first display region A1 may be electrically connected to the second pixel circuit 12 in the second display region A2 close to the first display region A1, and the second light emitting element close to the edge of the first display region A1 may be electrically connected to the second pixel circuit away from the first display region A1. The present embodiment is not limited to the connection relationship between the second pixel circuit and the second light emitting element.

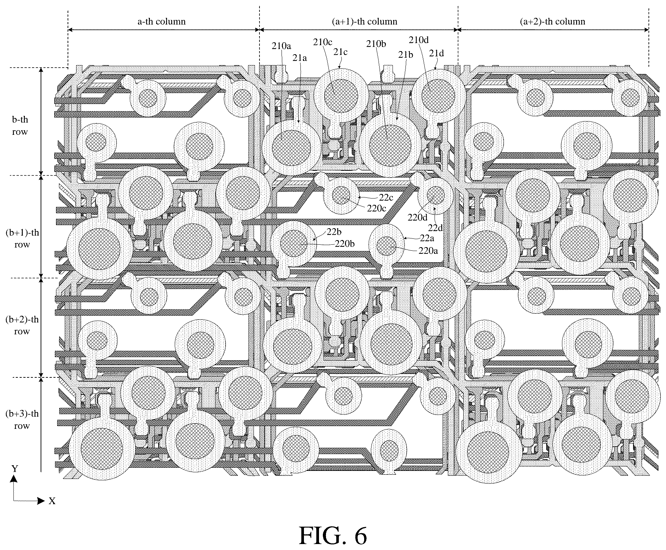

FIG. 6 is a top view of a part of a first display region according to at least one embodiment of the present disclosure. The first light emitting units and the second light emitting units in the a-th column to the (a+2)-th column and the b-th row to the (b+3)-th row are illustrated in FIG. 6. In some examples, as shown in FIG. 6, on a plane parallel to the display substrate, the first display region of the display substrate includes a plurality of first sub-regions and a plurality of second sub-regions arranged at intervals along the first direction X and the second direction Y. The first sub-region may include one first light emitting unit (including four first light emitting elements 21a, 21b, 21c, and 21d) and four first pixel circuits, and the second sub-region may include one second light emitting unit (including four second light emitting elements 22a, 22b, 22c, and 22d). The second sub-region in which the second light emitting unit in the (a+1)-th column and the (b+1)-th row is located may be surrounded by the first sub-region in which the first light emitting unit in the (a+1)-th column and the b-th row is located, the first sub-region in which the first light emitting unit in the a-th column and the (b+1)-th row is located, the first sub-region in which the first light emitting unit in the (a+2)-th column and the (b+1)-th row is located, and the first sub-region in which the first light emitting unit in the (a+1)-th column and the (b+2)-th row is located. The first sub-region in which the first light emitting unit in the (a+1)-th column and the b-th row is located, the first sub-region in which the first light emitting unit in the a-th column and the (b+1)-th row is located, the first sub-region in which the first light emitting unit in the (a+2)-th column and the (b+1)-th row is located, and the first sub-region in which the first light emitting unit in the (a+1)-th column and the (b+2)-th row may communicate with each other.

In some examples, in a direction perpendicular to the display substrate, the display substrate may include a base substrate, and a circuit structure layer, a conductive connection layer, and a light emitting structure layer disposed on the base substrate. The light emitting structure layer may be located on a side of the circuit structure layer away from the base substrate, and the conductive connection layer may be located between the circuit structure layer and the light emitting structure layer. The circuit structure layer of the first display region may include a plurality of first pixel circuits, and the light emitting structure layer of the first display region may include a plurality of first light emitting elements and a plurality of second light emitting elements.

In some examples, the circuit structure layer may include: a first semiconductor layer, a first conductive layer, a second conductive layer, a second semiconductor layer, a third conductive layer, a fourth conductive layer, a fifth conductive layer, and a sixth conductive layer disposed on the base substrate. A first insulating layer may be provided between the first semiconductor layer and the first conductive layer, a second insulating layer may be provided between the first conductive layer and the second conductive layer, a third insulating layer may be provided between the second conductive layer and the second semiconductor layer, a fourth insulating layer may be provided between the second conductive layer and the third conductive layer, a fifth insulating layer may be provided between the third conductive layer and the fourth conductive layer, a sixth insulating layer and a seventh insulating layer may be provided between the fourth conductive layer and the fifth conductive layer, an eighth insulating layer may be provided between the fifth conductive layer and the sixth conductive layer, and a ninth insulating layer may be provided on a side of the sixth conductive layer away from the base substrate. In some examples, the first insulating layer to the sixth insulating layer may be inorganic insulating layers, and the seventh insulating layer to the ninth insulating layer may be organic insulating layers. The present embodiment is not limited thereto.

In some examples, the conductive connection layer may include a plurality of conductive connection lines, and the conductive connection lines may extend from the first display region to the second display region to realize electrical connection between the second light emitting element and the second pixel circuit.

In some examples, the light emitting structure layer may include an anode layer, a pixel definition layer, an organic light emitting layer, and a cathode layer disposed sequentially on the circuit structure layer. The anode layer may be electrically connected with a pixel circuit of the circuit structure layer, the organic light emitting layer may be connected with the anode layer, the cathode layer may be connected with the organic light emitting layer, and the organic light emitting layer may emit light of corresponding colors under drive of the anode layer and the cathode layer.

In some examples, the encapsulation structure layer may include a first encapsulation layer, a second encapsulation layer, and a third encapsulation layer that are stacked. The first encapsulation layer and the third encapsulation layer may be made of an inorganic material, the second encapsulation layer may be made of an organic material, and the second encapsulation layer may be arranged between the first encapsulation layer and the third encapsulation layer to form a laminated structure of inorganic material/organic material/inorganic material, which may ensure that external moisture cannot enter the light emitting structure layer. In some possible implementation modes, the display substrate may further include another film layer, such as a touch structure layer and a color filter layer, which is not limited here in this embodiment.

A structure of the display substrate will be described below through an example of a manufacturing process of the display substrate. A "patterning process" mentioned in the present disclosure includes photoresist coating, mask exposure, development, etching, photoresist stripping, and the like for a metal material, an inorganic material, or a transparent conductive material, and includes organic material coating, mask exposure, development, and the like for an organic material. Deposition may be any one or more of sputtering, evaporation, and chemical vapor deposition, coating may be any one or more of spray coating, spin coating, and inkjet printing, and etching may be any one or more of dry etching and wet etching, the present disclosure is not limited thereto. A "thin film" refers to a layer of thin film made of a certain material on a base substrate using deposition, coating, or other processes. If the "thin film" does not need to be processed through a patterning process in the entire manufacturing process, the "thin film" may also be called a "layer". If the "thin film" needs to be processed through the patterning process in the entire manufacturing process, the "thin film" is called a "thin film" before the patterning process is performed and is called a "layer" after the patterning process is performed. At least one "pattern" is contained in the "layer" which has been processed through the patterning process.

"A and B are disposed in a same layer" in the present disclosure means that A and B are formed simultaneously through a same patterning process, or distances between surfaces of A and B close to a base substrate and the base substrate are substantially the same, or the surfaces of A and B close to the base substrate are in direct contact with a same film layer. A "thickness" of a film layer is a dimension of the film layer in a direction perpendicular to the display substrate. In an exemplary embodiment of the present disclosure, "an orthographic projection of B being within a range of an orthographic projection of A" or "an orthographic projection of A containing an orthographic projection of B" means that a boundary of the orthographic projection of B falls within a range of a boundary of the orthographic projection of A, or the boundary of the orthographic projection of A overlaps with the boundary of the orthographic projection of B. "A shape of A" in the present disclosure refers to a shape of an orthographic projection of A on the base substrate.

In some examples, the preparing process of the display substrate may include the following operations. Hereinafter, the circuit structure layer will be described by taking two first pixel circuits in the first sub-region of the first display region as an example. The example is explained by taking a case that a first pixel circuit is of the aforementioned 8T1C structure. The first one of the first pixel circuits (i.e., the first pixel circuit 11a) may include: a first transistor 31a, a second transistor 32a, a third transistor 33a, a fourth transistor 34a, a fifth transistor 35a, a sixth transistor 36a, a seventh transistor 37a, an eighth transistor 38a, and a storage capacitor; the second one of the first pixel circuits (i.e., the first pixel circuit 11b) may include a first transistor 31b, a second transistor 32b, a third transistor 33b, a fourth transistor 34b, a fifth transistor 35b, a sixth transistor 36b, a seventh transistor 37b, an eighth transistor 38b, and a storage capacitor. A connection relationship between eight transistors and a storage capacitor in each first pixel circuit may be referred to the equivalent circuit diagram shown in FIG. 2.

(1) A base substrate is provided. In some examples, the base substrate may be a rigid substrate or a flexible substrate. For example, the rigid substrate may be made of, but not limited to, one or more of glass and quartz. The flexible substrate may be made of, but not limited to, one or more of polyethylene terephthalate, ethylene terephthalate, polyether ether ketone, polystyrene, polycarbonate, polyarylate, polyarylester, polyimide, polyvinyl chloride, polyethylene, and textile fibers. In some examples, the flexible base substrate may include a first flexible material layer, a first inorganic material layer, a second flexible material layer and a second inorganic material layer which are stacked. The first flexible material layer and the second flexible material layer may be made of a material such as Polyimide (PI), Polyethylene Terephthalate (PET), or a polymer soft film on which surface treatment is performed, and a material of the first inorganic material layer and the second inorganic material layer may be Silicon Nitride (SiNx,x>0) or Silicon Oxide (SiOy,y>0), etc., which are used to improve resistance to water and oxygen of the base substrate.

(2) A first semiconductor layer is formed. In some examples, a first semiconductor thin film is deposited on the base substrate, and the first semiconductor thin film is patterned through a patterning process to form the first semiconductor layer disposed on the base substrate. In some examples, a material of the first semiconductor layer may be amorphous silicon (a-Si), polycrystalline silicon (p-Si), hexathiophene or polythiophene, or other materials.

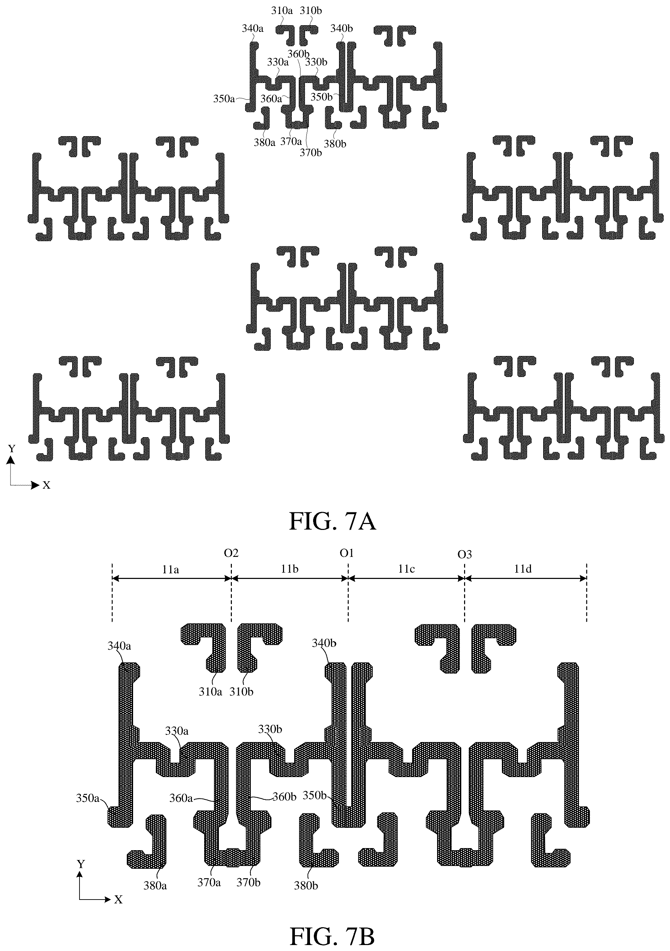

FIG. 7A is a schematic diagram of the first display region after a first semiconductor layer is formed in FIG. 6. FIG. 7B is a schematic diagram of one first sub-region in FIG. 7A.

In some examples, as shown in FIGS. 7A and 7B, the first semiconductor layer of the first display region may include at least active layers of a plurality of first type transistors of a plurality of first pixel circuits (e.g., including: a first active layer 310a of the first transistor, a third active layer 330a of the third transistor, a fourth active layer 340a of the fourth transistor, a fifth active layer 350a of the fifth transistor, a sixth active layer 360a of the sixth transistor, a seventh active layer 370a of the seventh transistor, and an eighth active layer 380a of the eighth transistor of the first pixel circuit 11a, a first active layer 310b of the first transistor, a third active layer 330b of the third transistor, a fourth active layer 340b of the fourth transistor, a fifth active layer 350b of the fifth transistor, a sixth active layer 360b of the sixth transistor, a seventh active layer 370b of the seventh transistor, and an eighth active layer 380b of the eighth transistor of the first pixel circuit 11b within the first sub-region).

In some examples, within the first sub-region, the patterns of the first semiconductor layers of the four first pixel circuits may be substantially symmetrical about a first centerline O1, the patterns of the first semiconductor layers of the first pixel circuits 11a and 11b may be substantially symmetrical about a second centerline O2, and the patterns of the first semiconductor layers of the first pixel circuits 11c and 11d may be substantially symmetrical about a third centerline O3. The patterns of the first semiconductor layers in different first sub-regions may be independent of each other.

In some examples, within the first sub-region, the first active layers, the third active layers, the fourth active layers, the fifth active layers, the sixth active layers, and the seventh active layers of the four first pixel circuits may be of an interconnected integral structure. The seventh active layer 370a of the first pixel circuit 11a and the seventh active layer 370b of the first pixel circuit 11b may be connected to each other. The fifth active layer 350b of the first pixel circuit 11b and the fifth active layer of the first pixel circuit 11c may be connected to each other. The seventh active layer of the first pixel circuit 11c and the seventh active layer of the first pixel circuit 11d may be connected to each other. The first active layer of each first pixel circuit may be located at a side of the third active layer in the second direction Y, and the eighth active layer may be located at a side of the third active layer in an opposite direction of the second direction Y.

In some examples, the third active layers 330a and 330b may be substantially u-shaped, the fourth active layers 340a and 340b, the fifth active layers 350a and 350b may be substantially I-shaped, the first active layers 310a and 310b, the sixth active layers 360a and 360b, the seventh active layers 370a and 370b, and the eighth active layers 380a and 380b may be substantially L-shaped. However, the present embodiment is not limited thereto.

In some examples, an active layer of each transistor may include: a first region, a second region, and a channel region located between the first region and the second region. A material of the first semiconductor layer may include, for example, polysilicon. The channel region may be not doped with impurities, and has characteristics of a semiconductor.

The first region and the second region may be doped regions on both sides of the channel region, and are doped with impurities, and thus have conductivity. The impurities may be different according to a type of a transistor. In some examples, a doped region of the active layer may be interpreted as a source or a drain of a transistor. A part of active layers between transistors may be interpreted as a wiring doped with impurities, and may be used for electrically connecting the transistors. The present embodiment is not limited thereto.

(2) A first conductive layer is formed. In some examples, a first insulating thin film and a first conductive thin film are deposited sequentially on the base substrate on which the aforementioned structures are formed, and the first conductive thin film is patterned through a patterning process to form a first insulating layer and a first conductive layer provided on the first insulating layer. In some examples, the first conductive layer may also be referred to as a first gate metal layer.

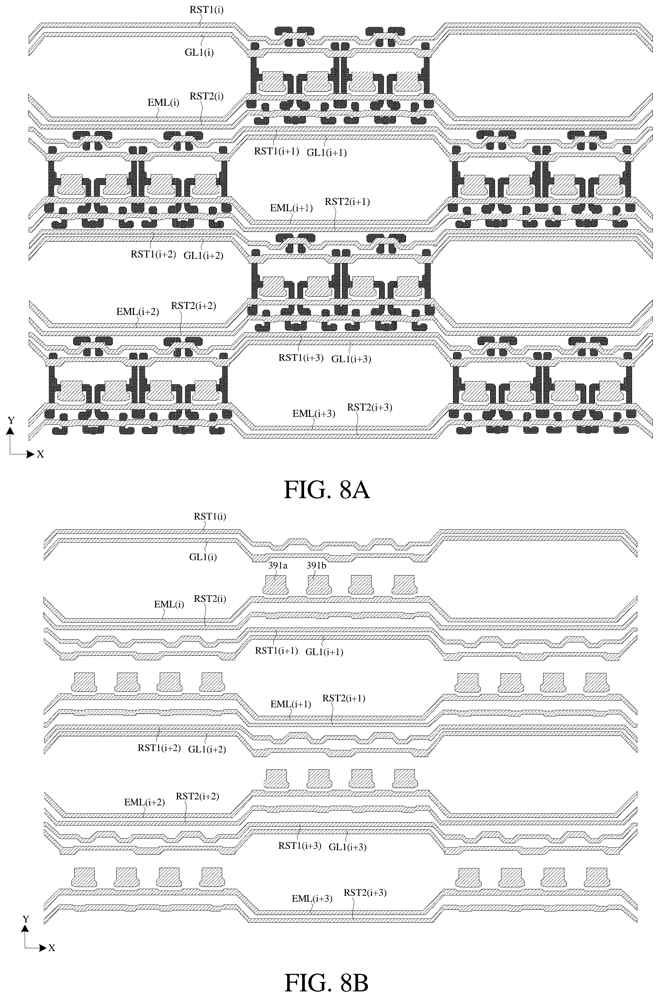

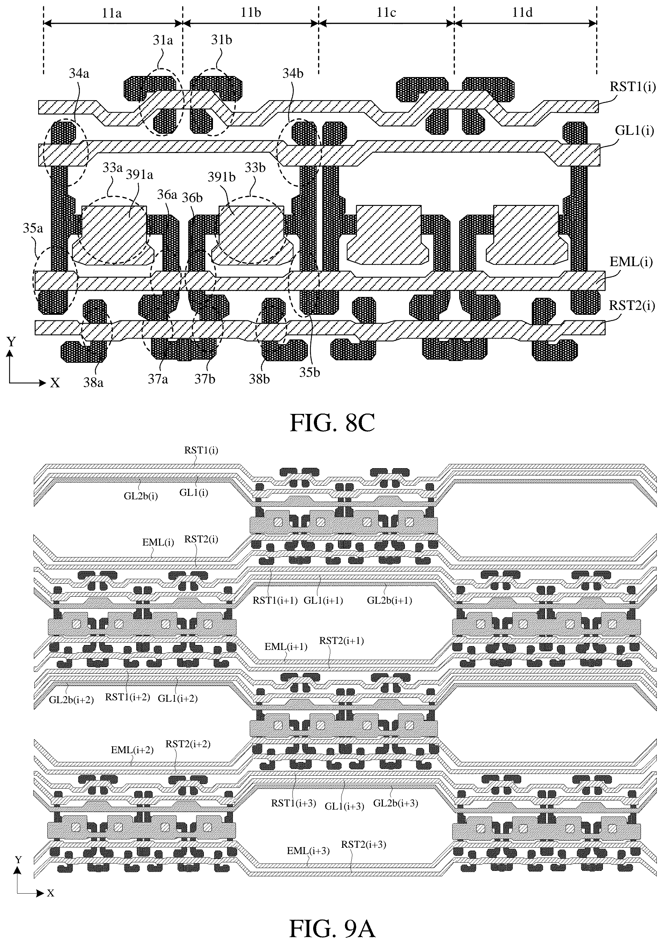

FIG. 8A is a schematic diagram of a first display region after a first conductive layer is formed in FIG. 6. FIG. 8B is a schematic diagram of the first conductive layer in FIG. 8A. FIG. 8C is a schematic diagram of one first sub-region in FIG. 8A.

In some examples, as shown in FIGS. 8A to 8C, the first conductive layer of the first display region may at least include: a plurality of first scan lines (e.g., first scan lines GL1(i), GL1(i+1), GL1(i+2), and GL1(i+3)), a plurality of light emitting control lines (e.g., light emitting control lines EML(i), EML(i+1), EML(i+2), and EML(i+3)), a plurality of first reset control lines (e.g., first reset control lines RST1(i), RST1(i+1), RST1(i+2), and RST1(i+3)), a plurality of second reset control lines (e.g., second reset control lines RST2(i), RST2(i+1), RST2(i+2), and RST2(i+3)), and first electrodes of storage capacitors of a plurality of first pixel circuits (e.g., first electrodes 391a and 391b).

In some examples, within the first sub-region, the first scan line GL1(i) may be located at a side of the first electrode (e.g., 391a and 391b) of the storage capacitor of the first pixel circuit in the second direction Y, and the first reset control line RST1(i) may be located at a side of the first scan line GL1(i) in the second direction Y. The light emitting control line EML(i) may be located at a side of the first electrode (for example, 391a and 391b) of the storage capacitor of the first pixel circuit in the opposite direction of the second direction Y, and the second reset control line RST2(i) may be located at a side of the light emitting control line EML(i) in the opposite direction of the second direction Y.

In some examples, the first reset control line RST1(i), the first scan line GL1(i), the second reset control line RST2(i), and the light emitting control line EML(i) may bypass a second sub-region adjacent to the first sub-region in which they are located in the first direction X by bending. For example, the first reset control line RST1(i) and the first scan line GL1(i) may bypass from a side of the second sub-region in the second direction Y, and the second reset control line RST2(i) and the light emitting control line EML(i) may bypass from a side of the second sub-region in the opposite direction in the second direction Y. In this example, by setting traces of the first conductive layer to bend to bypass the second sub-region, it is beneficial to improve the light transmittance of the second sub-region.

In some examples, a shape of the first reset control line RST1(i) may be substantially a polyline shape extending along the first direction X. In a first sub-region, overlapping regions of the first reset control line RST1(i) with first active layers of four first pixel circuits may serve as gates of first transistors of the four first pixel circuits (e.g., including a gate of the first transistor 31a, and a gate of the first transistor 31b).

In some examples, a shape of the first scan line GL1(i) may be substantially a polyline shape extending along the first direction X. In the first sub-region, overlapping regions of the first scan line GL1(i) with fourth active layers of four first pixel circuits may serve as gates of fourth transistors of the four first pixel circuits (e.g., including a gate of the fourth transistor 34a, and a gate of the fourth transistor 34b).

In some examples, a shape of the light emitting control line EML(i) may be substantially a polyline shape extending along the first direction X. In the first sub-region, overlapping regions of the light emitting control line EML(i) with fifth active layers of four first pixel circuits may serve as gates of fifth transistors of the four first pixel circuits (e.g., including gates of the fifth transistors 35a and 35b), and overlapping regions of the light emitting control line EML(i) with sixth active layers of the four first pixel circuits may serve as gates of sixth transistors of the four first pixel circuits (e.g., including gates of the sixth transistors 36a and 36b).

In some examples, a shape of the second reset control line RST2(i) may be substantially a polyline shape extending along the first direction X. In the sub-region, overlapping regions of the second reset control line RST2(i) with seventh active layers of four first pixel circuits may serve as gates of seventh transistors of the four first pixel circuits (e.g., including gates of the seventh transistors 37a and 37b), and overlapping regions of the second reset control line RST2(i) with eighth active layers of the four first pixel circuits may serve as gates of eighth transistors of the four first pixel circuits (e.g., including gates of the eighth transistors 38a and 38b).

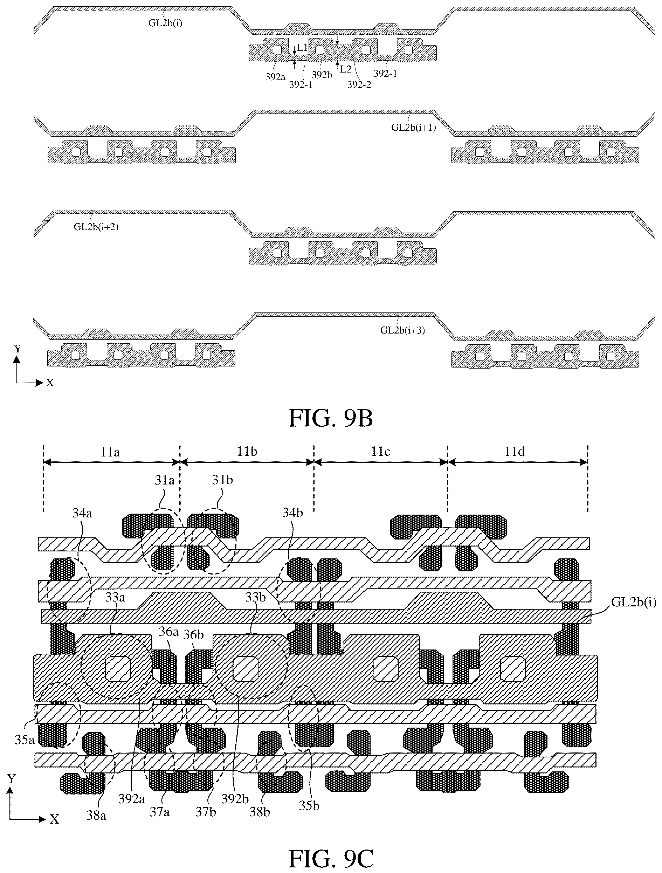

In some examples, the first electrode 391a of the storage capacitor of the first pixel circuit 11a may simultaneously serve as a gate of the third transistor 33a, and the first electrode 391b of the storage capacitor of the first pixel circuit 11b may simultaneously serve as a gate of the third transistor 33b. Orthographic projections of the first electrodes 391a and 391b on the base substrate may be substantially rectangular. The present embodiment is not limited thereto. (3) A second conductive layer is formed. In some examples, a second insulating thin film and a second conductive thin film are deposited sequentially on the base substrate on which the aforementioned structures are formed, and the second conductive thin film is patterned through a patterning process to form a second insulating layer and a second conductive layer disposed on the second insulating layer. In some examples, the second conductive layer may also be referred to as a second gate metal layer. FIG. 9A is a schematic diagram of a first display region after a second conductive layer is formed in FIG. 6. FIG. 9B is a schematic diagram of the second conductive layer in FIG. 9A. FIG. 9C is a schematic diagram of one first sub-region in FIG. 9A.

In some examples, as shown in FIGS. 9A to 9C, the second conductive layer of the first display region may at least include: a plurality of second scan auxiliary lines (e.g., second scan auxiliary lines GL2b(i), GL2b(i+1), GL2b(i+2), and GL2b(i+3)), and second electrodes of storage capacitors of a plurality of first pixel circuits (e.g., second electrodes 392a and 392b).

In some examples, a shape of the second scan auxiliary line GL2b(i) may be substantially a polyline shape extending along the first direction X. Within the first sub-region, the second scan auxiliary line GL2b(i) may be located at a side of the second electrode (e.g., 392a and 392b) of the storage capacitor of the first pixel circuit in the second direction Y. The second scan auxiliary line GL2b(i) may bypass the second sub-region from a side in the second direction Y, and may be located at a side of the first scan line GL1(i) in the opposite direction in the second direction Y.

In some examples, within the first sub-region, an orthographic projection of the second electrode of the storage capacitor of each first pixel circuit on the base substrate may be substantially a rectangular structure having a hollow region, an orthographic projection of the hollow region on the base substrate may be substantially in a shape of a rectangle, and the rectangle may have rounded corners or chamfers. The second electrode 392a of the storage capacitor of the first pixel circuit 11a and the second electrode 392b of the storage capacitor of the first pixel circuit 11b may be electrically connected through a first plate connection block 392-1, the second electrode 392b of the storage capacitor of the first pixel circuit 11b and the second electrode of the storage capacitor of the first pixel circuit 11c may be electrically connected through a second plate connection block 392-2, and the second electrode of the storage capacitor of the first pixel circuit 11c and the second electrode of the storage capacitor of the first pixel circuit 11d may be electrically connected through another first plate connection block 392-1. Sides of the second electrodes of the storage capacitors of the first pixel circuits 11a and 11d away from the remaining first pixel circuits may be electrically connected to one second plate connection blocks 392-2. The length L1 of the first plate connection block 392-1 in the second direction Y may be smaller than the length L2 of the second plate connection block 392-2 in the second direction Y. The second electrode of the storage capacitor may subsequently be electrically connected to the first power supply line through the second plate connection block. In this example, the second electrodes of the storage capacitors of the four first pixel circuits of the first sub-region may be connected to each other to form an integrated structure, which is conducive to ensuring uniform transmission of the first voltage signal in the first direction X.

(4) A second semiconductor layer is formed. In some examples, a third insulating thin film and a second semiconductor thin film are sequentially deposited on the base substrate on which the aforementioned patterns are formed, and the second semiconductor thin film is patterned through a patterning process to form a third insulating layer and a second semiconductor layer provided on the third insulating layer. In some examples, a material of the second semiconductor layer may include Indium Gallium Zinc Oxide (IGZO).

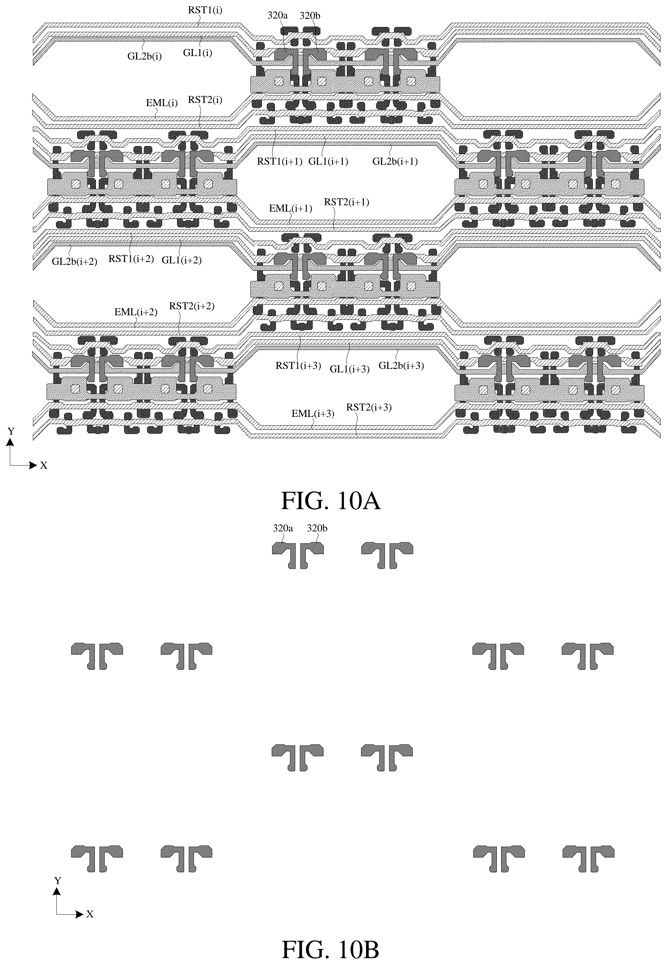

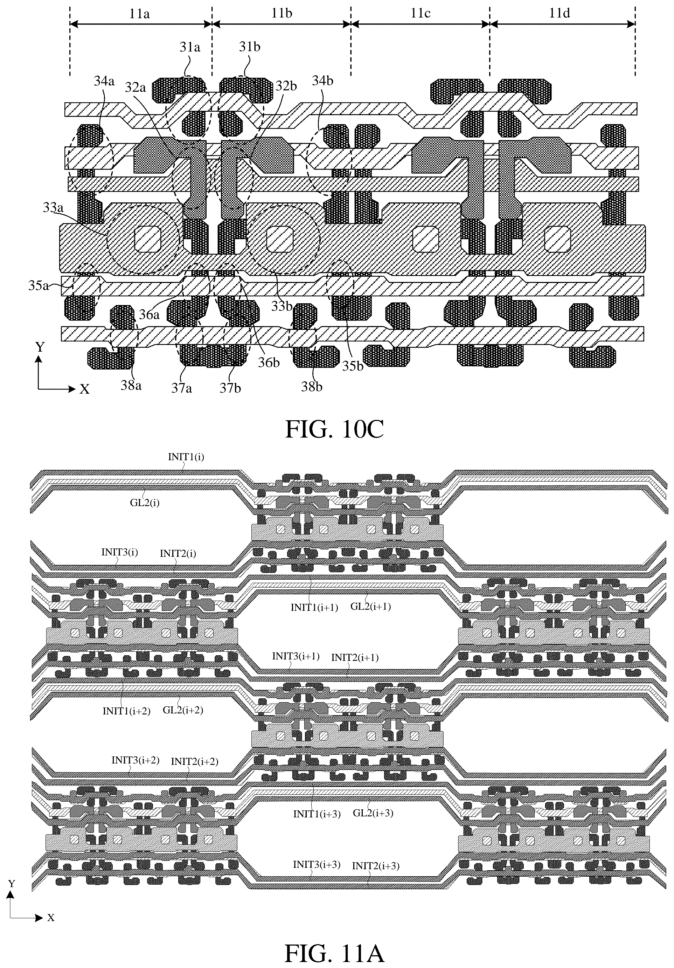

FIG. 10A is a schematic diagram of a first display region after a second semiconductor layer is formed in FIG. 6. FIG. 10B is a schematic diagram of the second semiconductor layer in FIG. 10A. FIG. 10C is a schematic diagram of one first sub-region in FIG. 10A.

In some examples, as shown in FIGS. 10A to 10C, the second semiconductor layer of the first display region may at least include: active layers of second type transistors of a plurality of first pixel circuits (e.g., including: the second active layer 320a of the second transistor 32a of the first pixel circuit 11a, and the second active layer 320b of the second transistor 32b of the first pixel circuit 11b within the first sub-region).

In some examples, within the first sub-region, the patterns of the second semiconductor layers of four first pixel circuits may be substantially symmetrical with respect to the first centerline O1, the patterns of the second semiconductor layers of the first pixel circuits 11a and 11b may be substantially symmetrical with respect to the second centerline O2, and the patterns of the second semiconductor layers of the first pixel circuits 11c and 11d may be substantially symmetrical with respect to the third centerline O3.

In some examples, the second active layers 320a and 320b may be substantially in an L-shape. An overlapping region of the second scan auxiliary line GL2b(i) with the second active layer 320a may serve as a bottom gate of the second transistor 32a, and an overlapping region of the second scan auxiliary line GL2b(i) with the second active layer 320b may serve as a bottom gate of the second transistor 32b.

(5) A third conductive layer is formed. In some examples, a fourth insulating thin film and a third conductive thin film are sequentially deposited on the base substrate on which the aforementioned patterns are formed, and the third conductive thin film is patterned through a patterning process to form a fourth insulating layer and a third conductive layer disposed on the fourth insulating layer. In some examples, the third conductive layer may also be referred to as a third gate metal layer.

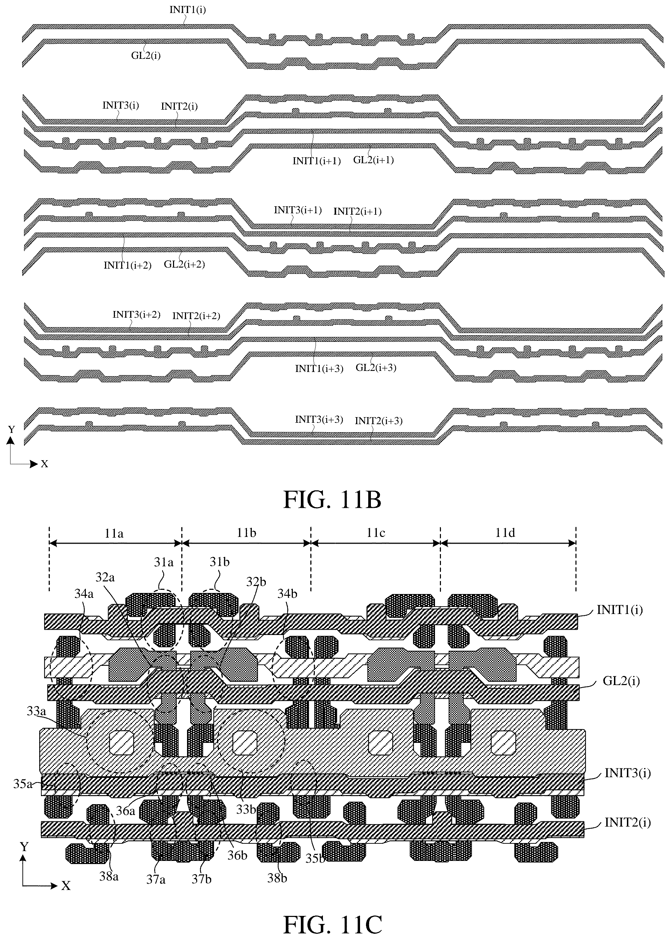

FIG. 11A is a schematic diagram of a first display region after a third conductive layer is formed in FIG. 6. FIG. 11B is a schematic diagram of the third conductive layer in FIG. 11A. FIG. 11C is a schematic view of one first sub-region in FIG.

11A.

In some examples, as shown in FIGS. 11A to 11C, the third conductive layer of the first display region may at least include: a plurality of second scan lines (e.g., second scan lines GL2(i), GL2(i+1), GL2(i+2), and GL2(i+3)), a plurality of first initial signal lines (e.g., first initial signal lines INIT1(i), INIT1(i+1), INIT1(i+2), and INIT1(i+3)), a plurality of second initial signal lines (e.g., second initial signal lines INIT2(i), INIT2(i+1), INIT2(i+2), and INIT2(i+3)), and a plurality of third initial signal lines (e.g., third initial signal lines INIT3(i), INIT3(i+1), INIT3(i+2), and INIT3(i+3)). Shapes of the first initial signal lines, the second scan lines, the second initial signal lines, and the third initial signal lines may each be substantially a polyline shape extending along the first direction X.

In some examples, in a first sub-region, the first initial signal line INIT1(i) and the second scan line GL2(i) may be located at a side of the storage capacitor in the second direction Y, and the second initial signal line INIT2(i) and the third initial signal line INIT3(i) may be located at a side of the storage capacitor in the opposite direction of the second direction Y. The first initial signal line INIT1(i) may be located at a side of the second scan line GL2(i) along the second direction Y. The second initial signal line INIT2(i) may be located at a side of the third initial signal line INIT3(i) in the opposite direction of the second direction Y.

In some examples, the first initial signal line INIT1(i), the second scan line GL2(i), the second initial signal line INIT2(i), and the third initial signal line INIT3(i) may bypass a second sub-region adjacent to the first sub-region in which they are located in the first direction X by bending. For example, the first initial signal line INIT1(i) and the second scan line GL2(i) may bypass from a side of the second sub-region along the second direction Y, and the second initial signal line INIT2(i) and the third initial signal line INIT3(i) may bypass from a side of the second sub-region along the opposite direction of the second direction Y. In this example, by setting traces of the third conductive layer to bend to bypass the second sub-region, it is beneficial to improve the light transmittance of the second sub-region.

In some examples, an orthographic projection of the first initial signal line INIT1(i) on the base substrate and an orthographic projection of the first reset control line RST1(i) on the base substrate may at least partially overlap, an orthographic projection of the second scan line GL2(i) on the base substrate and an orthographic projection of the second scan auxiliary line GL2b(i) on the base substrate may at least partially overlap, an orthographic projection of the third initial signal line INIT3(i) on the base substrate and an orthographic projection of the light emitting control line EML(i) on the base substrate may at least partially overlap, and an orthographic projection of the second initial signal line INIT2(i) on the base substrate and an orthographic projection of the second reset control line RST2(i) on the base substrate may at least partially overlap. In the example, traces of different conductive layers are stacked to avoid occupying too much trace space, which is beneficial to saving wiring space, thereby improving a light transmittance of the first display region.

(6) A fifth insulating layer is formed. In some examples, a fifth insulating thin film is deposited on the base substrate on which the aforementioned patterns are formed, and the fifth insulating thin film is patterned through a patterning process to form a fifth insulating layer.

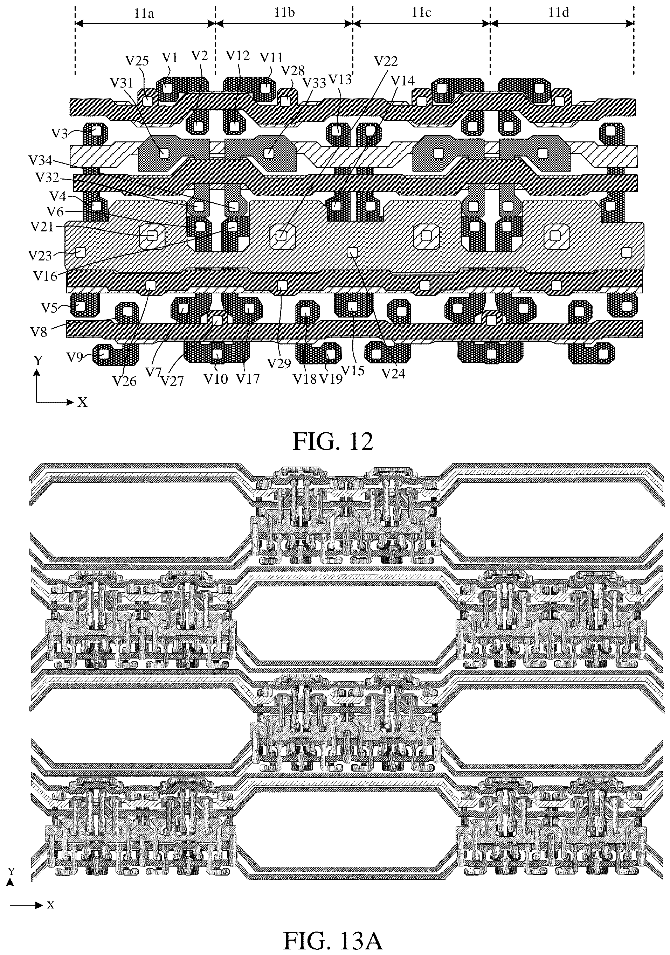

FIG. 12 is a schematic view of one first sub-region after a fifth insulating layer is formed in FIG. 6. In some examples, as shown in FIG. 12, the fifth insulating layer of the first display region may be provided with a plurality of vias, which, for example, may include a first via V1 to a nineteenth via V19, a twenty-first via V21 to a twenty-second via V22, a twenty-third via V23 to a twenty-fourth via V24, a twenty-fifth via V25 to a twenty-ninth via V29, and a thirty-first via V31 to a thirty-fourth via V34.

In some examples, the fifth insulating layer, the fourth insulating layer, the third insulating layer, the second insulating layer, and the first insulating layer within the first via V1 to the nineteenth via V19 may be removed, exposing part of a surface of the first semiconductor layer. The fifth insulating layer, the fourth insulating layer, the third insulating layer, and the second insulating layer within the twenty-first via V21 and the twenty-second via V22 may be removed, exposing part of a surface of the first conductive layer. The fifth insulating layer, the fourth insulating layer, and the third insulating layer within the twenty-third via V23 and the twenty-fourth via V24 may be removed, exposing part of a surface of the second conductive layer. The fifth insulating layer within the twenty-fifth via V25 to the twenty-ninth via V29 may be removed, exposing part of a surface of the third conductive layer. The fifth insulating layer and the fourth insulating layer within the thirty-first via V31 to the thirty-fourth via V34 may be removed, exposing a surface of the second semiconductor layer.

(7) A fourth conductive layer is formed. In some examples, a fourth conductive thin film is deposited on the base substrate on which the aforementioned patterns are formed, and the fourth insulating thin film is patterned through a patterning process to form a fourth conductive layer on the fifth insulating layer. In some examples, the fourth conductive layer may also be referred to as a first source-drain metal layer.

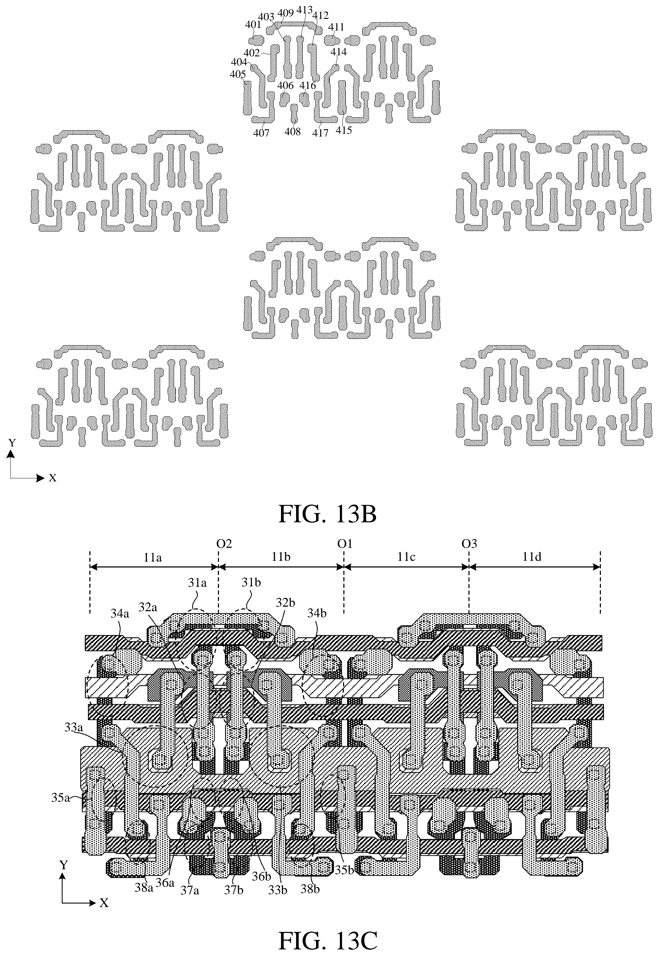

FIG. 13A is a schematic diagram of a first display region after a fourth conductive layer is formed in FIG. 6. FIG. 13B is a schematic diagram of a fourth conductive layer in FIG. 13A. FIG. 13C is a schematic diagram of one first sub-region in FIG. 13A.

In some examples, as shown in FIGS. 13A to 13C, the fourth conductive layer of the first display region may at least include: a plurality of connection electrodes (for example, including a first connection electrode 401 to a ninth connection electrode 409, and an eleventh connection electrode 411 to a seventeenth connection electrode 417).

In some examples, a shape of the first connection electrode 401 may be substantially a rectangle. The first connection electrode 401 may be electrically connected to the fourth active layer of the fourth transistor 34a of the first pixel circuit 11a through the third via V3.

In some examples, a shape of the second connection electrode 402 may be substantially a shape of a strip extending in the second direction Y. One end of the second connection electrode 402 may be electrically connected to the second active layer of the second transistor 32a of the first pixel circuit 11a through the thirty-first via V31, and the other end thereof may be electrically connected to the first electrode 391a of the storage capacitor through the twenty-first via V21. The second connection electrode 402 is electrically connected to the gate of the third transistor 33a, the first electrode 391a of the storage capacitor, and the first electrode of the second transistor 32a, and the second connection electrode 402 may serve as a first node of the first pixel circuit 11a.

In some examples, a shape of the third connection electrode 403 may be substantially a shape of a strip extending in the second direction Y. One end of the third connection electrode 403 may be electrically connected to the first active layer of the first transistor 31a of the first pixel circuit 11a through the second via V2, the other end thereof may be electrically connected to the second active layer of the second transistor 32a through the thirty-second via V32, and may also be electrically connected to the third active layer of the third transistor 33a through the sixth via V6.

In some examples, a shape of the fourth connection electrode 404 may be substantially a polyline shape extending along the second direction Y. The fourth connection electrode 404 may be electrically connected to the fourth active layer of the fourth transistor 34a of the first pixel circuit 11a through the fourth via V4, and may also be electrically connected to the eighth active layer of the eighth transistor 38a through the eighth via V8.

In some examples, a shape of the fifth connection electrode 405 may be substantially a shape of a strip extending in the second direction Y. The fifth connection electrode 405 may be electrically connected to the fifth active layer of the fifth transistor 35a of the first pixel circuit 11a through the fifth via V5, and may be electrically connected to the second plate connection block 392-2 through the twenty-third via V23, thereby realizing electrical connection with the second electrode 392a of the storage capacitor.

In some examples, a shape of the sixth connection electrode 406 may be substantially a rectangle. The sixth connection electrode 406 may be electrically connected to the sixth active layer of the sixth transistor 36a of the first pixel circuit 11a through the seventh via V7.

In some examples, the seventh connection electrode 407 may be substantially L-shaped. The seventh connection electrode 407 may be electrically connected to the eighth active layer of the eighth transistor 38a of the first pixel circuit 11a through the ninth via V9, and may also be electrically connected to the third initial signal line INIT3(i) through the twenty-sixth via V26.

In some examples, a shape of the eighth connection electrode 408 may be substantially a shape of a strip extending in the second direction Y. The eighth connection electrode 408 may be electrically connected to the seventh active layer of the seventh transistor 37a of the first pixel circuit 11a through the tenth via V10, and may also be electrically connected to the second initial signal line INIT2(i) through the twenty-seventh via V27.

In some examples, a shape of the ninth connection electrode 409 may be substantially a shape of an arch extending in the second direction Y. One end of the ninth connection electrode 409 may be electrically connected to the first active layer of the first transistor 31a of the first pixel circuit 11a through the first via V1, and may also be electrically connected to the first initial signal line INIT1(i) through the twenty-fifth via V25, and the other end thereof may be electrically connected to the first active layer of the first transistor 31b of the first pixel circuit 11b through the eleventh via V11, and may also be electrically connected to the first initial signal line INIT1(i) through the twenty-eighth via V28.

In some examples, the eleventh connection electrode 411 may be substantially in a shape of a rectangle. The eleventh connection electrode 411 may be electrically connected to the fourth active layer of the fourth transistor 34b of the first pixel circuit 11b through the thirteenth via V13.

In some examples, a shape of the twelfth connection electrode 412 may be substantially a strip extending in the second direction Y. One end of the twelfth connection electrode 412 may be electrically connected to the second active layer of the second transistor 32b of the first pixel circuit 11b through the thirty-third via V31, and the other end thereof may be electrically connected to the first electrode 391b of the storage capacitor through the twenty-second via V22. The twelfth connection electrode 412 is electrically connected to the gate of the third transistor 33b, the first electrode 391b of the storage capacitor, and the first electrode of the second transistor 32b. The twelfth connection electrode 412 may serve as a first node of the first pixel circuit 11b.

In some examples, a shape of the thirteenth connection electrode 413 may be substantially a shape of a strip extending in the second direction Y. One end of the thirteenth connection electrode 413 may be electrically connected to the first active layer of the first transistor 31b of the first pixel circuit 11b through the twelfth via V12, the other end thereof may be electrically connected to the second active layer of the second transistor 32b through the thirty-fourth via V34, and may also be electrically connected to the third active layer of the third transistor 33b through the sixteenth via V16.

In some examples, a shape of the fourteenth connection electrode 414 may be substantially a shape of a polyline extending in the second direction Y. The fourteenth connection electrode 414 may be electrically connected to the fourth active layer of the fourth transistor 34b of the first pixel circuit 11b through the fourteenth via V14, and may also be electrically connected to the eighth active layer of the eighth transistor 38b through the eighteenth via V18.

In some examples, a shape of the fifteenth connection electrode 415 may be substantially a shape of a strip extending in the second direction Y. The fifteenth connection electrode 415 may be electrically connected to the fifth active layer of the fifth transistor 35b of the first pixel circuit 11b through the fifteenth via V15, and may also be electrically connected to another second plate connection block 392-2 through the twenty-fourth via V24, thereby realizing electrical connection with the second electrode 392b of the storage capacitor.

In some examples, a shape of the sixteenth connection electrode 416 may be substantially a rectangle. The sixteenth connection electrode 416 may be electrically connected to the sixth active layer of the sixth transistor 36b of the first pixel circuit 11b through the seventeenth via V17.

In some examples, the seventeenth connection electrode 417 may be generally L-shaped. The seventeenth connection electrode 417 may be electrically connected to the eighth active layer of the eighth transistor 38b of the first pixel circuit 11b through the nineteenth via V19, and may also be electrically connected to the third initial signal line INIT3(i) through the twenty-ninth via V29.

In some examples, within a first sub-region, the first pixel circuits 11a and 11b may be substantially symmetrical with respect to the second centerline O2, the first pixel circuits 11c and 11d may be substantially symmetrical with respect to the third centerline O3, and the first pixel circuits 11a and 11b, and the first pixel circuits 11c and 11d may be substantially symmetrical with respect to the first centerline O1.

In some examples, the first pixel circuits within a plurality of first sub-regions arranged in the first direction X may be arranged in alignment in the first direction X, and the first pixel circuits within a plurality of first sub-regions arranged in the second direction Y may be arranged in alignment in the second direction Y. For example, four columns of first pixel circuits may be arranged in one column of first sub-regions.

(8) A sixth insulating layer and a seventh insulating layer are formed. In some examples, a sixth insulating thin film is deposited on the base substrate on which the aforementioned patterns are formed, and then a seventh insulating thin film is coated, and the seventh insulating thin film and the sixth insulating thin film are patterned through a patterning process to form a sixth insulating layer and a seventh insulating layer. In some examples, the sixth insulating layer may also be referred to as a passivation layer and the seventh insulating layer may also be referred to as a first planarization layer.

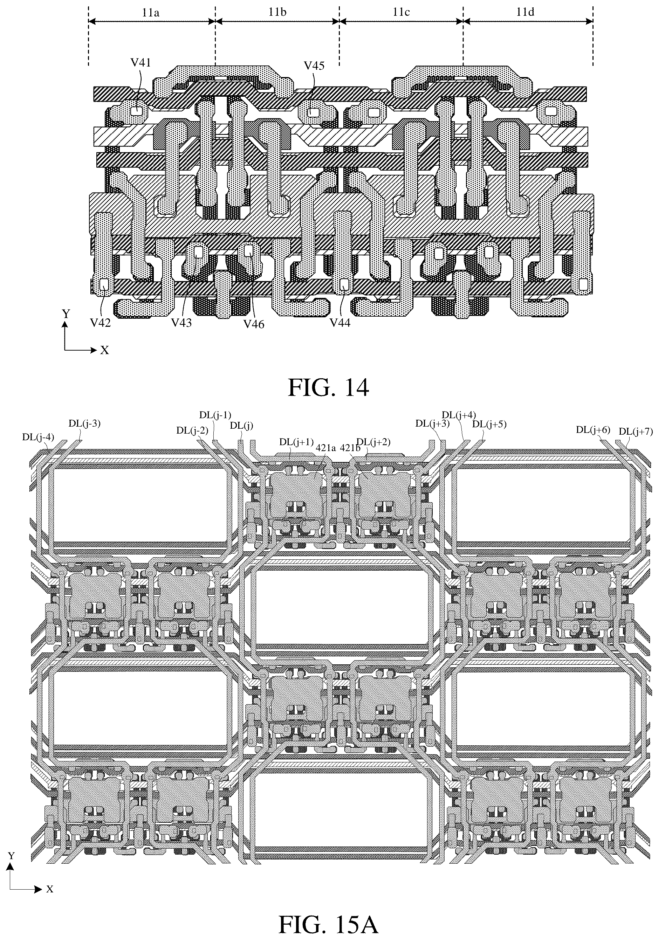

FIG. 14 is a schematic view of one first sub-region after a seventh insulating layer is formed in FIG. 6. In some examples, as shown in FIG. 14, the seventh insulating layer of the first display region may be provided with a plurality of vias, which, for example, may include a forty-first via V41 to a forty-sixth via V46. The seventh insulating layer and the sixth insulating layer within the forty-first via V41 to the forty-sixth via V46 may be removed, exposing part of a surface of the fourth conductive layer.

(9) A fifth conductive layer is formed. In some examples, a fifth conductive thin film is deposited on the base substrate on which the aforementioned patterns are formed, and the fifth conductive thin film is patterned through a patterning process to form a fifth conductive layer on the seventh insulating layer. In some examples, the fifth conductive layer may also be referred to as a second source-drain metal layer.

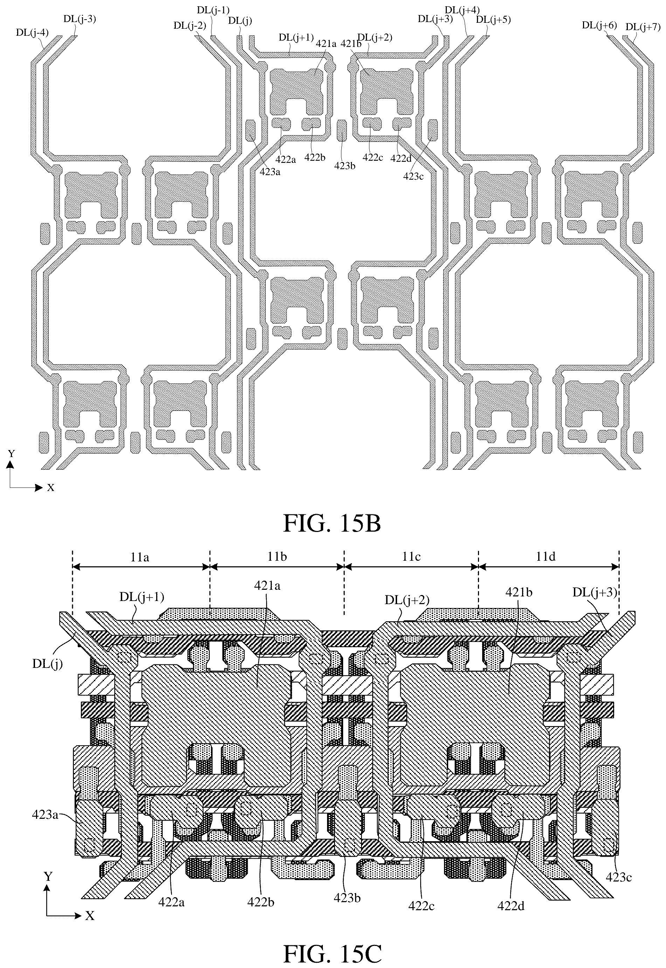

FIG. 15A is a schematic diagram of a first display region after a fifth conductive layer is formed in FIG. 6. FIG. 15B is a schematic diagram of the fifth conductive layer in FIG. 15A. FIG. 15C is a schematic diagram of one first sub-region in FIG. 15A.

In some examples, as shown in FIGS. 15A-15C, the fifth conductive layer of the first display region may include at least: a plurality of data lines (e.g., data lines DL(j-4), DL(j-3), DL(j-2), DL(j-1), DL(j), DL(j+1), DL(j+2), DL(j+3), DL(j+4), DL(j+5), DL(j+6), DL(j+7)), a plurality of first anode connection electrodes (e.g., first anode connection electrodes 422a, 422b, 422c, and 422d), a plurality of first power supply connection electrodes (e.g., first power supply connection electrodes 423a, 423b, and 423c), and a plurality of first shielding electrodes (e.g., first shielding electrodes 421a and 421b).

In some examples, the plurality of data lines may be substantially in a shape of a polyline extending in the second direction Y. Four first sub-pixels in each first sub-region are electrically connected to four data lines in one-to-one correspondence. The data line DL(j) may be electrically connected to the first connection electrode 401 through the forty-first via V41, thereby being electrically connected to the fourth transistor of the first pixel circuit 11a. The data line DL(j+1) may be electrically connected to the eleventh connection electrode 411 through the forty-fifth via V45, thereby being electrically connected to the fourth transistor of the first pixel circuit 11b. The data line DL(j+2) may be electrically connected to the fourth transistor of the first pixel circuit 11c. The data line DL(j+3) may be electrically connected to the fourth transistor of the first pixel circuit 11d.

In some examples, four data lines electrically connected to four first pixel circuits within a first sub-region may be divided into two groups bypassing a second sub-region adjacent to the first sub-region in the second direction Y. For example, the data line DL(j) to which the first pixel circuit 11a is connected and the data line DL(j+1) to which the first pixel circuit 11b is connected may bypass an adjacent second sub-region in the second direction Y from a side in the opposite direction of the first direction X, and the data line DL(j+2) to which the first pixel circuit 11c is connected and the data line DL(j+2) to which the first pixel circuit 11d is connected may bypass an adjacent second sub-region in the second direction Y from a side in the first direction X. In this example, the data line is bent to bypass the second sub-region, which is conducive to reducing the space occupied by the wiring, thereby improving the light transmittance of the first display region.

In some examples, the first anode connection electrodes 422a, 422b, 422c, and 422d may be substantially in a shape of a rectangle. The first anode connection electrodes 422a and 422b may be located between the data lines DL(j) and DL(j+1), and the first anode connection electrodes 422c and 422d may be located between the data lines DL(j+2) and DL(j+3).

In some examples, the first anode connection electrode 422a may be electrically connected to the sixth connection electrode 406 through the forty-third via V43, thereby realizing electrical connection to the sixth transistor of the first pixel circuit 11a. The first anode connection electrode 422b may be electrically connected to the sixteenth connection electrode 416 through the forty-sixth via V46, thereby realizing electrical connection to the sixth transistor of the first pixel circuit 11b. The first anode connection electrode 422c may be electrically connected to the sixth transistor of the first pixel circuit 11c. The first anode connection electrode 422d may be electrically connected to the sixth transistor of the first pixel circuit 11d.

In some examples, the first power supply connection electrodes 423a, 423b, and 423c may be substantially in a shape of a rectangle. The first power supply connection electrode 423a may be located at a side of the data line DL(j) in the opposite direction of the first direction X, the first power supply connection electrode 423b may be located between the data lines DL(j+1) and DL(j+2), and the first power supply connection electrode 423c may be located at a side of the data line DL(j+3) in the first direction X.

In some examples, the first power supply connection electrode 423a may be electrically connected to the fifth connection electrode 405 through the forty-second via V42, thereby realizing electrical connection to the fifth transistor and the storage capacitor of the first pixel circuit 11a. The second power supply connection electrode 423b may be electrically connected to the fifteenth connection electrode 415 through the forty-fourth via V44, thereby realizing electrical connection to the fifth transistors and the storage capacitors of the first pixel circuits 11b and 11c. The third power supply connection electrode 423c may be electrically connected to the fifth transistor and the storage capacitor of the first pixel circuit 11d.

In some examples, the first shielding electrodes 421a and 421b may be substantially n-shaped. The first shielding electrode 421a may be located between the data lines DL(j) and DL(j+1), and the first shielding electrode 421b may be located between the data lines DL(j+2) and DL(j+3). An orthographic projection of the first shielding electrode 421a on the base substrate may cover orthographic projections of the second connection electrode 402 and the twelfth connection electrode 412 on the base substrate, which may achieve shielding of the first node of the first pixel circuit 11a and the first node of the first pixel circuit 11b, thereby shielding an influence of other signals on the first nodes of the first pixel circuits 11a and 11b. The second shielding electrode 421b may achieve shielding of the first node of the first pixel circuit 11c and the first node of the first pixel circuit 11d, thereby shielding an influence of other signals on the first nodes of the first pixel circuits 11c and 11d.

(10) An eighth insulating layer is formed. In some examples, an eighth insulating thin film is coated on the base substrate on which the aforementioned patterns are formed, and the eighth insulating thin film is patterned through a patterning process to form an eighth insulating layer. In some examples, the eighth insulating layer may also be referred to as a second planarization layer.

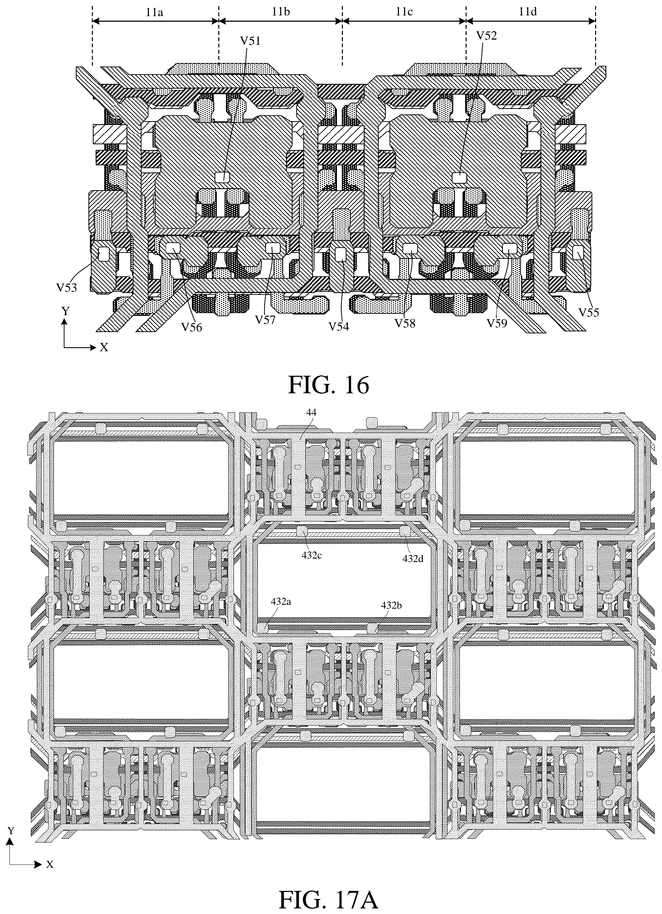

FIG. 16 is a schematic view of one first sub-region after an eighth insulating layer in FIG. 6 is formed. In some examples, as shown in FIG. 16, the eighth insulating layer of the first display region may be provided with a plurality of vias, which, for example, may include a fifty-first via V51 to a fifty-ninth via V59. The eighth insulating layer within the fifty-first via V51 to the fifty-ninth via V59 may be removed, exposing part of a surface of the fifth conductive layer.

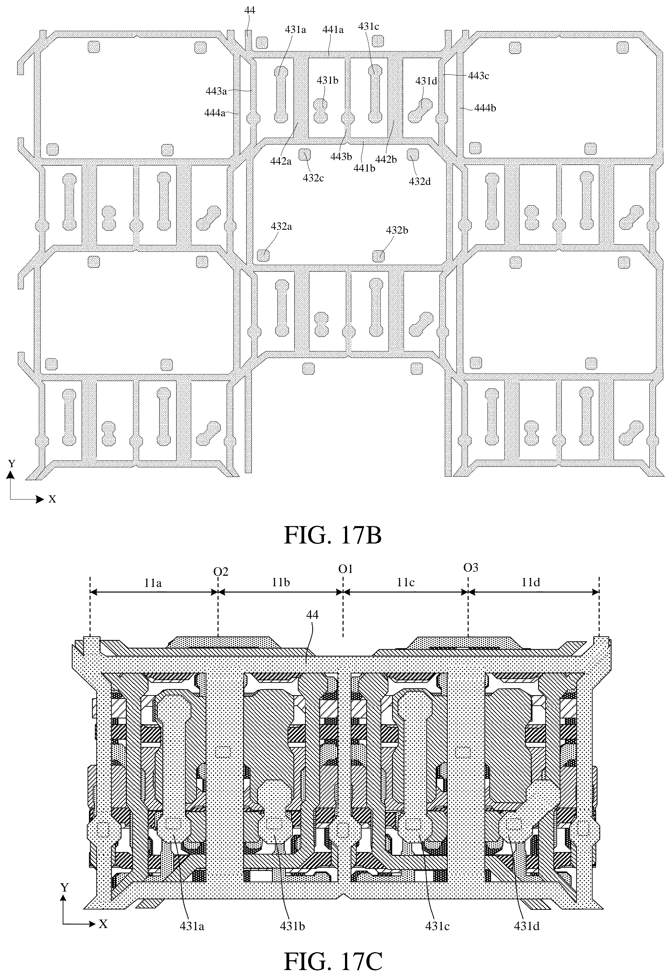

(11) A sixth conductive layer is formed. In some examples, a sixth conductive thin film is deposited on the base substrate on which the aforementioned patterns are formed, and the sixth conductive thin film is patterned through a patterning process to form a sixth conductive layer on the eighth insulating layer. In some examples, the sixth conductive layer may also be referred to as a third source-drain metal layer. FIG. 17A is a schematic diagram of a first display region after a sixth conductive layer is formed in FIG. 6. FIG. 17B is a schematic diagram of the sixth conductive layer in FIG. 17A. FIG. 17C is a schematic diagram of one first sub-region in FIG. 17A.

In some examples, as shown in FIGS. 17A to 17C, the sixth conductive layer of the first display region may include at least a plurality of second anode connection electrodes (e.g., second anode connection electrodes 431a, 431b, 431c, and 431d), a plurality of third anode connection electrodes (e.g., third anode connection electrodes 432a, 432b, 432c, and 432d), and a first power supply line 44.

In some examples, the first power supply line 44 of the first display region may be in a mesh structure. The first power supply line 44 of the first sub-region may be substantially symmetrical with respect to the first centerline O1. The first power supply line 44 of the first sub-region may include first extension segments 441a and 441b, second extension segments 442a and 442b, third extension segments 443a, 443b and 443c, and fourth extension segments 444a and 444b. The first extension segments 441a and 441b, the second extension segments 442a and 442b, the third extension segments 443a, 443b and 443c, and the fourth extension segments 444a and 444b may be of an interconnected integral structure. A second sub-region may be surrounded by first extended segments 441a and 441b within a first sub-region adjacent in the second direction Y, fourth extended segments 444a and 44b within a first sub-region adjacent in the first direction X. The first extension segments, the third extension segments, and the fourth extension segments of the first power supply line 44 of different first sub-regions may be electrically connected correspondingly to form a grid-like design throughout the first display.

In some examples, the first extension segments 441a and 441b may have a strip shape extending substantially along the first direction X. The first extension segment 441a may be located on a side of the first shielding electrodes 421a and 421b in the opposite direction of the second direction Y, and the first extension segment 441b may be located on a side of the first shielding electrodes 421a and 421b in the second direction Y.

In some examples, the second extension segments 442a and 442b may have a strip shape extending substantially along the second direction Y. The second extension segment 442a may be electrically connected to the first shielding electrode 421a through the fifty-first via V51, and the second extension segment 442b may be electrically connected to the first shielding electrode 421b through the fifty-second via V52. Two ends of the second extension segment 442a are electrically connected to the first extension segments 441a and 441b, respectively, and two ends of the second extension segment 442b may be electrically connected to the first extension segments 441a and 441b, respectively.

In some examples, the third extension segments 443a, 443b, and 443c may be substantially in a shape of a strip extending in the second direction Y. The third extension segment 443a may be electrically connected to the first power supply connection electrode 423a through the fifty-third via V53, the third extension segment 443b may be electrically connected to the first power supply connection electrode 423b through the fifty-fourth via V54, and the third extension segment 443c may be electrically connected to the first power supply connection electrode 423c through the fifty-fifth via V55. Two ends of the third extension segment 443a may be electrically connected to the first extension segments 441a and 441b, respectively, two ends of the third extension segment 443b may be electrically connected to the first extension segments 441a and 441b, respectively, and two ends of the third extension segment 443c may be electrically connected to the first extension segments 441a and 441b, respectively. Three third extension segments and two second extension segments may be arranged at intervals along the first direction X.

In some examples, the fourth extension segments 444a and 444b may be substantially in a shape of a strip extending in the second direction Y. Two ends of the fourth extension segment 444a may be electrically connected to the first extension segments 441a and 441b, respectively, and two ends of the fourth extension segment 444b may be electrically connected to the first extension segments 441a and 441b, respectively. The fourth extension segment 444a is located at a side of the third extension segment 443a in the opposite direction of the first direction X, and the fourth extension segment 444b is located at a side of the third extension segment 443c in the first direction X.

In some examples, in a first sub-region, two first extension segments 441a and 441b, two second extension segments 442a and 442b, and three third extension segments 443a, 443b, and 443c of the first power supply line 44 may be connected to form and surround four containment regions. The four accommodation regions correspond to four first pixel circuits one-to-one, and a second anode connection electrode may be provided in each accommodation region.

The mesh design of the first power supply line in the first sub-region of the present example can ensure the symmetrical design of the circuit structure layer, thereby avoiding display differences at different viewing angles (for example, left and right viewing angle differences) caused by the circuit structure layer.

In some examples, the second anode connection electrode 431a may be located in a containment region between the third extension segment 443a and the second extension segment 442a. A shape of the second anode connection electrode 431a may be substantially a dumbbell shape extending in the second direction Y. The second anode connection electrode 431a may be electrically connected to the first anode connection electrode 422a through the fifty-sixth via V56 to achieve an electrical connection with the sixth transistor of the first pixel circuit 11a.

In some examples, the second anode connection electrode 431b may be located in a containment region between the third extension segment 443b and the second extension segment 442a. A shape of the second anode connection electrode 432b may be substantially a dumbbell shape extending in the second direction Y. The second anode connection electrode 431b may be electrically connected to the first anode connection electrode 422b through the fifty-seventh via V57, thereby realizing electrical connection to the sixth transistor of the first pixel circuit 11b.

In some examples, the second anode connection electrode 431c may be located in a containment region between the third extension segment 443b and the second extension segment 442b. A shape of the second anode connection electrode 432c may be substantially a dumbbell shape extending in the second direction Y. The second anode connection electrode 431c may be electrically connected to the first anode connection electrode 422c through the fifty-eighth via V58, thereby realizing electrical connection to the sixth transistor of the first pixel circuit 11c.

In some examples, the second anode connection electrode 431d may be located in a containment region between the third extension segment 443c and the second extension segment 442b. A shape of the second anode connection electrode 432d may be substantially a dumbbell shape extending in a direction intersecting both the first direction and the second direction. The second anode connection electrode 432d may be electrically connected to the first anode connection electrode 422d through the fifty-ninth via V59, thereby realizing electrical connection with the sixth transistor of the first pixel circuit 11d.

In some examples, the third anode connection electrodes 432a, 432b, 432c, and 432d are substantially in a shape of a rectangle, and the rectangle has chamfered and rounded corners. The third anode connection electrodes 432a, 432b, 432c, and 432d may be located in a region formed and surrounded by first extension segments 441a and 441b adjacent in the second direction Y and fourth extension segments 444a and 44b adjacent in the first direction X. The third anode connection electrodes 432a and 432b are aligned in the first direction X and adjacent to the first extension 441a in one first sub-region in the second direction Y. The third anode connection electrodes 423c and 423d may be aligned in the first direction X and adjacent to the first extension 441b in another first sub-region in the second direction Y.

(12) A ninth insulating layer is formed. In some examples, an ninth insulating thin film is coated on the base substrate on which the aforementioned patterns are formed, and the ninth insulating thin film is patterned through a patterning process to form a ninth insulating layer. In some examples, the ninth insulating layer may also be referred to as a third planarization layer.

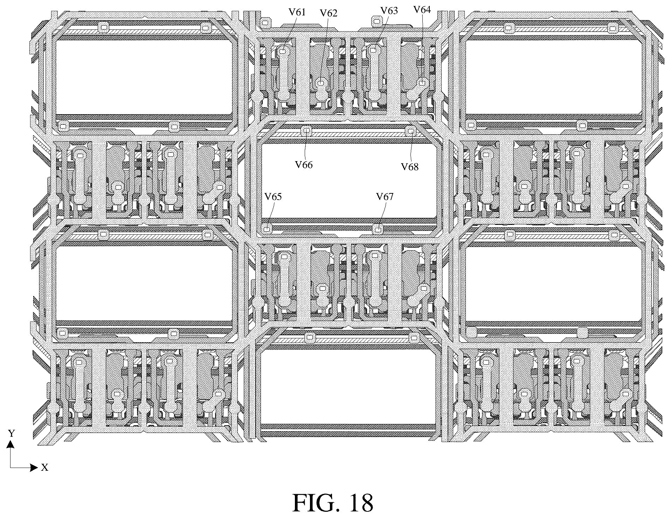

FIG. 18 is a schematic diagram of the first display region after a ninth insulating layer is formed in FIG. 6. In some examples, as shown in FIG. 18, the ninth insulating layer of the first display region may be provided with a plurality of vias, which may include, for example, a sixty-first via V61 to a sixty-eighth via V68. The ninth insulating layer within the sixty-first via V61 to the sixty-eighth via V68 may be removed, exposing part of a surface of the sixth conductive layer.

At this point, manufacturing of a circuit structure layer may be completed. A film layer structure of a circuit structure layer of the second display region is similar to a film layer structure of the first display region, and therefore, it will not be repeated herein.

(13) A conductive connection layer is formed. In some examples, a transparent conductive thin film is deposited on the base substrate on which the aforementioned patterns are formed, and the transparent conductive thin film is patterned by a patterning process to form a conductive connection layer. In this example, description is given below by taking one conductive connection layer as an example. However, the present embodiment is not limited thereto. In other examples, a plurality of conductive connection layers may be provided, and a planarization layer may be provided between adjacent conductive connection layers.

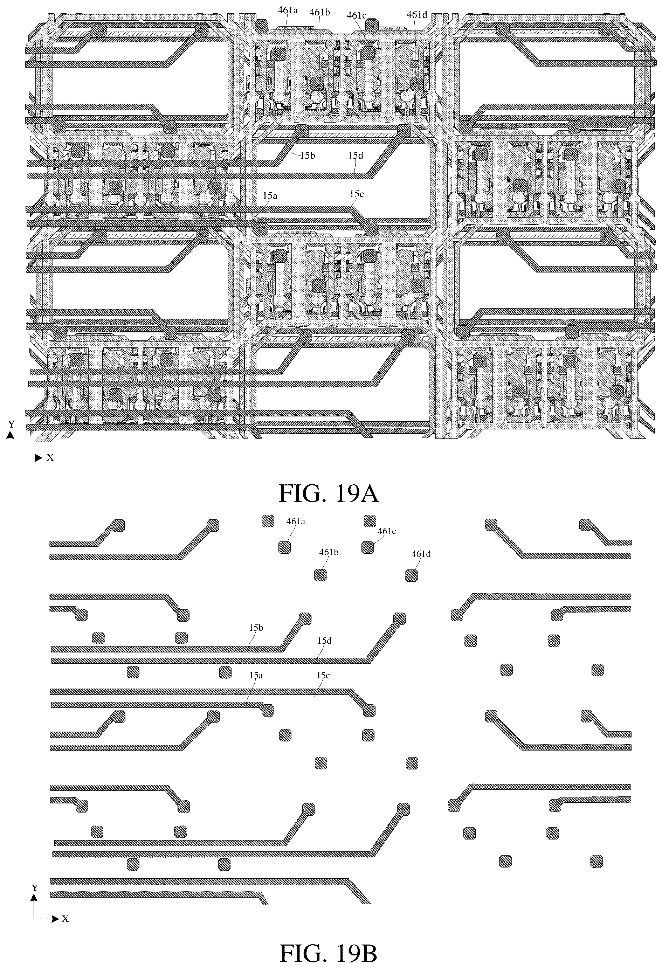

FIG. 19A is a schematic diagram of the first display region after a conductive connection layer in FIG. 6 is formed. FIG. 19B is a schematic diagram of the conductive connection layer of FIG. 19A.

In some examples, as shown in FIGS. 19A and 19B, the conductive connection layer of the first display region may include a plurality of conductive connection lines (e.g., conductive connection lines 15a, 15b, 15c, and 15d), a plurality of fourth anode connection electrodes (e.g., fourth anode connection electrodes 461a, 461b, 461c, and 461d).

In some examples, the fourth anode connection electrodes 461a, 461b, 461c, and 461d may be substantially in a shape of a rectangle, and the rectangle may have rounded corners or chamfers. The fourth anode connection electrode 461a may be electrically connected to the second anode connection electrode 431a through the sixty-first via V61. The fourth anode connection electrode 461b may be electrically connected to the second anode connection electrode 431b through the sixty-second via V62. The fourth anode connection electrode 461c may be electrically connected to the second anode connection electrode 431c through the sixty-third via V63. The fourth anode connection electrode 461d may be electrically connected to the second anode connection click 431d through the sixty-fourth via V64.

In some examples, the plurality of conductive connection lines may extend at least along the first direction X, may extend from the first display region to the second display region, and be electrically connected to the second pixel circuit of the second display region. The conductive connection line 15a may be electrically connected to the third anode connection electrode 432a through the sixty-fifth via V65, the conductive connection line 15b may be electrically connected to the third anode connection electrode 432c through the sixty-sixth via V66, the conductive connection line 15c may be electrically connected to the third anode connection electrode 432b through the sixty-seventh via V67, and the conductive connection line 15d may be electrically connected to the third anode connection electrode 432d through the sixty-eighth via V68. An orthographic projection of a conductive connection line on the base substrate may be overlapped with an orthographic projection of at least one first pixel circuit on the base substrate. For example, orthographic projections of the conductive connection lines 15a, 15b, 15c, and 15d on the base substrate may all be overlapped with orthographic projections of the four first pixel circuits to which the four first light emitting elements of the first light emitting unit in the a-th column and the (b+1)-th row are connected on the base substrate.

In some examples, the conductive connection layer may be made of a transparent conductive material, such as ITO. Although the conductive connection line passes through a second sub-region, it is possible to avoid affecting the light transmittance of the second sub-region.

(14) A light emitting structure layer is formed. In some examples, a tenth insulating thin film is coated on the base substrate on which the aforementioned patterns are formed, and the tenth insulating thin film is patterned through a patterning process to form a tenth insulating layer. The tenth insulating layer may be provided with a plurality of vias, and the plurality of vias may expose a portion of a surface of the conductive connection layer. Subsequently, an anode thin film is deposited on the base substrate on which the aforementioned patterns are formed, and the anode thin film is patterned through a patterning process to form an anode layer.

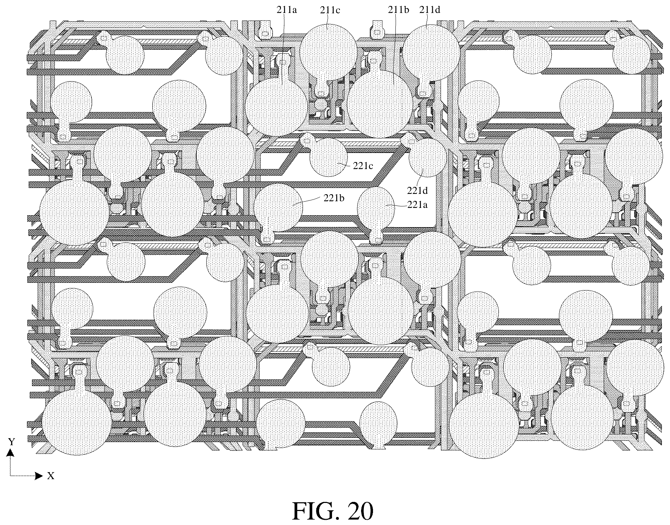

FIG. 20 is a schematic diagram of the first display region after an anode layer is formed in FIG. 6. In some examples, as shown in FIG. 20, the first display region may include: anodes of a plurality of first light emitting elements (for example, an anode 211a of the first light emitting element 21a, an anode 211b of the first light emitting element 21b, an anode 211c of the first light emitting element 21c, and an anode 211d of the first light emitting element 21d), and anodes of a plurality of second light emitting elements (for example, an anode 221a of the second light emitting element 22a, an anode 221b of the second light emitting element 22b, an anode 221c of the second light emitting element 22c, and an anode 221d of the second light emitting element 22d).

In some examples, the anode 211a of the first light emitting element 21a that emits light of the first color may be electrically connected to the fourth anode connection electrode 461a through a via opened in the tenth insulating layer. The anode 211b of the first light emitting element 21b that emits light of the second color may be electrically connected to the fourth anode connection electrode 461c through a via opened in the tenth insulating layer. The anode 211c of the first light emitting element 21c that emits light of the third color may be electrically connected to the fourth anode connection electrode 461b through a via opened in the tenth insulating layer. The anode 211d of the first light emitting element 21d that emits light of the third color may be electrically connected to the fourth anode connection electrode 461d through a via opened in the tenth insulating layer.

In some examples, the anode 221a of the second light emitting element 22a that emits light of the first color may be electrically connected to the conductive connection line 15c through a via opened in the tenth insulating layer. The anode 221b of the second light emitting element 22b that emits light of the second color may be electrically connected to the conductive connection line 15a through a via opened in the tenth insulating layer. The anode 221c of the second light emitting element 22c that emits light of the third color may be electrically connected to the conductive connection line 15b through a via opened in the tenth insulating layer. The anode 221d of the second light emitting element 22d that emits light of the third color may be electrically connected to the conductive connection line 15d through a via opened in the tenth insulating layer.

In some examples, a pixel definition thin film is coated on the base substrate on which the aforementioned patterns are formed, and a pixel definition layer is formed through masking, exposure, and development processes. The pixel definition layer may be formed with a plurality of pixel openings exposing the anode layer. An organic light emitting layer is formed in the pixel openings formed earlier, and the organic light emitting layer is connected with the anode layer. Subsequently, a cathode thin film is deposited, and the cathode thin film is patterned through a patterning process to form a pattern of a cathode, and the cathode is connected with the organic emitting layer.

In some examples, as shown in FIG. 6, the pixel definition layer of the first display region may form a plurality of first pixel openings (e.g., first pixel openings 210a, 210b, 210c, and 210d) and a plurality of second pixel openings (e.g., second pixel circuits 220a, 220b, 220c, and 220d). The plurality of first pixel openings and the plurality of second pixel openings may be substantially circular.

In some examples, the first pixel opening 210a may expose a portion of a surface of the anode 211a, the first pixel opening 210b may expose a portion of a surface of the anode 211b, the first pixel opening 210c may expose a portion of a surface of the anode 211c, and the first pixel opening 210d may expose a portion of a surface of the anode 211d. The second pixel opening 220a may expose a part of a surface of the anode 221a, the second pixel opening 220b may expose a part of a surface of the anode 221b, the second pixel opening 220c may expose a part of a surface of the anode 221c, and the second pixel opening 220d may expose a part of a surface of the anode 221d.

In some examples, the light emitting area of the first light emitting element 21b that emits light of the second color may be larger than the light emitting area of the first light emitting element 21a that emits light of the first color. The light emitting area of the first light emitting element 21a that emits light of the first color may be larger than the light emitting area of the first light emitting element 21c or 21d that emits light of the third color. The light emitting areas of the first light emitting elements 21c and 21d that emit light of the third color may be the same. The light emitting area of the light emitting element of the present example may refer to the area of the stacked region of the anode exposed by the pixel opening of the pixel definition layer with the organic light emitting layer and the cathode.

In some examples, the light emitting area of the second light emitting element 22b that emits light of the second color may be larger than the light emitting area of the second light emitting element 22a that emits light of the first color. The light emitting area of the second light emitting element 22a that emits light of the first color may be larger than the light emitting area of the second light emitting element 22c or 22d that emits light of the third color. The light emitting areas of the second light emitting elements 22c and 22d that emit light of the third color may be the same.

In some examples, a light emitting area of a first light emitting element may be greater than a light emitting area of a second light emitting element emitting light of a same color. For example, the ratio of the light emitting areas of the second light emitting element and the first light emitting element emitting light of a same color may be 0.4 to 0.8, such as about 0.5. For example, the light emitting area of the second light emitting element 22a that emits light of the first color may be approximately half of the light emitting area of the first light emitting element 21a that emits light of the first color. The light emitting area of the second light emitting element 22b that emits light of the second color may be about half of the light emitting area of the first light emitting element 21b that emits light of the second color. The light emitting area of the second light emitting element 22c (or 22d) that emits light of the third color may be about half of the light emitting area of the first light emitting element 21c (or 21d) that emits light of the third color.

By reducing the light emitting area of the second light emitting element, the present example can reduce the situation in which the brightness of the second light emitting element is dark due to a low current density caused by a large load of the conductive connection line, which is conducive to enhancing the brightness of the second light emitting element.

In some examples, the pixel definition layer of the first sub-region may be made of a black material to shield the first pixel circuits and traces of the first sub-region, and the pixel definition layer of the second sub-region may be made of a transparent material to improve the light transmittance of the second sub-region. The present embodiment is not limited thereto.

In some examples, after the light emitting structure layer is prepared, an encapsulation layer may be formed on the cathode, and the encapsulation layer may include a stacked structure of an inorganic material/an organic material/an inorganic material.

In some examples, the first conductive layer, the second conductive layer, the third conductive layer, the fourth conductive layer, the fifth conductive layer, and the sixth conductive layer may be made of a metal material, such as any one or more of Argentum (Ag), Copper (Cu), Aluminum (Al), and Molybdenum (Mo), or an alloy material of the above metals, such as an Aluminum Neodymium alloy (AlNd) or a Molybdenum Niobium alloy (MoNb), and may be of a single-layer structure or a multi-layer composite structure, such as Mo/Cu/Mo. The first insulating layer, the second insulating layer, the third insulating layer, the fourth insulating layer, the fifth insulating layer, and the sixth insulating layer may be made of any one or more of Silicon Oxide (SiOx, x>0), Silicon Nitride (SiNy, y>0), and Silicon OxyNitride (SiON), and may be a single layer, a multi-layer, or a composite layer. The seventh insulating layer, the eighth insulating layer, and the ninth insulating layer may be made of an organic material, such as polyimide, acrylic, or polyethylene terephthalate. The pixel definition layer may be made of an organic material, such as polyimide, acrylic, or polyethylene terephthalate. The anode layer may be made of a reflective material such as a metal, and the cathode may be made of a transparent conductive material. However, the present embodiment is not limited thereto.

A structure and a preparation process of the display substrate of the embodiment are merely illustrative. In some exemplary implementations, a corresponding structure may be changed and a patterning process may be added or removed according to actual needs. The manufacturing process in the exemplary embodiment may be implemented using an existing mature manufacturing device, and may be compatible well with an existing manufacturing process, simple in process implementation, easy to implement, high in a production efficiency, low in a production cost, and high in yield.

In some examples, the structure of the second pixel circuit and the third pixel circuit in the second display region may be substantially the same as the structure of the first pixel circuit, the light emitting area of the third light emitting element and the first light emitting element that emit light of a same color may be substantially the same, and the structure of the third light emitting element in the second display region may be substantially the same as the structure of the first light emitting element, and will not be repeated here.

In the display substrate provided in this example, for the first display region, the first pixel circuit connected to the first light emitting element is built in and the second pixel circuit connected to the second light emitting element is built out, and a light emitting element for which a pixel circuit is built out and a light emitting element for which a pixel circuit is built in can be reasonably arranged to achieve an optimal combination of light transmittance and size of the first display region, thereby improving performance of the display substrate and the user experience.

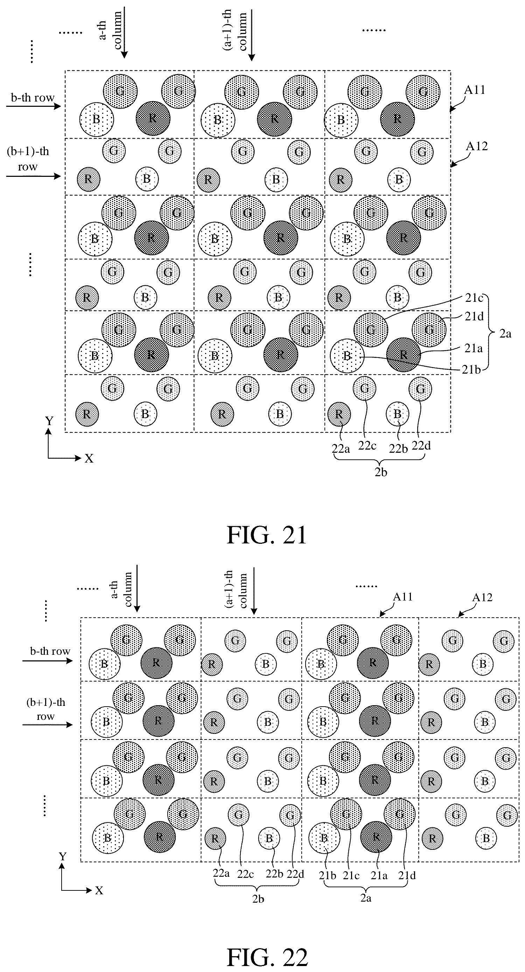

FIG. 21 is another example diagram of a first display region according to at least one embodiment of the present disclosure. In some examples, as illustrated in FIG. 21, the first sub-regions A11 and the second sub-regions A12 of the first display region may be arranged at intervals along the second direction Y. The first sub-region A11 may include a row of first light emitting units 2a (including a plurality of first light emitting units 2a sequentially disposed in the first direction X), and the second sub-region A12 may include a row of second light emitting units 2b (including a plurality of second light emitting units 2b sequentially disposed in the first direction X). In the second direction Y, the first light emitting units 2a and the second light emitting units 2b may be aligned and arranged at intervals.

In some examples, as illustrated in FIG. 21, the first light emitting unit 2a may include a first light emitting element 21a that emits light of a first color, a first light emitting element 21b that emits light of a second color, and two first light emitting elements 21c and 21d that emit light of a third color. The second light emitting unit 2b may include a second light emitting element 22a that emits light of the first color, a second light emitting element 22b that emits light of the second color, and two second light emitting elements 22c and 22d that emit light of the third color. Since the arrangement of the light emitting elements of the present example may be referred to descriptions of the aforementioned embodiments, and will not be repeated here.

In the display substrate of the present example, by providing a row of first light emitting units and a row of second light emitting units to be arranged at intervals in the second direction, a light emitting element for which a pixel circuit is built out and a light emitting element for which a pixel circuit is built in can be reasonably arranged to achieve an optimal combination of light transmittance and size of the first display region, thereby improving performance of the display substrate and the user experience. Remaining description of the display substrate in this example may be referred to the description in the aforementioned embodiments, which is not repeated here.

FIG. 22 is another example diagram of a first display region according to at least one embodiment of the present disclosure. In some examples, as illustrated in FIG. 22, the first sub-regions A11 and the second sub-regions A12 of the first display region may be arranged at intervals along the first direction X. The first sub-region A11 may include a column of first light emitting units 2a (including a plurality of first light emitting units 2a sequentially disposed in the second direction Y), and the second sub-region A12 may include a column of second light emitting units 2b (including a plurality of second light emitting units 2b sequentially disposed in the second direction Y). In the first direction X, the first light emitting units 2a and the second light emitting units 2b may be aligned and arranged at intervals.

In the display substrate of the present example, by providing a row of first light emitting units and a row of second light emitting units to be arranged at intervals in the first direction, a light emitting element for which a pixel circuit is built out and a light emitting element for which a pixel circuit is built in can be reasonably arranged to achieve an optimal combination of light transmittance and size of the first display region, thereby improving performance of the display substrate and the user experience. Remaining description of the display substrate in this example may be referred to the description in the aforementioned embodiments, which is not repeated here.

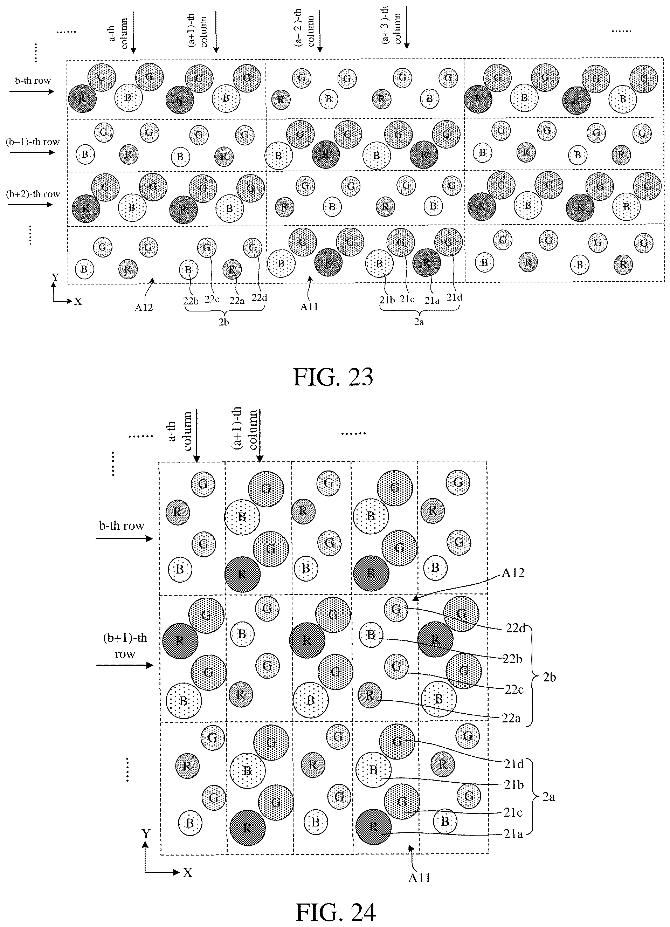

FIG. 23 is another example diagram of a first display region according to at least one embodiment of the present disclosure. In some examples, as illustrated in FIG. 23, the first sub-regions A11 and the second sub-regions A12 of the first display region may be provided at intervals in both the first direction X and the second direction Y. The first sub-region A11 may include two first light emitting units 2a sequentially disposed in the first direction X, and the second sub-region A12 may include two second light emitting units 2b sequentially disposed in the first direction X. In the first direction X, the two first light emitting units 2a and the two second light emitting units 2b may be aligned and arranged at intervals. In the second direction Y, one first light emitting unit 2a and one second light emitting unit 2b may be aligned and arranged at intervals. However, the present embodiment is not limited thereto. In some other examples, two first light emitting units and the one second light emitting unit may be arranged at intervals in the first direction, or two first light emitting units and one second light emitting unit may be arranged at intervals in the second direction.

In the display substrate of the present example, by providing two first light emitting units and two second light emitting units to be arranged at intervals in the first direction and the second direction, a light emitting element for which a pixel circuit is built out and a light emitting element for which a pixel circuit is built in can be reasonably arranged to achieve an optimal combination of light transmittance and size of the first display region, thereby improving performance of the display substrate and the user experience. Remaining description of the display substrate in this example may be referred to the description in the aforementioned embodiments, which is not repeated here.

FIG. 24 is another example diagram of a first display region according to at least one embodiment of the present disclosure. In some examples, as illustrated in FIG. 24, the first sub-regions A11 and the second sub-regions A12 of the first display region may be arranged at intervals along both the first direction X and the second direction Y. The first sub-region A11 may include one first light emitting unit 2a, and the second sub-region A12 may include one second light emitting unit 2b. In the second direction Y, the first light emitting units 2a and the second light emitting units 2b may be aligned and arranged at intervals. In the first direction X, the first light emitting units 2a and the second light emitting units 2b may be aligned and arranged at intervals.

In some examples, as illustrated in FIG. 24, the first light emitting unit 2a may include a first light emitting element 21a that emits light of a first color, a first light emitting element 21b that emits light of a second color, and two first light emitting elements 21c and 21d that emit light of a third color. Herein, the first light emitting elements 21a and 21b may be arranged in a same column of light emitting elements at intervals, the first light emitting elements 21c and 21d may be arranged in a same column of light emitting elements at intervals, and the first light emitting elements 21a, 21b, 21c and 21d may be arranged in different rows of light emitting elements.

In some examples, as illustrated in FIG. 24, the second light emitting unit 2b may include a second light emitting element 22a that emits light of the first color, a second light emitting element 22b that emits light of the second color, and two second light emitting elements 22c and 22d that emit light of the third color. Herein, the second light emitting elements 22a and 22b may be arranged in a same column of light emitting elements at intervals, the second light emitting elements 22c and 22d may be arranged in a same column of light emitting elements at intervals, and the second light emitting elements 22a, 22b, 22c and 22d may be arranged in different rows of light emitting elements.

In the display substrate of the present example, by providing the first light emitting unit (including four first light emitting elements arranged in two columns longitudinally) and the second light emitting unit (including four second light emitting elements arranged in two columns longitudinally) to be arranged at intervals in the first direction and the second direction, a light emitting element for which a pixel circuit is built out and a light emitting element for which a pixel circuit is built in can be reasonably arranged to achieve an optimal combination of light transmittance and size of the first display region, thereby improving performance of the display substrate and the user experience. Remaining description of the display substrate in this example may be referred to the description in the aforementioned embodiments, which is not repeated here.

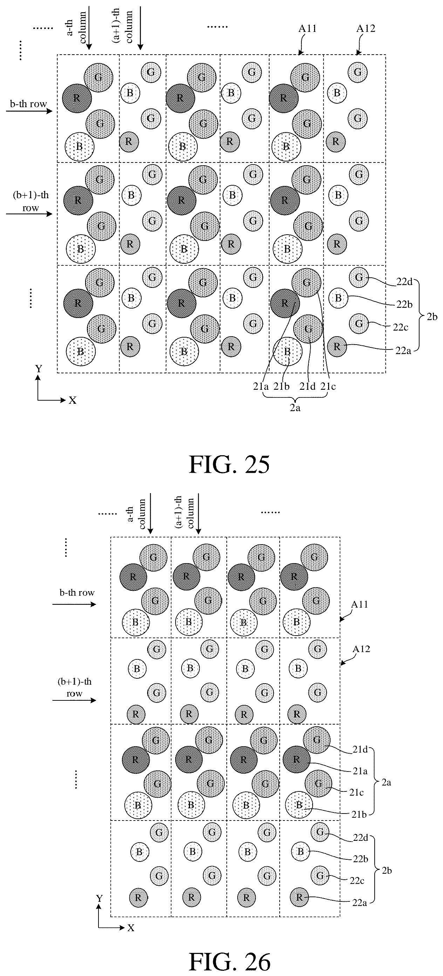

FIG. 25 is another example diagram of a first display region according to at least one embodiment of the present disclosure. In some examples, as illustrated in FIG. 25, the first sub-regions A11 and the second sub-regions A12 of the first display region may be arranged at intervals along the first direction X. The first sub-region A11 may include a column of first light emitting units 2a (including a plurality of first light emitting units 2a sequentially disposed in the second direction Y), and the second sub-region A12 may include a column of second light emitting units 2b (including a plurality of second light emitting units 2b sequentially disposed in the second direction Y). In the first direction X, the first light emitting units 2a and the second light emitting units 2b may be aligned and arranged at intervals.

In the display substrate of the present example, by providing the first light emitting unit (including four first light emitting elements arranged in two columns longitudinally) and the second light emitting unit (including four second light emitting elements arranged in two columns longitudinally) to be arranged at intervals in the first direction, a light emitting element for which a pixel circuit is built out and a light emitting element for which a pixel circuit is built in can be reasonably arranged to achieve an optimal combination of light transmittance and size of the first display region, thereby improving performance of the display substrate and the user experience. Remaining description of the display substrate in this example may be referred to the description in the aforementioned embodiments, which is not repeated here.

FIG. 26 is another example diagram of a first display region according to at least one embodiment of the present disclosure. In some examples, as illustrated in FIG. 26, the first sub-regions A11 and the second sub-regions A12 of the first display region may be arranged at intervals along the second direction Y. The first sub-region A11 may include a row of first light emitting units 2a (including a plurality of first light emitting units 2a sequentially disposed in the first direction X), and the second sub-region A12 may include a row of second light emitting units 2b (including a plurality of second light emitting units 2b sequentially disposed in the first direction X). In the second direction Y, the first light emitting units 2a and the second light emitting units 2b may be aligned and arranged at intervals.

In the display substrate of the present example, by providing the first light emitting unit (including four first light emitting elements arranged in two columns longitudinally) and the second light emitting unit (including four second light emitting elements arranged in two columns longitudinally) to be arranged at intervals in the second direction, a light emitting element for which a pixel circuit is built out and a light emitting element for which a pixel circuit is built in can be reasonably arranged to achieve an optimal combination of light transmittance and size of the first display region, thereby improving performance of the display substrate and the user experience. Remaining description of the display substrate in this example may be referred to the description in the aforementioned embodiments, which is not repeated here.

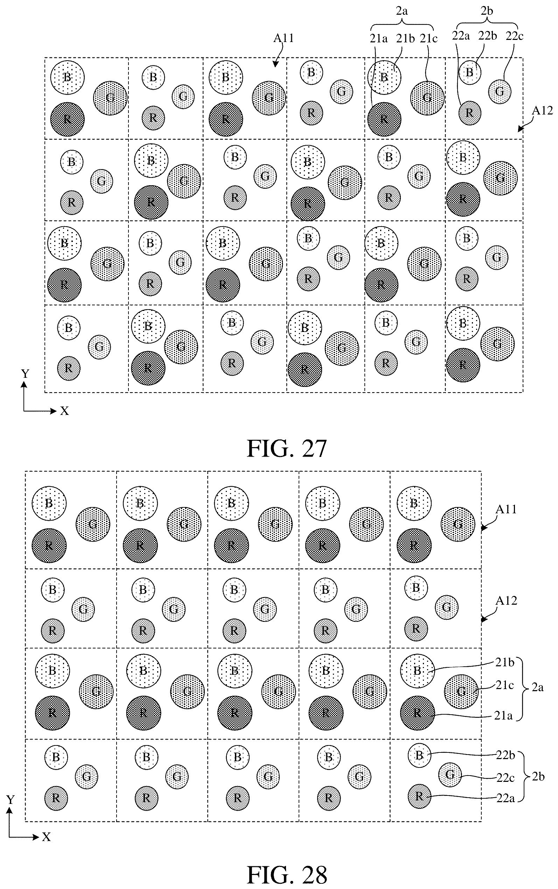

FIG. 27 is another example diagram of a first display region according to at least one embodiment of the present disclosure. In some examples, as illustrated in FIG. 27, the first sub-regions A11 and the second sub-regions A12 of the first display region may be provided at intervals along both the first direction X and the second direction Y. The first sub-region A11 may include one first light emitting unit 2a, and the second sub-region A12 may include one second light emitting unit 2b. In the second direction Y, the first light emitting units 2a and the second light emitting units 2b may be aligned and arranged at intervals. In the first direction X, the first light emitting units 2a and the second light emitting units 2b may be aligned and arranged at intervals.

In some examples, as illustrated in FIG. 27, the first light emitting unit 2a may include one first light emitting element 21a that emits light of a first color, one first light emitting element 21b that emits light of a second color, and one first light emitting element 21c that emits light of a third color. Herein, the first light emitting elements 21a and 21b may be arranged in a same column of light emitting elements at intervals, the first light emitting elements 21c may be arranged in one column of light emitting elements, and the first light emitting elements 21a, 21b, and 21c may be arranged in different rows of light emitting elements. The arrangement of three first light emitting elements of the first light emitting unit 2a is substantially triangular in shape.

In some examples, as illustrated in FIG. 27, the second light emitting unit 2b may include one second light emitting element 22a that emits light of the first color, one second light emitting element 22b that emits light of the second color, and one second light emitting element 22c and 22d that emits light of the third color. Herein, the second light emitting elements 22a and 22b may be arranged in a same column of light emitting elements at intervals, the second light emitting elements 22c may be arranged in one column of light emitting elements, and the second light emitting elements 22a, 22b, and 22c may be arranged in different rows of light emitting elements. The arrangement of three first light emitting elements of the second light emitting unit 2b is substantially triangular in shape.

In the display substrate of the present example, by providing the first light emitting unit (including three first light emitting elements arranged in a triangular shape) and the second light emitting unit (including three second light emitting elements arranged in a triangular shape) to be arranged at intervals in both the first direction and the second direction, a light emitting element for which a pixel circuit is built out and a light emitting element for which a pixel circuit is built in can be reasonably arranged to achieve an optimal combination of light transmittance and size of the first display region, thereby improving performance of the display substrate and the user experience. Remaining description of the display substrate in this example may be referred to the description in the aforementioned embodiments, which is not repeated here.

FIG. 28 is another example diagram of a first display region according to at least one embodiment of the present disclosure. In some examples, as illustrated in FIG. 28, the first sub-regions A11 and the second sub-regions A12 of the first display region may be arranged at intervals along the second direction Y. The first sub-region A11 may include a row of first light emitting units 2a, and the second sub-region A12 may include a row of second light emitting units 2b. In the second direction Y, the first light emitting units 2a and the second light emitting units 2b may be aligned and arranged at intervals.

In the display substrate of the present example, by providing the first light emitting unit (including three first light emitting elements arranged in a triangular shape) and the second light emitting unit (including three second light emitting elements arranged in a triangular shape) to be arranged at intervals in the second direction, a light emitting element for which a pixel circuit is built out and a light emitting element for which a pixel circuit is built in can be reasonably arranged to achieve an optimal combination of light transmittance and size of the first display region, thereby improving performance of the display substrate and the user experience. Remaining description of the display substrate in this example may be referred to the description in the aforementioned embodiments, which is not repeated here.

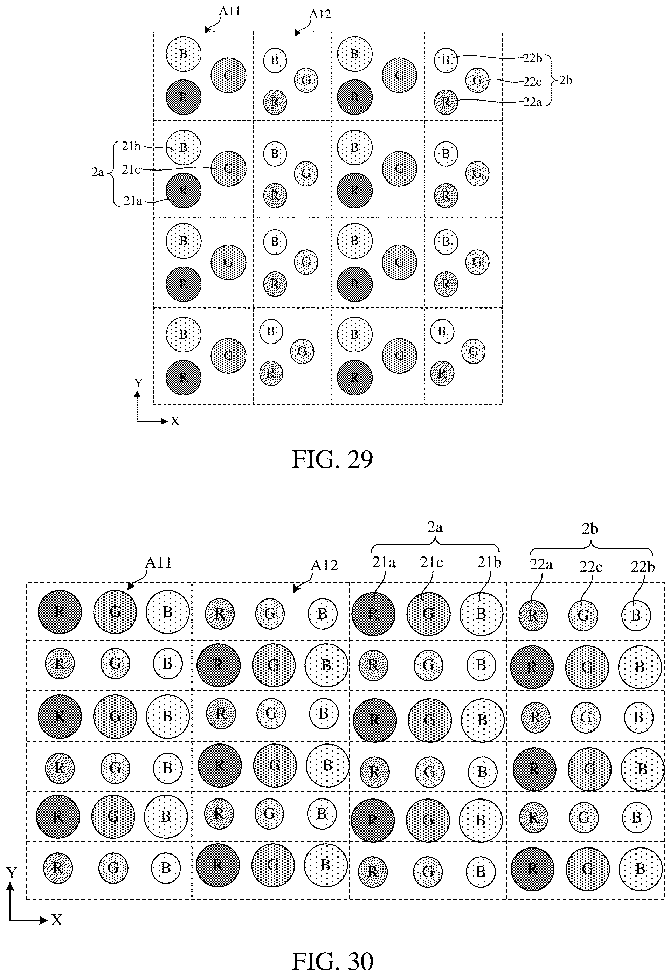

FIG. 29 is another example diagram of a first display region according to at least one embodiment of the present disclosure. In some examples, as illustrated in FIG. 29, the first sub-regions A11 and the second sub-regions A12 of the first display region may be arranged at intervals along the first direction X. The first sub-region A11 may include a column of first light emitting units 2a, and the second sub-region A12 may include a column of second light emitting units 2b. In the first direction X, the first light emitting units 2a and the second light emitting units 2b may be aligned and arranged at intervals.

In the display substrate of the present example, by providing the first light emitting unit (including three first light emitting elements arranged in a triangular shape) and the second light emitting unit (including three second light emitting elements arranged in a triangular shape) to be arranged at intervals in the first direction, a light emitting element for which a pixel circuit is built out and a light emitting element for which a pixel circuit is built in can be reasonably arranged to achieve an optimal combination of light transmittance and size of the first display region, thereby improving performance of the display substrate and the user experience. Remaining description of the display substrate in this example may be referred to the description in the aforementioned embodiments, which is not repeated here.

FIG. 30 is another example diagram of a first display region according to at least one embodiment of the present disclosure. In some examples, as illustrated in FIG. 30, the first sub-regions A11 and the second sub-regions A12 of the first display region may be provided at intervals along both the first direction X and the second direction Y. The first sub-region A11 may include one first light emitting unit 2a, and the second sub-region A12 may include one second light emitting unit 2b. In the first direction X and the second direction Y, the first light emitting units 2a and the second light emitting units 2b may be aligned and arranged at intervals.

In some examples, as illustrated in FIG. 30, the first light emitting unit 2a may include one first light emitting element 21a that emits light of a first color, one first light emitting element 21b that emits light of a second color, and one first light emitting element 21c that emits light of a third color. Here, the first light emitting elements 21a, 21c, and 21b may be arranged sequentially in the first direction X. The second light emitting unit 2b may include one second light emitting element 22a that emits light of the first color, one second light emitting element 22b that emits light of the second color, and one second light emitting elements 22c and 22d that emit light of the third color. Here, the second light emitting elements 22a, 22c, and 22b may be arranged sequentially along the first direction X. The light emitting elements of the present example may be arranged periodically in the first direction X in a repeating unit including a light emitting element emitting light of the first color, a light emitting elements emitting light of the third color, and a light emitting element emitting light of the second color, the light emitting elements emitting light of the same color may be arranged in alignment in the second direction Y.

In the display substrate of the present example, by providing the first light emitting unit (including three first light emitting elements arranged in the first direction) and the second light emitting unit (including three second light emitting elements arranged in the first direction) to be arranged at intervals in both the first direction and the second direction, a light emitting element for which a pixel circuit is built out and a light emitting element for which a pixel circuit is built in can be reasonably arranged to achieve an optimal combination of light transmittance and size of the first display region, thereby improving performance of the display substrate and the user experience. Remaining description of the display substrate in this example may be referred to the description in the aforementioned embodiments, which is not repeated here.

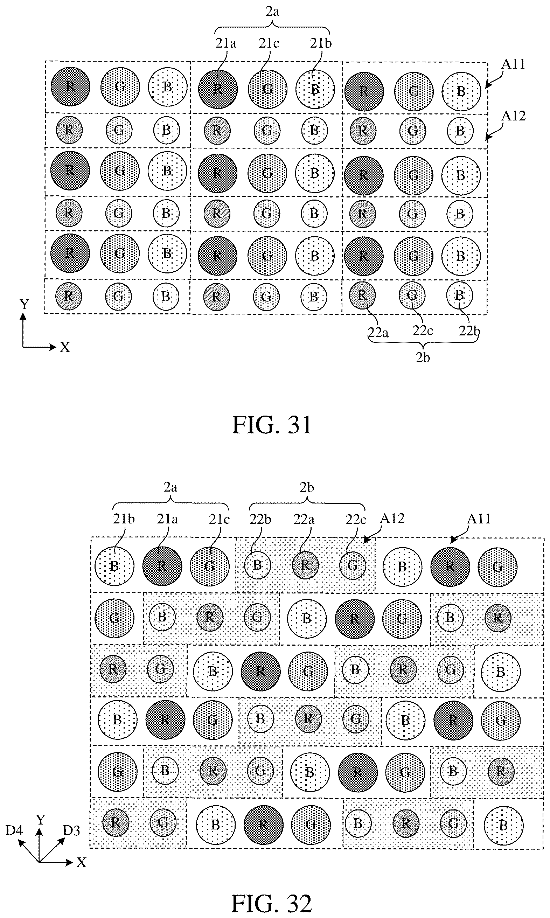

FIG. 31 is another example diagram of a first display region according to at least one embodiment of the present disclosure. In some examples, as illustrated in FIG. 31, the first sub-regions A11 and the second sub-regions A12 of the first display region may be arranged at intervals along the second direction Y. The first sub-region A11 may include a row of first light emitting units 2a, and the second sub-region A12 may include a row of second light emitting units 2b. In the second direction Y, the first light emitting units 2a and the second light emitting units 2b may be aligned and arranged at intervals. However, the present embodiment is not limited thereto. In other examples, the first sub-regions and the second sub-regions may be arranged at intervals along the first direction X. The first sub-region may include a column of first light emitting units, and the second sub-region may include a column of second light emitting units.

In the display substrate of the present example, by providing the first light emitting unit (including three first light emitting elements arranged in the first direction) and the second light emitting unit (including three second light emitting elements arranged in the first direction) to be arranged at intervals in the second direction, a light emitting element for which a pixel circuit is built out and a light emitting element for which a pixel circuit is built in can be reasonably arranged to achieve an optimal combination of light transmittance and size of the first display region, thereby improving performance of the display substrate and the user experience. Remaining description of the display substrate in this example may be referred to the description in the aforementioned embodiments, which is not repeated here.

FIG. 32 is another example diagram of a first display region according to at least one embodiment of the present disclosure. In some examples, as shown in FIG. 32, the light emitting elements of the first display region may be periodically arranged in the first direction X in a repeating unit including a light emitting element emitting light of the second color (for example, blue light B), a light emitting element emitting light of the first color (for example, red light R), and a light emitting element emitting light of the third color (for example, green light G), and the light emitting elements emitting light of a same color can be arranged in a staggered manner in the second direction Y. Herein, a light emitting elements emitting light of the second color in one row of repeating units may be aligned with a light emitting element emitting light of the first color in the previous row of repeating units in the second direction Y. Light emitting elements in adjacent rows can be arranged in such a way that they are staggered by one light emitting element in the second direction Y.

In some examples, as illustrated in FIG. 32, the first sub-regions A11 and the second sub-regions A12 of the first display region may be arranged at intervals in a fourth direction D4 intersecting both the first direction X and the second direction Y. The first sub-region A11 may include a plurality of first light emitting units 2a sequentially disposed in a third direction D3, the second sub-region A12 may include a plurality of second light emitting units 2b sequentially disposed in the third direction D3, and the third direction D3 and the fourth direction D4 may intersect, for example, may be perpendicular to each other. The first light emitting unit 2a may include three first light emitting elements, and the second light emitting unit 2b may include three second light emitting elements.

In the display substrate of the present example, by providing the first light emitting unit (including three first light emitting elements arranged along the first direction) and the second light emitting unit (including three second light emitting elements arranged along the first direction) to be arranged at intervals in the fourth direction intersecting both the first direction and the second direction, a light emitting element for which a pixel circuit is built out and a light emitting element for which a pixel circuit is built in can be reasonably arranged to achieve an optimal combination of light transmittance and size of the first display region, thereby improving performance of the display substrate and the user experience. Remaining description of the display substrate in this example may be referred to the description in the aforementioned embodiments, which is not repeated here.

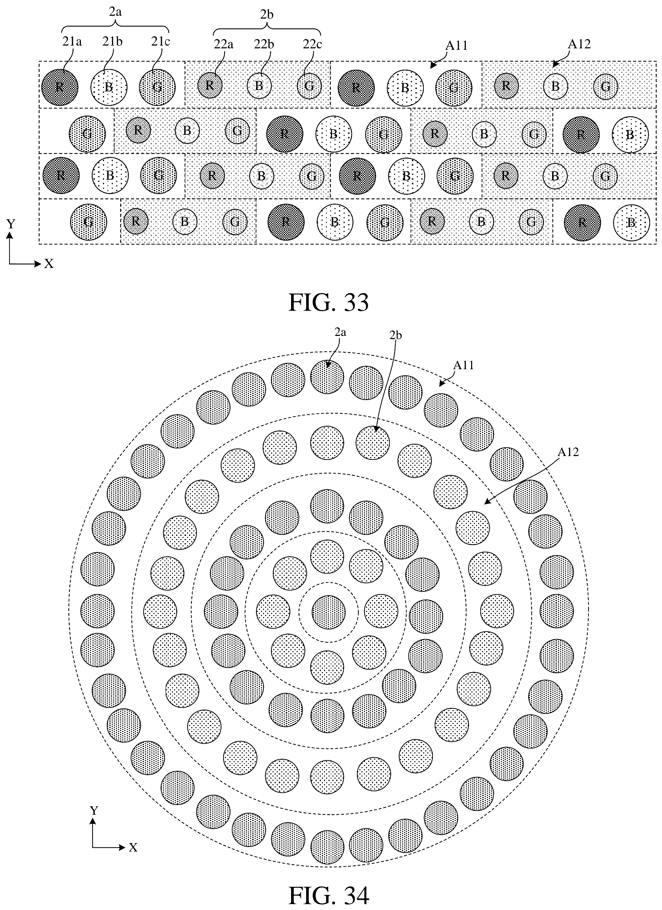

FIG. 33 is another example diagram of a first display region according to at least one embodiment of the present disclosure. In some examples, as shown in FIG. 33, the light emitting elements of the first display region may be periodically arranged in the first direction X in a repeating unit including a light emitting element that emits light of the first color (e.g., blue light R), a light emitting element that emits light of the second color (e.g., blue light B), and a light emitting element that emits light of a same color (e.g., green light G), and the light emitting elements emitting light of a same color can be arranged in a staggered manner in the second direction Y. Herein, the light emitting element emitting light of the first color in a row of repeating units may be aligned in the second direction with the centerline of the light emitting element emitting light of the second color and the light emitting element emitting light of the third color in the previous row of repeating units. Light emitting elements in adjacent rows can be arranged in such a way that they are staggered by 1.5 light emitting element in the second direction Y.

In some examples, as shown in FIG. 33, the first sub-regions A11 and the second sub-regions A12 of the first display region may be arranged at intervals in the first direction X. The first sub-region A11 may include a plurality of first light emitting units 2a disposed sequentially along the second direction Y, and adjacent first light emitting units 2a can be staggered. The second sub-region A12 may include a plurality of second light emitting units 2b sequentially disposed in the second direction Y, and adjacent second light emitting units 2b can be staggered. The first light emitting unit 2a may include three first light emitting elements, and the second light emitting unit 2b may include three second light emitting elements.

In the display substrate of the present example, by providing the first light emitting unit (including three first light emitting elements arranged in the first direction) and the second light emitting unit (including three second light emitting elements arranged in the first direction) to be arranged at intervals in the first direction, a light emitting element for which a pixel circuit is built out and a light emitting element for which a pixel circuit is built in can be reasonably arranged to achieve an optimal combination of light transmittance and size of the first display region, thereby improving performance of the display substrate and the user experience. Remaining description of the display substrate in this example may be referred to the description in the aforementioned embodiments, which is not repeated here.

FIG. 34 is another example diagram of a first display region according to at least one embodiment of the present disclosure. In some examples, as illustrated in FIG. 34, a plurality of first light emitting units 2a and a plurality of second light emitting units 2b of the first display region may be arranged at intervals in a plurality of circumferential regions centered on the center of the first display region. The first sub-regions A11 and the second sub-regions A12 may be arranged at intervals along the direction from the center to the edge. The first sub-region A11 may include at least one first light emitting unit 2a, and the second sub-region A12 may include a plurality of second light emitting units 2b. In the direction from the center to the edge, a quantity of the first light emitting units 2a in different first sub-regions A11 may gradually increase, and a quantity of the first light emitting units 2b in different second sub-regions A12 may gradually increase. The first light emitting unit 2a may include three or four first light emitting elements, and the second light emitting unit 2b may include three or four second light emitting elements. The present embodiment is not limited thereto.

In the display substrate of the present example, by providing the first light emitting units and the second light emitting units to be arranged at intervals in the direction from the center to the edge, and a light emitting element for which a pixel circuit is built out and a light emitting element for which a pixel circuit is built in can be reasonably arranged to achieve an optimal combination of light transmittance and size of the first display region, thereby improving performance of the display substrate and the user experience. Remaining description of the display substrate in this example may be referred to the description in the aforementioned embodiments, which is not repeated here.

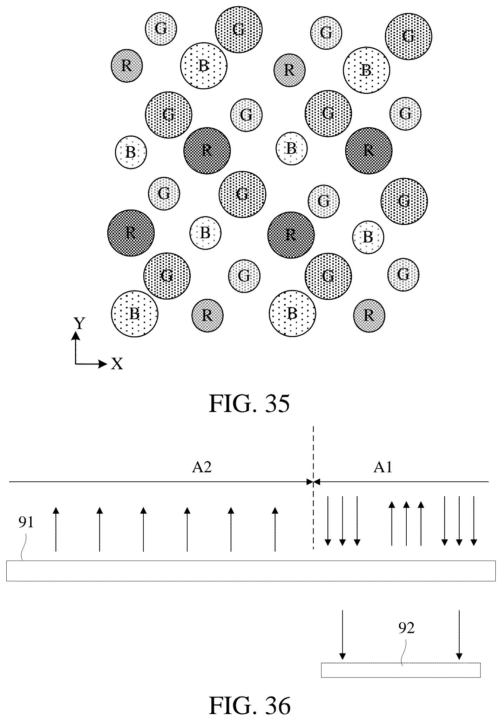

FIG. 35 is another example diagram of a first display region according to at least one embodiment of the present disclosure. In some examples, as shown in FIG. 35, the light emitting elements of the first display region may be arranged in a manner in which a plurality of light emitting elements emitting light of the third color (for example, green light G) are arranged in a plurality of rows and a plurality of columns, the light emitting elements emitting light of the first color (for example, red light R) and the light emitting elements emitting light of the second color (for example, blue light B) are arranged at intervals in a row direction and a column direction, and the light emitting elements emitting light of the first color and the light emitting elements emitting light of the third color are arranged in different rows and columns.

In some examples, as illustrated in FIG. 35, the first light emitting unit may include one first light emitting element, and the second light emitting unit may include a first second light emitting element. In the first direction X, one first light emitting unit and one second light emitting unit are arranged at intervals. Herein, in a row of light emitting elements, the first light emitting element and the second light emitting element are arranged at intervals. For example, the first light emitting element and the second light emitting element that emit light of the third color (G) are arranged at intervals; the first light emitting element that emits light of the first color (R) and the second light emitting element that emits light of the second color (B) are arranged at intervals, or the first light emitting element that emits light of the second color (B) and the second light emitting element that emits light of the first color (R) are arranged at intervals.

In some examples, in the second direction Y, one first light emitting unit and one second light emitting unit are arranged at intervals, or two first light emitting units and two second light emitting units are arranged at intervals. Herein, in a column of light emitting elements, the first light emitting element and the second light emitting element that emit light of the third color (G) are arranged at intervals one by one; in another column of light emitting elements, two first light emitting elements (including a first light emitting element that emits light of the first color (R) and a first light emitting element that emits light of the first color (B)) and two second light emitting elements (including a second light emitting element that emits light of the first color (R) and a first light emitting element that emits light of the second color (B)) are arranged at intervals.

In the display substrate of the present example, by providing a single first light emitting element and a single second light emitting element to be arranged at intervals in the first direction, a single first light emitting element and a single first light emitting element or two first light emitting elements and two second light emitting elements to be arranged at intervals in the second direction, and a light emitting element for which a pixel circuit is built out and a light emitting element for which a pixel circuit is built in can be reasonably arranged to achieve an optimal combination of light transmittance and size of the first display region, thereby improving performance of the display substrate and the user experience. Remaining description of the display substrate in this example may be referred to the description in the aforementioned embodiments, which is not repeated here.

FIG. 36 is a schematic diagram of a display apparatus according to at least one embodiment of the present disclosure. As shown in FIG. 36, a display apparatus is provided in an embodiment, which includes a display substrate 91 and a sensor 92 located on a light exit side of a light emitting structure layer away from the display substrate 91. The sensor 92 may be located on a side of a non-display surface of the display substrate 91. An orthographic projection of the sensor 92 on the display substrate 91 may be overlapped with a first display region A1.

In some examples, the display substrate 91 may be a flexible OLED display substrate, a QLED display substrate, a Micro-LED display substrate, or a Mini-LED display substrate. The display apparatus may be a product having an image (including a still image or a moving image, where the moving image may be a video) display function. For example, the display apparatus may be any one of a display, a television, a billboard, a digital photo frame, a laser printer with display function, a telephone, a mobile phone, a picture screen, a personal digital assistant (PDA), a digital camera, a portable camcorder, a viewfinder, a navigator, a vehicle, a large-area wall, an information inquiry equipment (such as business inquiry equipment in e-government, banks, hospitals, power departments), a monitor, or the like. As another example, the display apparatus may be any one of a micro-display, a VR device or an AR device including a micro-display.

The drawings of the present disclosure only involve structures involved in the present disclosure, and other structures may refer to conventional designs. The embodiments of the present disclosure, i.e., features in the embodiments, may be combined with each other to obtain new embodiments if there is no conflict. It should be noted that the above examples or embodiments are exemplary only but not restrictive. Therefore, the present disclosure is not limited to what is specifically shown and described herein. Various modifications, substitutions or omissions may be made in forms and details of implementation modes without departing from the scope of the present disclosure.

**Claims**

1. A display substrate, comprising:

   a base substrate comprising a first display region, and a second display region located on at least one side of the first display region;
   a plurality of first light emitting units and a plurality of second light emitting units located in the first display region; wherein a first light emitting unit of the plurality of first light emitting units comprises at least one first light emitting element, and a second light emitting unit of the plurality of second light emitting units comprises at least one second light emitting element; the first light emitting unit of the plurality of first light emitting units is adjacent to at least one second light emitting unit of the plurality of second light emitting units;
   a plurality of first pixel circuits located in the first display region; wherein at least one first pixel circuit of the plurality of first pixel circuits is electrically connected to the at least one first light emitting element and configured to drive the at least one first light emitting element to emit light; and
   a plurality of second pixel circuits located in the second display region; wherein at least one second pixel circuit of the plurality of second pixel circuits is electrically connected to the at least one second light emitting element and configured to drive the at least one second light emitting element to emit light.

2. The display substrate according to claim 1, wherein the plurality of first light emitting units and the plurality of second light emitting units are arranged at intervals along at least one of a first direction and a second direction; and the first direction intersects the second direction.

3. The display substrate according to claim 2, wherein, in the first direction, one first light emitting unit and one second light emitting unit are arranged at intervals; and in the second direction, one first light emitting unit and one second light emitting unit are arranged at intervals.

4. The display substrate according to claim 2, wherein the plurality of first light emitting units comprise: a plurality of columns of first light emitting units; each column of first light emitting units comprise a plurality of first light emitting units arranged sequentially along the second direction;

   the plurality of second light emitting units comprises: a plurality of columns of second light emitting units, each column of second light emitting units comprise a plurality of second light emitting units arranged sequentially along the second direction; and
   in the first direction, a column of first light emitting units and a column of second light emitting units are arranged at intervals.

5. The display substrate according to claim 2, wherein the plurality of first light emitting units comprise a plurality of rows of first light emitting units, each row of first light emitting units comprise a plurality of first light emitting units arranged sequentially along the first direction;

   the plurality of second light emitting units comprises a plurality of rows of second light emitting units, each row of the second light emitting units comprise a plurality of second light emitting units arranged sequentially along the first direction; and
   in the second direction, a row of first light emitting units and a row of second light emitting units are arranged at intervals.

6. The display substrate according to claim 2, wherein a first light emitting unit and a second light emitting unit adjacent to each other in the first direction are arranged in alignment, and a first light emitting unit and a second light emitting unit adjacent in the second direction are arranged in alignment;
   or, a first light emitting unit and a second light emitting unit adjacent to each other in the second direction are misaligned.

7. The display substrate according to any one of claims 1 to 6, wherein a ratio of light emitting areas of a second light emitting element and a first light emitting element emitting light of a same color is less than 1.

8. The display substrate according to any one of claims 1 to 7, wherein a quantity of first light emitting elements comprised in at least one first light emitting unit is the same as a quantity of second light emitting elements comprised in at least one second light emitting unit.

9. The display substrate according to claim 8, wherein the at least one first light emitting unit comprises four first light emitting elements: one first light emitting element that emits light of a first color, one first light emitting element that emits light of a second color, and two first light emitting elements that emit light of a third color; and
the at least one second light emitting unit comprises four second light emitting elements: one second light emitting element that emits light of the first color, one second light emitting element that emits light of the second color, and two second light emitting elements that emit light of the third color.

10. The display substrate according to claim 9, wherein the plurality of first light emitting elements and the plurality of second light emitting elements in the first display region are arranged in a plurality of rows and a plurality of columns;

in the at least one first light emitting unit, the two first light emitting elements that emit light of the third color are arranged in a same column, the first light emitting element that emits light of the first color and the first light emitting element that emits light of the second color are arranged in a same column, and the four first light emitting elements of the first light emitting unit are arranged in different rows; and
in the at least one second light emitting unit, the two second light emitting elements that emit light of the third color are arranged in a same column, the second light emitting element that emits light of the first color and the second light emitting element that emits light of the second color are arranged in a same column, and the four first light emitting elements of the second light emitting unit are arranged in different rows.

11. The display substrate according to claim 9, wherein the plurality of first light emitting elements and the plurality of second light emitting elements in the first display region are arranged in a plurality of rows and a plurality of columns;

in the at least one first light emitting unit, the two first light emitting elements that emit light of the third color are arranged in a same row, the first light emitting element that emit light of the first color and the first light emitting element that emit light of the second color are arranged in a same row, and the four first light emitting elements of the first light emitting unit are arranged in different columns; and
in the at least one second light emitting unit, the two second light emitting elements that emit light of the third color are arranged in a same row, the first light emitting element that emits light of the first color and the second light emitting element that emits light of the second color are arranged in a same row, and the four second light emitting elements of the second light emitting unit are arranged in different columns.

12. The display substrate according to claim 11, wherein the four first light emitting elements in the first light emitting unit are electrically connected to four first pixel circuits in a one-to-one correspondence, the four first pixel circuits are arranged sequentially in a first direction, and an orthographic projection of each first pixel circuit on the base substrate is at least partially overlapped with an orthographic projection of a first light emitting element connected to the first pixel circuit on the base substrate.

13. The display substrate according to claim 12, wherein the four first pixel circuits are disposed symmetrically with respect to a first centerline of the four first pixel circuits in the first direction, a first one of the four first pixel circuits and a second one of the four first pixel circuits are disposed symmetrically with respect to a second centerline of the first one and the second one of the four first pixel circuits in the first direction, and a third one of the four first pixel circuits and a fourth one of the four first pixel circuits are disposed symmetrically with respect to a third centerline of the third one and the fourth one of the four first pixel circuits in the first direction.

14. The display substrate according to claim 12, wherein the four first pixel circuits are electrically connected to a first power supply line, and the first power supply line is in a form of a grid in the first display region.

15. The display substrate according to claim 12 or 13, wherein, in a direction perpendicular to the display substrate, the display substrate comprises: a circuit structure layer on the base substrate; wherein the circuit structure layer comprises the plurality of first pixel circuits and the plurality of second pixel circuits; each pixel circuit of the plurality of first pixel circuits and the plurality of second pixel circuits comprises: at least one first type transistor, at least one second type transistor, and a storage capacitor;

the circuit structure layer comprises a first semiconductor layer, a first conductive layer, a second conductive layer, a second semiconductor layer, a third conductive layer, a fourth conductive layer, a fifth conductive layer, and a sixth conductive layer disposed on the base substrate;
the first semiconductor layer at least comprises: an active layer of the first type transistor of the pixel circuit;
the first conductive layer at least comprises: a gate of the first type transistor and a first electrode of the storage capacitor of the pixel circuit;

the second conductive layer at least comprises: a second electrode of the storage capacitor of the pixel circuit;

the second semiconductor layer at least comprises: an active layer of the second type transistor of the pixel circuit;

the third conductive layer at least comprises: a gate of the second type transistor of the pixel circuit; and

the fourth conductive layer at least comprises: a plurality of connection electrodes;

the fifth conductive layer at least comprises: a plurality of data lines; and

the sixth conductive layer at least comprises a first power supply line.

16. The display substrate according to claim 15, wherein the first display region comprises:

a plurality of first sub-regions and a plurality of second sub-regions; at least one first sub-region of the plurality of first sub-regions is provided with at least one first light emitting unit, and at least one second sub-region of the plurality of second sub-regions is provided with at least one second light emitting unit;

the second conductive layer further comprises: a first scan line, a light emitting control line, a first reset control line, and a second reset control line electrically connected to the first pixel circuit; the first scan line, the light emitting control line, the first reset control line, and the second reset control line extend in the first direction; and

in a second direction, the first scan line and the first reset control line bypass from one side of the second sub-region, and the light emitting control line and the second reset control line bypass from the other side of the second sub-region; the second direction intersects the first direction.

17. The display substrate according to claim 15 or 16, wherein the first display region comprises: a plurality of first sub-regions and a plurality of second sub-regions; at least one first sub-region of the plurality of first sub-regions is provided with at least one first light emitting unit, and at least one second sub-region of the plurality of second sub-regions is provided with at least one second light emitting unit;

the third conductive layer further comprises a first initial signal line, a second initial signal line, a third initial signal line, and a second scan line electrically connected to the first pixel circuit; the first initial signal line, the second initial signal line, the third initial signal line, and the second scan line extend in a first direction;

in a second direction, the first initial signal line and the second scan line bypass from one side of the second sub-region, and the second initial signal line and the third initial signal line bypass from the other side of the second sub-region; the second direction intersects the first direction.

18. The display substrate according to any one of claims 1 to 17, wherein a ratio of a quantity of the first light emitting units and a quantity of the second light emitting units in the first display region is 0.8 to 1.2.

19. The display substrate according to any one of claims 1 to 18, wherein a light transmittance of the first display region is greater than a light transmittance of the second display region;

the display substrate further comprises a plurality of third light emitting elements and a plurality of third pixel circuits located in the second display region, wherein at least one third pixel circuit of the plurality of third pixel circuits is electrically connected to at least one third light emitting element of the plurality of third light emitting elements and is configured to drive the at least one third light emitting element to emit light; and

the plurality of second pixel circuits are arranged at intervals between the plurality of third pixel circuits.

20. The display substrate according to any one of claims 1 to 19, wherein an orthographic projection of the at least one first pixel circuit on the base substrate is overlapped with an orthographic projection of the at least one first light emitting element on the base substrate; and

the at least one second pixel circuit is electrically connected to the at least one second light emitting element via at least one conductive connection line; an orthographic projection of the at least one second pixel circuit on the base substrate is not overlapped with an orthographic projection of the at least one second light emitting element on the base substrate.

21. The display substrate according to claim 20, wherein an orthographic projection of the at least one conductive connection line on the base substrate is overlapped with the orthographic projection of the at least one first pixel circuit on the base substrate.

22. A display apparatus, comprising a display substrate according to any one of claims 1 to 21, and a sensor located on a non-display side of the display substrate, wherein an orthographic projection of the sensor on the display substrate is at least partially overlapped with the first display region of the display substrate.

FIG. 1

FIG. 2

FIG. 3

FIG. 4A

FIG. 4B

FIG. 5

FIG. 6

FIG. 7A

FIG. 7B

RST1(i)

GL1(i)

EML(i)  RST2(i)

RST1(i+1)  GL1(i+1)

EML(i+1)  RST2(i+1)

RST1(i+2)  GL1(i+2)

EML(i+2)  RST2(i+2)

RST1(i+3)  GL1(i+3)

EML(i+3)  RST2(i+3)

Y
X

## FIG. 8A

RST1(i)

GL1(i)

391a  391b

EML(i)  RST2(i)

RST1(i+1)  GL1(i+1)

EML(i+1)  RST2(i+1)

RST1(i+2)  GL1(i+2)

EML(i+2)  RST2(i+2)

RST1(i+3)  GL1(i+3)

EML(i+3)  RST2(i+3)

Y
X

## FIG. 8B

FIG. 8C

FIG. 9A

GL2b(i)

392a  392-1  392b  L2  392-1
392-1  392-2

GL2b(i+1)

GL2b(i+2)

GL2b(i+3)

**FIG. 9B**

11a  11b  11c  11d

31a  31b

34a  34b

33a  33b

GL2b(i)

36a 36b

35a

35b

38a  392a  37a 37b  392b  38b  35b

**FIG. 9C**

FIG. 10A

FIG. 10B

FIG. 10C

FIG. 11A

INIT1(i)

GL2(i)

INIT3(i)   INIT2(i)

INIT1(i+1)   GL2(i+1)

INIT3(i+1)   INIT2(i+1)

INIT1(i+2)   GL2(i+2)

INIT3(i+2)   INIT2(i+2)

INIT1(i+3)   GL2(i+3)

INIT3(i+3)   INIT2(i+3)

Y
X

## FIG. 11B

| 11a | 11b | 11c | 11d |

31a   31b
32a        32b
34a             34b
INIT1(i)

GL2(i)

33a
INIT3(i)

35a
INIT2(i)

36a   33b
Y
X
38a   37a   37b   36b   35b   38b

## FIG. 11C

FIG. 12

FIG. 13A

FIG. 13B

FIG. 13C

FIG. 14

FIG. 15A

FIG. 15B

FIG. 15C

FIG. 16

FIG. 17A

FIG. 17B

FIG. 17C

FIG. 18

FIG. 19A

FIG. 19B

FIG. 20

FIG. 21

FIG. 22

FIG. 23

FIG. 24

FIG. 25

FIG. 26

FIG. 27

FIG. 28

FIG. 29

FIG. 30

FIG. 31

FIG. 32

FIG. 33

FIG. 34

FIG. 35

FIG. 36

## INTERNATIONAL SEARCH REPORT

| International application No. |
| --- |
| **PCT/CN2024/094855** |

| A. | CLASSIFICATION OF SUBJECT MATTER |
| --- | --- |
| | H10K59/12(2023.01)i; H10K59/121(2023.01)i; H10K59/131(2023.01)i; H10K59/65(2023.01)i; H01L27/12(2006.01)i |

According to International Patent Classification (IPC) or to both national classification and IPC

| B. | FIELDS SEARCHED |
| --- | --- |

Minimum documentation searched (classification system followed by classification symbols)

    IPC: H10K, H01L

Documentation searched other than minimum documentation to the extent that such documents are included in the fields searched

Electronic data base consulted during the international search (name of data base and, where practicable, search terms used)

    CNTXT: ENTXT; ENTXTC; DWPI; WPABS; CNKI; IEEE: 显示, 像素, 电路, 发光, 驱动, 第一, 第二, 内置, 内部, 外置, 外部, 区, 区域, 部分, display, pixel, circuit, light emitting, drive, driving, first, second, internal, external, region, area, partial

| C. | DOCUMENTS CONSIDERED TO BE RELEVANT |
| --- | --- |

| Category* | Citation of document, with indication, where appropriate, of the relevant passages | Relevant to claim No. |
| --- | --- | --- |
| PX | CN 116568078 A (BOE TECHNOLOGY GROUP CO., LTD. et al.) 08 August 2023 (2023-08-08)<br>    claims 1-22, description, paragraphs [0029]-[0314], and figures 1-36 | 1-22 |
| PX | CN 116685162 A (BOE TECHNOLOGY GROUP CO., LTD.) 01 September 2023 (2023-09-01)<br>    description, paragraphs [0002]-[0178], and figures 1A-22 | 1-8, 18-22 |
| X | WO 2023071312 A1 (BOE TECHNOLOGY GROUP CO., LTD. et al.) 04 May 2023 (2023-05-04)<br>    description, page 1, line 10-page 39, line 2, and figures 1-53 | 1-8, 18-22 |
| Y | WO 2023071312 A1 (BOE TECHNOLOGY GROUP CO., LTD. et al.) 04 May 2023 (2023-05-04)<br>    description, page 1, line 10-page 39, line 2, and figures 1-53 | 9-22 |
| Y | CN 115020461 A (BOE TECHNOLOGY GROUP CO., LTD. et al.) 06 September 2022 (2022-09-06)<br>    description, paragraphs [0025]-[0178], and figures 1-17 | 9-22 |

✓ Further documents are listed in the continuation of Box C.      ✓ See patent family annex.

| * | Special categories of cited documents: | "T" | later document published after the international filing date or priority date and not in conflict with the application but cited to understand the principle or theory underlying the invention |
| --- | --- | --- | --- |
| "A" | document defining the general state of the art which is not considered to be of particular relevance | | |
| "D" | document cited by the applicant in the international application | "X" | document of particular relevance; the claimed invention cannot be considered novel or cannot be considered to involve an inventive step when the document is taken alone |
| "E" | earlier application or patent but published on or after the international filing date | | |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | "&" | document member of the same patent family |
| "P" | document published prior to the international filing date but later than the priority date claimed | | |

| Date of the actual completion of the international search | Date of mailing of the international search report |
| --- | --- |
| **04 August 2024** | **07 August 2024** |

| Name and mailing address of the ISA/CN | Authorized officer |
| --- | --- |
| **China National Intellectual Property Administration (ISA/ CN)**<br>**China No. 6, Xitucheng Road, Jimenqiao, Haidian District, Beijing 100088** | |
| | Telephone No. |

Form PCT/ISA/210 (second sheet) (July 2022)

**EP 4 651 689 A1**

## INTERNATIONAL SEARCH REPORT

| International application No. |
|---|
| **PCT/CN2024/094855** |

### C. DOCUMENTS CONSIDERED TO BE RELEVANT

| Category* | Citation of document, with indication, where appropriate, of the relevant passages | Relevant to claim No. |
|---|---|---|
| X | CN 113178163 A (WUHAN TIANMA MICRO-ELECTRONICS CO., LTD.) 27 July 2021 (2021-07-27)<br>  description, paragraphs [0002]-[0192], and figures 1-47 | 1-8, 18-22 |
| A | CN 113178163 A (WUHAN TIANMA MICRO-ELECTRONICS CO., LTD.) 27 July 2021 (2021-07-27)<br>  description, paragraphs [0002]-[0192], and figures 1-47 | 9-17 |
| A | CN 113066847 A (KUNSHAN GOVISIONOX OPTOELECTRONICS CO., LTD.) 02 July 2021 (2021-07-02)<br>  entire document | 1-22 |
| A | KR 20200075546 A (LG DISPLAY CO., LTD.) 26 June 2020 (2020-06-26)<br>  entire document | 1-22 |

Form PCT/ISA/210 (second sheet) (July 2022)

67

**INTERNATIONAL SEARCH REPORT**
Information on patent family members

International application No.

**PCT/CN2024/094855**

| Patent document cited in search report | | | Publication date (day/month/year) | Patent family member(s) | | | Publication date (day/month/year) |
|---|---|---|---|---|---|---|---|
| CN | 116568078 | A | 08 August 2023 | CN | 220342749 | U | 12 January 2024 |
| CN | 116685162 | A | 01 September 2023 | CN | 220326166 | U | 09 January 2024 |
| WO | 2023071312 | A1 | 04 May 2023 | US | 2024212610 | A1 | 27 June 2024 |
| | | | | EP | 4336543 | A1 | 13 March 2024 |
| | | | | EP | 4336543 | A4 | 17 April 2024 |
| | | | | CN | 113990909 | A | 28 January 2022 |
| | | | | CN | 117296473 | A | 26 December 2023 |
| CN | 115020461 | A | 06 September 2022 | WO | 2023231737 | A1 | 07 December 2023 |
| | | | | WO | 2023231740 | A1 | 07 December 2023 |
| CN | 113178163 | A | 27 July 2021 | CN | 113178163 | B | 10 January 2023 |
| | | | | WO | 2022227260 | A1 | 03 November 2022 |
| | | | | US | 2024062720 | A1 | 22 February 2024 |
| CN | 113066847 | A | 02 July 2021 | CN | 113066847 | B | 25 July 2023 |
| KR | 20200075546 | A | 26 June 2020 | KR | 102647450 | B1 | 14 March 2024 |

Form PCT/ISA/210 (patent family annex) (July 2022)

**REFERENCES CITED IN THE DESCRIPTION**

**Patent documents cited in the description**

- CN 202310722592